# EUROPEAN PATENT SPECIFICATION

(11) **EP 1 849 342 B1**
(45) Date of publication and mention of the grant of the patent: **19.08.2009**
(21) Application number: 06713727.3
(22) Date of filing: 08.02.2006
(51) Int. Cl.: H05K 13/08

(54) **MOUNTING CONDITION DETERMINING METHOD, MOUNTING CONDITION DETERMINING DEVICE, AND MOUNTING APPARATUS**
VERFAHREN ZUR BESTIMMUNG VON MONTAGEBEDINGUNGEN, VORRICHTUNG ZUR BESTIMMUNG VON MONTAGEBEDINGUNGEN UND MONTAGEVORRICHTUNG
PROCEDE DE DETERMINATION DE CONDITIONS DE MONTAGE, DISPOSITIF DE DETERMINATION DE CONDITIONS DE MONTAGE ET APPAREIL DE MONTAGE

(30) Priority: 17.02.2005 JP 2005041351; 18.02.2005 JP 2005043015; 28.03.2005 JP 2005092936
(43) Date of publication of application: 31.10.2007
(73) Proprietor: Panasonic Corporation, Kadoma-shi Osaka 571-8501 (JP)
(72) Inventor: HIRAI, Wataru c/oMatsushita Electric Ind.Co.Ltd, Osaka-shi, Osaka 540-6319 (JP); MAENISHI, Yasuhiro c/oMatsushita Elect.Indust. Co Ltd, Osaka-shi, Osaka 540-6319 (JP); KURATA, Hiroaki c/oMatsushita Elect.Indust. Co Ltd, Osaka-shi, Osaka 540-6319 (JP); KONISHI, Chikashi c/oMatsushita Electric Indust. Co Ltd, Osaka-shi, Osaka 540-6319 (JP); NAKAHARA, Kazuhiko c/oMatsushita Electr.Industr.Co. Ltd, Osaka-shi, Osaka 540-6319 (JP); FUJITA, Masakatsu c/oMatsushita Electric Indust. Co Ltd, Osaka-shi, Osaka 540-6319 (JP); YAMAZAKI, Takuya c/oMatsushita Electr.Indust.Co Ltd, Osaka-shi, Osaka 540-6319 (JP); YOKOI, Takaaki c/oMatsushita Electric Indust. Co Ltd, Osaka-shi, Osaka 540-6319 (JP)
(74) Representative: Pautex Schneider, Nicole Véronique
(86) International application number: PCT/JP2006/302586
(87) International publication number: WO 2006/088032

(56) References cited:
- US-A1- 2004 143 964
- US-B1- 6 701 611

## Description

### Technical Field

The present invention relates to a method of determining mounting conditions under which a piece of equipment mounts electronic components onto a board, and more specifically to a method of determining mounting conditions under which a mounting device moves electronic components and the like to mounting positions at a high speed.

### Background Art

Conventionally, various researches and developments have been pursued to minimize a tact time that is a time taken by mounting in which a mounting device (hereinafter, referred to also as a mounter) mounts electronic components on a printed circuit board or other board, in other words, to improve throughput from carrying of a board into the device until carrying of the board mounted with components from the device.

For example, by improving a mechanical processing speed of the mounter, it is possible to realize a short tact time. More specifically, electronic components are picked up from a supplying unit at a high speed, transported to a mounting position at a high speed, and mounted onto a board at a high speed, so that it is possible to reduce a tact time from the picking-up of the electronic components until the mounting of the electronic components onto the board, thereby enabling the throughput to be improved.

Furthermore, by determining beforehand an order in which component feeders or component tapes for supplying components to be mounted are arranged in the mounter, thereby deterining an order of component mounting, wasted time is avoided as much as possible, so that the throughput improvement is realized, as disclosed in Japanese Patent Laid-Open No. 2002-50900 and Nos. 2005-41351 and 2005-43015, for example.

### Disclosure of Invention

In actual manufacturing, however, an amount of production (amount of orders) of mounted boards is not constant, so that, when the amount of production is small, sometimes it is not necessary to operate a mounter at capacity. However, if mounted boards are produced to achieve the highest productivity using such short tact time and high throughput as described for the conventional mounter, an amount of ordered production is completed soon, causing a so-called "idle time" that is a non-productive time in which a mounter or a mounting line waits for work even in operating hours.

Even if a mounter is stopped and the idle time occurs as described above, an operator for operating the mounter has usually to stay in a productions plant and other equipments in the plant have to continue to be operated, so that the stop of a mounter or a mounting line hardly contributes to cost reduction of the mounted board productions,

Thus, in order to address the above problems, the present invention utilizes an highly-effective element to achieve an effect of reducing electricity consumption, and an object of the present invention is to realize a cost reduction by efficiently reducing electricity consumption for the mounted board production, by efficiently utilizing the idle time while achieving the desired amount of production within a predetermined production time, not by operating a mounter merely at a low speed.

In order to achieve the above object, the present invention provides a method of determining mounting conditions under which a piece of equipment mounts a component onto a substrate, the method including The method steps mentionned in claim 1.

The present invention further provides a device for carrying out the method, as defined in claim 5 and a mounter including such device as defined in claim 6.

Thereby it is possible to determine mounting conditions to become closer to a setting value of a parameter regarding electricity consumption, thereby efficiently reducing the electricity consumption, and eventually resulting in cost reduction.

Further, the parameter regarding electricity consumption is desirably a producing time required to produce the mounted substrates, in the obtaining of the setting value, a goal producing time allowed to produce the mounted substrates is obtained, in the obtaining of the actual value, an actual producing time required to produce the mounted substrates under the current mounting conditions is obtained, and in the determining, the new mounting conditions are determined so that the obtained actual producing time does not exceed the goal producing time.

Thereby it is possible to reduce electricity consumption for mounted board production, achieving a predetermined amount of production within a goal producing time.

Still further, it is desirable that the mounting condition determining method further includes: obtaining information of a mounting acceleration corresponding to the component to be mounted; and lowering the mounting acceleration by a predetermined degree, wherein in the obtaining of the actual value, the actual producing time is calculated based on the lowered mounting acceleration as the current mounting conditions, and in the determining, the lowered mounting acceleration is determined so that the actual producing time does not exceed the goal producing time.

By operating an equipments at the mounting speed that is determined by applying the above method, it is possible to quite efficiently reduce electricity consumption for mounted board production.

Still further, the mounting condition determining method may further include obtaining gradual mounting acceleration information which gradually sets the mounting accelerations, wherein in the lowering, the mounting acceleration is gradually lowered based on the gradual mounting acceleration information.

Thereby a time required to obtain the most appropriate mounting conditions can be shortened, so that it is possible to obtain mounting conditions to reduce electricity consumption soon.

Still further, the mounting condition determining method may further include: obtaining information of a mounting acceleration corresponding to the component to be mounted; and lowering the mounting acceleration by a predetermined degree, wherein in the obtaining of the actual value, the actual producing time is calculated based on the lowered mounting acceleration and a mounting order that are the current mounting conditions, and in the determining, the mounting order is determined so that the actual producing time does not exceed the goal producing time, after the lowered mounting acceleration is determined so that the actual producing time does not exceed the goal producing time.

By determining the mounting speed and the mounting order in the above described order, it is possible to determine the electricity consumption for mounted board production.

Still further, the parameter regarding electricity consumption may be a producing time required to produce the mounted substrate, the setting value obtainment unit may be operable to obtain a goal producing time allowed to produce the mounted substrate, the actual value obtainment unit may be operable to obtain an actual producing time required to produce the mounted substrate under the current mounting conditions, and the mounting condition determining unit may be operable to determine the new mounting conditions so that the obtained actual producing time does not exceed the goal producing time.

Thereby the number of using beams is reduced while the time constraint such as a delivery deadline is satisfied, so that it is possible to restrain electricity consumption of the equipment.

Still further, the mounting condition determining method may further include: determining mounting conditions assuming that all beams are to be used; and calculating a fastest producing time under the fastest-mounting conditions, wherein in the obtaining of the number of beams to be used, the number of beams to be used is obtained based on the goal producing time and the fastest producing time.

Thereby the number of using beams can be previously estimated, so that it is possible to shorten a time required to obtain the final mounting conditions.

Still further, the mounting condition determining method may further include : receiving information of a selected number of beams to be used; and obtaining the number of beams to be used from the received information of the selected number of beams.

Thereby beams to be used can be selected artificially, so that, by selecting, for example, only beam arranged in a one of two rows parallel to a transportation direction, it is possible to reflect usability of operator, such as accessibility to a component supplying unit corresponding to the using beam, into the determination of the mounting conditions.

Still further, in the determining, the new mounting conditions may be determined to be added with further conditions under which beams arranged in a row parallel to a direction of transporting the substrate are used prior to beams arranged in another row parallel to the direction.

Thereby by merely reducing the number of using beams, a possibility of shortening of actual producing time obtained by the determined mounting conditions is increased, so that a possibility of further reducing the number of using beams is further increased. As a result, it is possible to increase the effect of electricity consumption restraint.

Still further, the mounting condition determining method may further include blocking electricity supplied to beams not to be used.

Thereby it is possible not only to determine beams to be used, but also to completely block electricity supplied to beams not to be used, so that electricity consumption can be completely controlled.

Still further, the mounting condition determining method may further include blocking electricity supplied to a stage in the equipment, the stage having beams not to be used.

Thereby it is possible not only to determine beams to be used, but also to completely block electricity supplied to a stage corresponding to the beams not to be used, so that electricity consumption can be more completely controlled.

Still further, the parameter regarding electricity consumption may be a producing time totally required to produce the mounted substrates by a mounting line that includes the equipment, in the obtaining of the setting value, a goal producing time allowed to produce the mounted substrates by the mounting line is obtained, in the obtaining of the actual value, an actual producing time totally required to produce the mounted substrates may be obtained based on the number of the equipments to be used in the mounting line as the current mounting conditions, and in the determining, the number of the equipments to be used may be determined so that the obtained actual producing time does not exceed the goal producing time.

Thereby the number of mounters included in a mounting line is reduced while the time constraint such as a delivery deadline is satisfied, so that it is possible to restrain electricity consumption of a whole mounting line.

Still further, the parameter regarding electricity consumption may be a producing time required to produce the mounted substrate, and the method further include: detecting that the mounting is complete when all of components to be mounted are mounted; and blocking electricity supplied to beams when a production waiting time required to wait for next mounting after the detected mounting completion exceeds the setting value.

Thereby even in a case where an unexpected production delay occurs by an accident of any mounter in the mounting line, blocking of electricity supplied to a beam enables electricity consumption to be restricted.

Still further, the parameter regarding electricity consumption may be a producing time required to produce the mounted substrate, the setting value obtainment unit may be operable to obtain a goal producing time allowed to produce the mounted substrate, the actual value obtainment unit may be operable to obtain an actual producing time required to produce the mounted substrate based on the number of beams to be used as the current mounting conditions, and the mounting condition determining unit may be operable to determine the number of beams to be used so that the obtained actual producing time does not exceed the goal producing time.

Thereby the setting amount of electricity and the used amount of electricity are displayed, so that an operator of the equipment can easily learn from the display a ratio of the used amount to the setting amount of electricity. As a result, if, for example, the used amount of electricity is getting closer to the setting amount of electricity, the operator can stop the operation of the equipment in order to avoid the used amount of electricity to be greater than the setting amount of electricity, thereby reducing the amount of electricity used in the equipment.

Still further, the mounting condition determining method may further include: examining whether or not a ratio of the used amount of electricity to the setting amount of electricity exceeds the setting value; and alarming to notify that the used amount of electricity becomes closer to the setting amount of electricity, when the examination is made that the ratio exceeds the setting value.

Thereby if a setting value is set to 80% for example, an alarm is provided when the used amount of electricity reaches 80% of the setting amount of electricity, so that the operator can easily learn that the used amount of electricity is getting closer to the setting amount of electricity.

Still further, the mounting condition determining method may include: examining whether or not a ratio of the used amount of electricity to the setting amount of electricity exceeds the setting value; and reducing an amount of commercially-supplied electricity per unit time which is supplied to the equipment, after the examination is made that the ratio exceeds the setting value.

Thereby if a setting value is set to 80% for example, the operation of the equipment is stopped when the used amount of electricity reaches 80% of the setting amount of electricity, so that it is possible to completely avoid the used amount of electricity to be greater than the setting amount of electricity.

Still further, in the reducing, an operation performed by the equipment to mount the component onto the substrate may be stopped.

Still further, in the reducing, the commercially-supplied electricity may be stopped not to be supplied to the equipment and privately-generated electricity is supplied to the equipment instead.

Thereby the commercial supply of electricity is stopped and privately-generated electricity is supplied to a equipment, it is possible to reduce the amount of used commercially-supplied electricity.

Still further, the mounting condition determining method may further include: obtaining an electricity rate per unit amount of used electricity; and calculating an electricity fee for the used amount of electricity measured in the obtaining of the actual value, based on the used amount of electricity and the obtained electricity rate, wherein in the displaying, the calculated electricity fee is displayed instead of the used amount of electricity.

In a case where, for example, an electricity rate per electricity power amount unit is set to be gradually increased according to the used amount of electricity, an electricity fee per one produced board is increased according to the used amount of electricity. However, as described above, the electricity fee per one produced board is displayed, so that the operator of the equipment can easily estimate, from the displayed electricity fee, profit from sale of the produced board. As a result, when the estimated profit is smaller than it has been expected, the operator can stop the operation of the equipment.

Still further, it is desirable that the mounting condition determining further include: measuring an amount of carbon dioxide discharged from the equipment; and displaying the measured amount of carbon dioxide.

Still further, the mounting condition determining method may further include: obtaining a setting amount of carbon dioxide allowed to be discharged from the equipment; and stopping an operation performed by the equipment to mount the component onto the substrate, when a ratio of the amount of carbon dioxide discharged from the equipment to the setting amount of carbon dioxide exceeds the setting value.

Still further, the parameter regarding electricity consumption may be a used amount of electricity, the setting value obtainment unit may be operable to obtain a setting amount of electricity allowed to be used by the equipment in a predetermined time period, and the actual value obtainment unit may be operable to obtain the used amount of electricity by measuring an amount of electricity used by the equipment from a beginning of the predetermined time period to a present time, the device further including a display unit operable to display the obtained setting amount of electricity and the measured used amount of electricity.

Thereby an amount of discharged carbon dioxide can be notified, so that various control can be performed according the estimation.

Note that the above object can be achieved not only as the above mounting condition determining method, but also as a mounting condition determining device which determines mounting conditions using the method, and as a mounter having the device. Note also that the mounting condition determining method can be realized as a program or a storage medium for storing the program, and also as a producing method, a producing device, a program and a storage medium for storing the program, each of which produce boards using the above method.

According to the present invention, it is possible to produce a mounted board with restrained electricity consumption, by efficiently utilizing an idle time, achieving a desired amount of production.

Further, according to the present invention, it is possible to reduce electricity consumption of a mounter by limiting the number of using beams, satisfying constraint of production of the predetermined number of boards within a predetermined deadline.

Still further, according to the present invention, it is possible to reduce an amount of electricity used for a mounter.

### Brief Description of Drawings

These and other objects, advantages and features of the invention will become apparent from the following description thereof taken in conjunction with the accompanying drawings that illustrate specific embodiments of the present invention. In the Drawings:
FIG. 1 is an outline perspective view showing inside of a mounter by cutting a part of the mounter according to an embodiment of the present invention;
FIG. 2 is a plane view showing a main structure of the mounter;
FIG. 3 is a perspective pattern view showing a position relationship between a line gang pickup head and a component supplying unit;
FIG. 4 is a perspective pattern view showing a part of a tray supplying unit;
FIG. 5 is a block diagram showing functional structures of a mounter and a mounting condition determining device;
FIG. 6 is a flowchart showing processing performed by the mounting condition determining device;
FIG. 7 is an outline perspective view showing inside of a mounter by cutting a part of the mounter;
FIG. 8 is a plane view showing a main structure of the mounter;
FIG. 9 is a perspective pattern view showing a position relationship between a line gang pickup head and a component supplying unit;
FIG. 10 is a perspective pattern view showing a part of a tray supplying unit;
FIG. 11 is a block diagram showing functional structures of a mounter and a mounting condition determining device;
FIG. 12 is a table showing an example of a part of a component library stored in a database unit;
FIG. 13 is a table showing an example of moving acceleration data stored in the database unit;
FIG. 14 is a block diagram showing in detail a function of the mounting condition determining unit;
FIG. 15 is a flowchart showing processing performed by the mounting condition determining device;
FIG. 16 is a graph showing a pattern relationship between a time and a speed of a line gang pickup head when an electronic component is transported;
FIG. 17 is a flowchart showing an operation for determining a mounting order;
FIG. 18 is a perspective view showing a mounting line and a mounting condition determining device according to anther embodiment of the present invention;
FIG. 19 is a plan view showing a relationship among a mounting head, a board, and a supplying unit of a rotary mounter according to the another embodiment;
FIG. 20 is a flowchart showing another processing performed by a mounting condition determining device;
FIG. 21 is an outline perspective view showing a whole structure of a mounting line according to a still another embodiment of the present invention;
FIG. 22 is a plane view showing a main structure of a mounter;
FIG. 23 is a perspective pattern view showing a position relationship between a line gang pickup head and a component feeder;
FIG. 24 is a block diagram showing a functional structure of a mounting condition determining device;
FIG. 25 is a block diagram showing in detail a functional structure of an electricity consumption restraint unit;
FIG. 26 is a diagram showing an example of an input screen;
FIG. 27 is a flowchart showing a processing performed especially by a mounting condition determining device and an electricity consumption restraint unit;
FIG. 28 is a diagram showing an example of a screen showing whether or not a power-saving mode is applied;
FIG. 29 is a flowchart showing processing performed especially performed by a mounting condition determining device and an electricity consumption restraint unit according to a still another embodiment of the present invention;
FIG. 30 is a diagram showing an example of a screen displaying temporarily-determined using beams;
FIG. 31 is a block diagram showing a mounting line;
FIG. 32 is a block diagram showing a functional structure of a mounting line monitor unit;
FIG. 33 is a diagram showing sequence of communication between a mounter and the mounting line monitor unit;
FIG. 34 is a diagram showing a status in which using beams are gathered;
FIG. 35 is a diagram showing an example of a task balance;
FIG. 36 is a diagram showing another example of the task balance;
FIG. 37 is a diagram showing a whole structure of a mounting system according to a still another embodiment of the present invention;
FIG. 38 is an outline perspective view showing a production line and a power monitoring apparatus according to the embodiment;
FIG. 39 is a plane view showing a main structure of a mounter according to the embodiment;
FIG. 40 is a block diagram showing a functional structure of inside of the above mounter and the power monitoring apparatus according to the embodiment;
FIG. 41 is tables showing detail of setting electricity data according to the embodiment;
FIG. 42 is tables showing detail of setting operation data according to the embodiment;
FIG. 43 is a table showing detail of mounting point data according to the embodiment;
FIG. 44A and 44B are a graph and a table, respectively, explaining acceleration patterns according to the embodiment;
FIG. 45 is a table showing detail of accelerated electricity data according to the embodiment;
FIG. 46 is a diagram showing an example of a setting operation screen according to the embodiment;
FIG. 47 is a diagram showing an example of an electricity amount display screen according to the embodiment;
FIG. 48 is a graph showing another example of the electricity amount display screen according to the embodiment;
FIG. 49 is a diagram showing an example of a screen displaying a preliminary alarm and an alarm according to the embodiment;
FIG. 50 is a table showing mounting point data which is changed by a monitor control unit according to the embodiment;
FIG. 51 is a diagram showing a stopped rear stage according to the embodiment;
FIG. 52 is a flowchart showing an operation performed by a power monitoring apparatus according to the embodiment;
FIG. 53 is a diagram explaining an example of electricity rates that are set to be increased gradually, according to the embodiment;
FIG. 54 is a flowchart showing _{.}an operation performed by a monitor control unit according to the first variation of the embodiment;
FIG. 55 is a flowchart showing an operation performed by a monitor control unit according to the second variation of the embodiment;
FIG. 56 is a flowchart showing an operation performed by a monitor control unit according to the third variation of the embodiment;
FIG. 57 is a graph showing a relationship between a production cost and sales cost of produced boards according to the fourth variation of the embodiment; and
FIG. 58 is a flowchart showing an operation performed by a monitor control unit according to the fourth variation of the embodiment.

### Best Mode for Carrying Out the Invention

### (First Embodiment)

The following describes the first embodiment of the present invention with reference to the drawings.

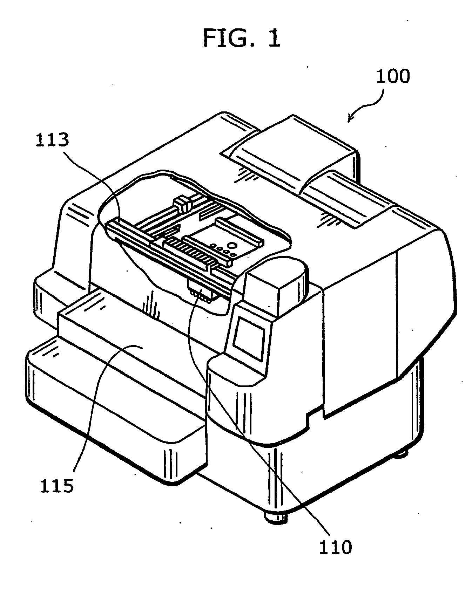

FIG. 1 is an outline perspective view showing inside of a mounter 100 by cutting a part of the mounter 100 as a device which mounts components onto a board, according to the first embodiment of the present invention.

A mounter 100 shown in FIG. 1 can form a mounting line where electronic components are mounted onto a circuit board which is a substrate provided from upstream and then the mounted circuit board is transported downstream. The mounter 100 includes a line gang pickup head 110, an XY robot 113, and a component supplying unit 115. The line gang pickup head 110 has multiple mounting heads to pick up, transform, and mount on the board the electronic components. The XY robot 113 moves the line gang pickup head 110 in a horizontal direction. The component supplying unit 115 supplies the components to the mounting heads.

The mounter 100 is a mounting device which can mount onto a board various electronic components from quite small components to connectors, and more specifically can mount large electronic components that are 10 mm² or larger, irregularly shaped components like switches and connectors, and IC components like quad flat package (QFP) or ball grid array (BAG) components.

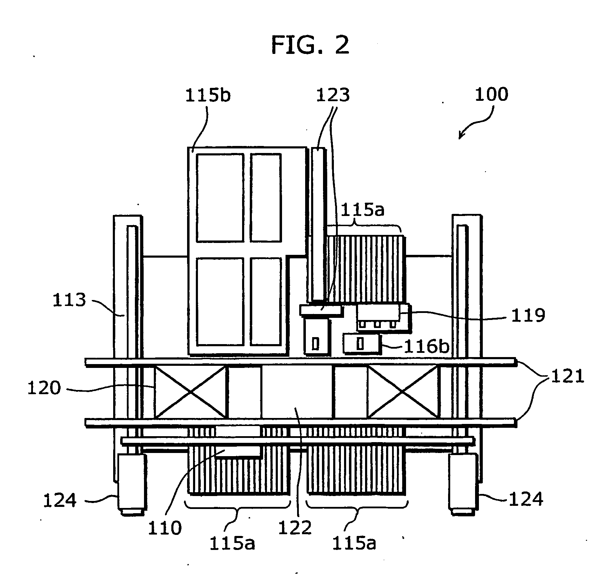

FIG. 2 is a plane view showing a main structure of the mounter 100 according to the first embodiment.

The mounter 100 further includes a nozzle station 119, a rail 121, a mounting tables 122, a component collection device 123, and a beam motor 124. The nozzle station 119 is a table on which nozzles are positioned. The nozzles are interchangeably arranged at the mounting heads in order to correspond to various dimensions of components. The rail 121 forms a track along which a board 120 is transported. The mounting table 122 is a table on which the transported board 120 is placed to be mounted with electronic components. The component collection device 123 is a device which collects picked-up and sticked components that are found defective. The beam motor 124 is a motor which drives beams. In addition, the mounter 100 includes a head motor which drives the line gang pickup head 110, but the head motor is not shown in FIG. 1.

Note that the component supplying units 115 are provided on the front and rear sides of the mounter 100. The component supplying unit 115 includes component supplying units 115a and 115b. The component supplying unit 115a supplies electronic components stored in a tape shape. On the other hand, the component supplying unit 115b supplies electronic components stored in a plate whose area is partitioned in keeping with the dimensions of components.

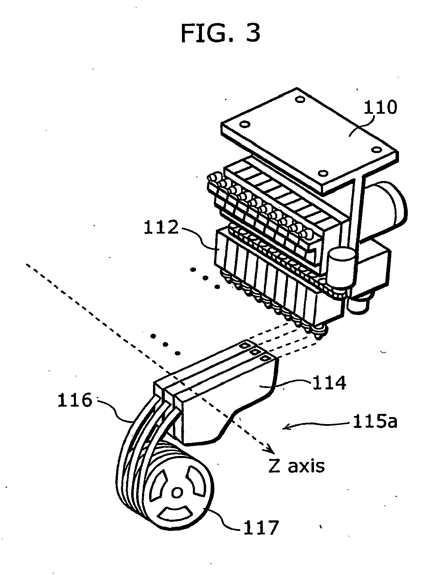

FIG. 3 is a perspective pattern view showing a position relationship between the line gang pickup head 110 and the component supplying unit 115a, according to the first embodiment.

As shown in FIG. 3, the line gang pickup head 110 has multiple mounting heads 112. The line gang pickup head 110 moves to a position above the component supplying unit 115, then lowers a nozzle formed on a top of each mounting head 112 to pick up an electronic component, and raises the nozzle. After picking up the necessary component, the line gang pickup head 110 moves to a position above the board 120 where the picked-up component is located above a mounting position and lowers the nozzle of the mounting head 120 to mount the component on the board 120.

On the other hand, the component supplying unit 115a has multiple sets of the following units in a Z axial direction: a component ta pe 116, a supply reel 117, and a tape feeder 114. The component tape 116 is a tape on which a number of the same type of electronic components are arranged and stored. The supply reel - 117 holds the component tape 116 that has been wound. The tape feeder 114 obtains a suitable width of the component tape 116 from the supply reel 117 to supply electronic components from the component tape 116.

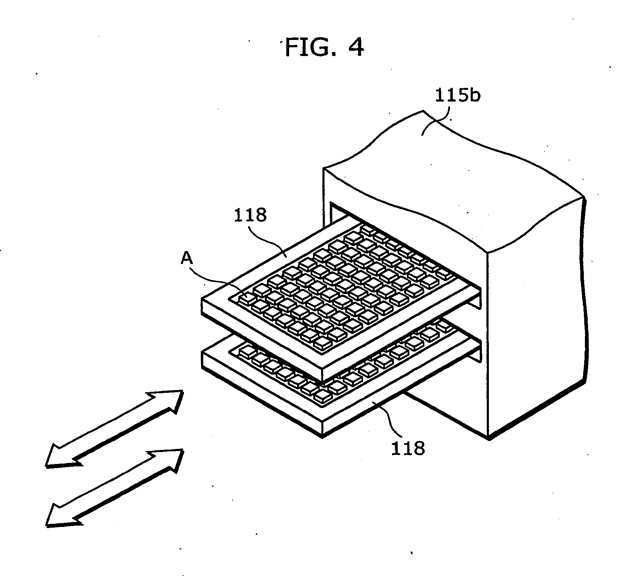

FIG. 4 is a perspective pattern view showing a part of the tray-type supplying unit 115b, according to the first embodiment.

As shown in FIG. 4, the tray-type supplying unit 115b has a plurality of trays 118 on which a number of the same type of electronic components A are placed and which are vertically arranged at a plurality of levels. Each type of electronic component is placed on each level. Furthermore, the tray 118 can protrude from and withdraw to a body of the tray-type supplying unit 115b, and by changing the tray 118 to be protruded based on a type of the electronic component to be mounted, it is possible to supply a plurality of types of electronic components. Note that the electronic components supplied by the tray 118 are relatively large components.

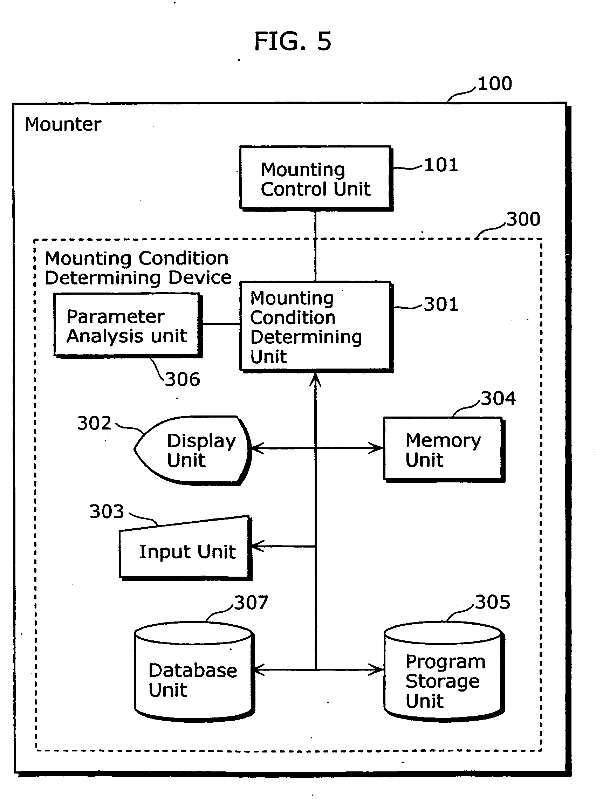

FIG. 5 is a block diagram showing a functional structure of a mounting condition determining device 300, according to the first embodiment.

The mounting condition determining device 300 shown in FIG. 5 is a device which determines new mounting conditions based on a result of comparing an actual value to a setting value of a parameter regarding electricity consumption, under various restrictions due to a specification of the mounter 100. The mounting condition determining device 300 includes a mounting condition determining unit 301, a display unit 302, an input unit 303, a memory unit 304, a program storage unit 305 which stores a mounting condition determining program, a parameter analysis unit 306, and a database unit 307 Examples of the parameter are a producing time, a used amount of electricity, an electricity rate, an amount of discharged CO₂, and the like.

Furthermore, according to the first embodiment, the mounting condition determining device 300 is embedded in the mounter 100, and a body of the mounter 100 has a mounting control unit 101 which obtains mounting conditions determined by the mounting condition determining device 300 in order to mount components onto a board based on the mounting conditions.

The mounting condition determining device 300 is realized by executing the mounting condition determining program, and may determine the mounting conditions required for production by the mounter 100 not only prior to the production, but also at real time during the production when mounting electronic components on a board.

The mounting condition determining unit 301 is a processing unit which determines the mounting conditions, based on data such as mounting acceleration an a mounting order stored in the database unit 307, or the mounting condition determining program stored in the program storage unit 305.

The display unit 302 is a cathode ray tube (CRT), a liquid crystal display (LCD), or the like, while the input unit 303 is an input device such as a keyboard, a mouse, a touch panel, or the like. These are used to input data for controlling the mounter 100, such as a goal producing time and the number of circuit boards to be produced within the goal producing time, according to communication between an operator and the mounter 100.

The memory unit 304 is a random access memory (RAM) or the like that provides a work area for the mounting condition determining unit 301.

The program storage unit 305 is a hard disk drive or the like storing a variety of programs that realize the functions of the mounting condition determining device 300.

The database unit 307 is a hard disk drive or the like storing predetermined data such as mounting acceleration data used for the mounting condition determination performed by the mounting condition determining device 300, a mounting order generated based on the determination, and the like.

Next, a method of determining the mounting conditions is described.

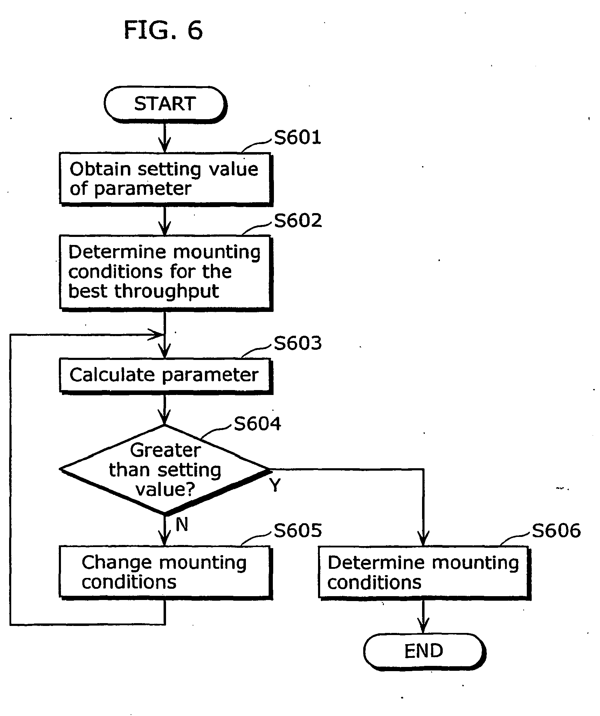

FIG. 6 is a flowchart showing processing performed by the mounting condition determining device 300, according to the first embodiment.

Firstly, the mounting condition determining unit 301 obtains a setting value of a parameter (SW For example, when the setting value of the parameter is a goal producing time, the goal producing time is calculated using a daily operation time of the mounter 100, operation days of a whole plant, an amount of orders, and an estimated amount of orders. Note that the calculated goal producing time may include an additional time period in order to cope with unexpected additional orders. Note also that the goal producing time may be obtained from other order estimation systems.

Next, current mounting conditions by which the best throughput can be obtained are determined (S602).

Then, the parameter analysis unit 306 calculates a value of a parameter based on the determined current mounting conditions (S603). If the value is greater than the setting value obtained at Step S601 (Y at S604), then the current mounting conditions are determined as target mounting conditions (S906).

On the other hand, if the value is not greater than the setting value (N at S604), then the current mounting conditions are changed (S605).

Moreover, examples of the determined mounting conditions are acceleration and speed of a component regarding component amounting, a mounting order of a component, the number of using beams, the number of mounters, and the like.

Note that the first embodiment has described that, as the original mounting conditions, the mounting conditions by which the best throughput can be obtained is used. However, the present invention does not limit the mounting conditions to the above. For example, mounting conditions by which minimum or arbitrary throughput can be obtained Is determined as the original mounting conditions, and target mounting conditions may be searched by using a value of the determined original mounting conditions as an initial value and changing and estimating the target mounting conditions to be within a range of the parameter.

### (Second Embodiment)

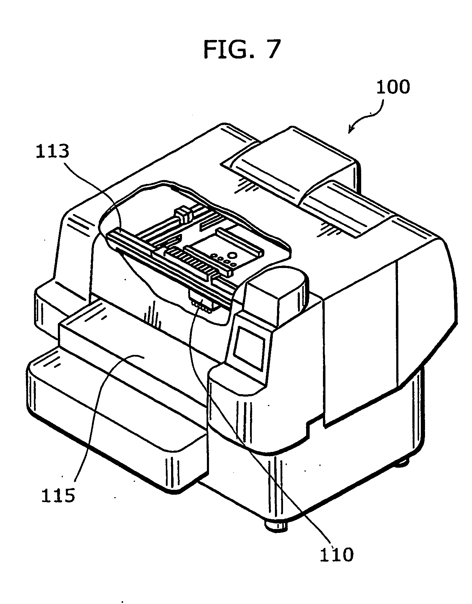

FIG. 7 is an outline perspective view showing inside of the mounter 100 by cutting a part of the mounter 100 as a device which mounts components onto a board, according to the second embodiment of the present invention.

Note that the same elements are designated by the same reference numerals in the first embodiment.

A mounter 100 shown in FIG. 7 can form a mounting line where electronic components are mounted onto a circuit board which is a board provided from upstream and then the mounted circuit board is transported downstream. The mounter 100 includes the line gang pickup head 110, the XY robot 113, and the component supplying unit 115. The line gang pickup head 110 has a plurality of mounting heads to pick up, transform, and mount on the board the electronic components. The XY robot 113 moves the line gang pickup head 110 in a horizontal direction. The component supplying unit 115 supplies the components to the mounting heads.

The mounter 100 is a mounting device which can mount onto a board various electronic components from quite small components to connectors, and more specifically can mount large electronic components that are 10 mm² or larger, irregularly shaped components like switches and connectors, and IC components like quad flat package (QFP) or ball grid array (BAG) components.

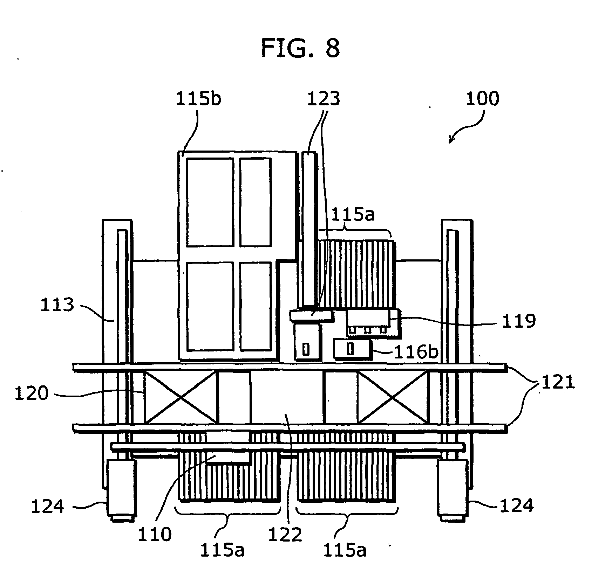

FIG. 8 is a plane view showing a main structure of the mounter 100, according to the second embodiment.

The mounter 100 further includes the nozzle station 119, the rail 121, the mounting table 122, the component collection device 123, and the beam motor 124. The nozzle station 119 is a table on which nozzles are positioned. The nozzles are interchangeably arranged at the mounting heads in order to correspond to various dimensions of components. The rail 121,forms a track along which the board 120 is transported. The mounting table 122 is a table on which the transported board 120 is placed to be mounted with electronic components. The component collection device 123 is a device which collects picked-up and sticked components that are found defective. The beam motor 124 is a motor which drives beams. In addition, the mounter 100 includes a head motor which drives the line gang pickup head 110, but the head motor is not shown in FIG. 8.

Note that the component supplying units 115 are provided on the front and rear sides of the mounter 100. The component supplying unit 115 includes component supplying units 115a and 115b. The component supplying unit 115a supplies electronic components stored in a tape shape. On the other hand, the component supplying unit 115b supplies electronic components stored In a plate whose area is partitioned in keeping with the dimensions of components.

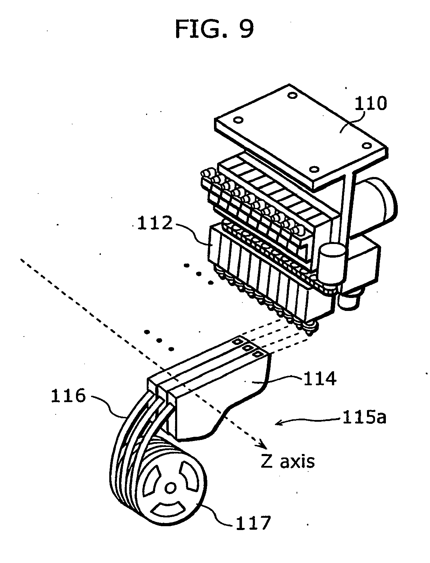

FIG. 9 is a perspective pattern view showing a position relationship between the line gang pickup head 110 and the component supplying unit 115a, according to the second embodiment.

As shown in FIG. 9, the line gang pickup head 110 has a plurality of the mounting heads 112. The line gang pickup head 110 moves to a position above the component supplying unit 115, then lowers a nozzle formed on a top of each mounting head 112 to pick up an electronic component, and raises the nozzle. After picking up the necessary component, the line gang pickup head 110 moves to a position above the board 120 where the picked-up and sticked component is located above a mounting position and lowers the nozzle of the mounting head 120 to mount the component on the board 120.

On the other hand, the component supplying unit 115a has multiple sets of the following units in a Z axial direction: a component tape 116, a supply reel 117, and a tape feeder 114. The component tape 116 is a tape on which a number of the same type of electronic components are arranged and stored. The supply reel 117 holds the component tape 116 that has been wound. The tapes feeder 114 obtains a suitable width of the component tape 116 from the supply reel 117 to supply electronic components from the component tape 116.

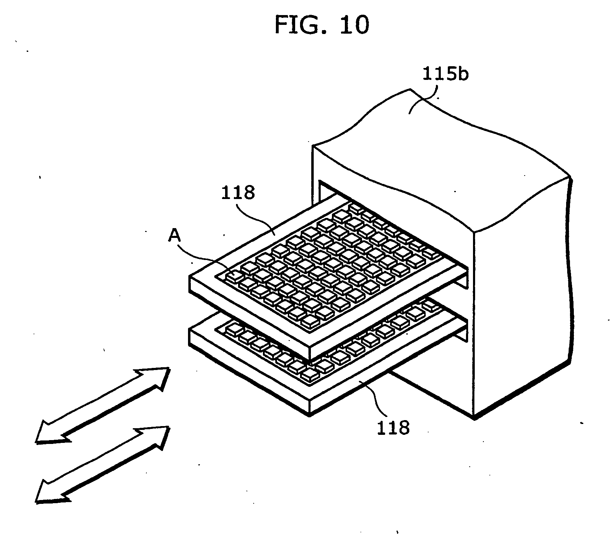

FIG. 10 is a perspective pattern view showing a part of the tray-type supplying unit 115b according to the second embodiment.

As shown in FIG. 10, the tray-type supplying unit 115b has a plurality of trays 118 on which a number of the same type of electronic components A are placed and which are vertically arranged at a plurality of levels. Each type of electronic component is placed on each level. Furthermore, the tray 118 can protrude from and withdraw to a body of the tray-type supplying unit 115b, and by changing the tray 118 to be protruded based on a type of the electronic component to be mounted, it is possible to supply a plurality of types of electronic components. Note that the electronic components supplied by the tray 118 are relatively large components.

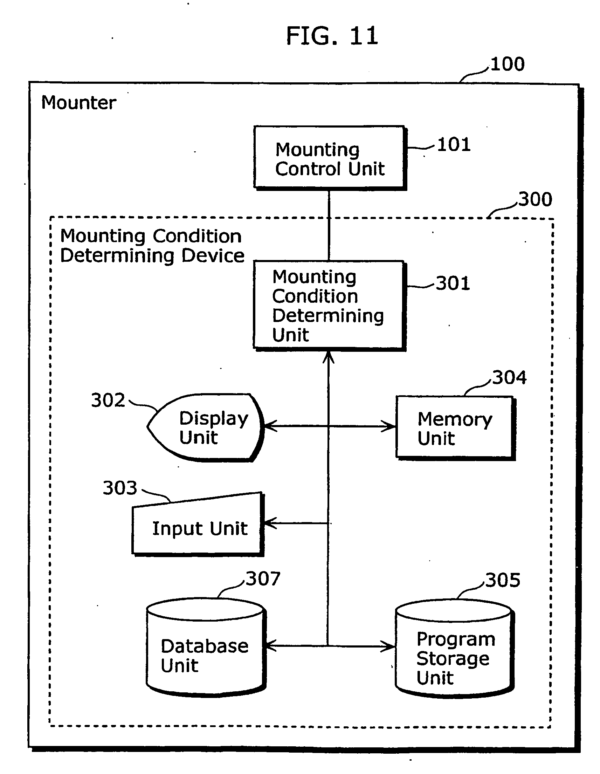

FIG. 11 is a block diagram showing a functional structure of the mounting condition determining device 300 according to the second embodiment.

The mounting condition determining device 300 shown in FIG. 11 is a device which determines mounting conditions that are an actual producing time as an actual time and that is nearly equal to but not longer than a goal producing time which is a setting value of the producing time and.a parameter regarding consumed electricity amount, under various restrictions due to a specification of the mounter 100. The mounting condition determining device 300 includes a mounting condition determining unit 301, a display unit 302, an input unit 303, a memory unit 304, a program storage unit 305 which stores a mounting condition determining program, and a database unit 307.

Furthermore, according to the second embodiment, the mounting condition determining device 300 is embedded in the mounter 100, and a body of the mounter 100 has a mounting control unit 101 which obtains mounting conditions determined by the mounting condition determining device 300 in order to mount components onto a board based on the mounting conditions and controls motor based on the determined accelerations or speeds.

Here, "mounting acceleration" means a general idea of acceleration including all acceleration caused in the mounter, such as acceleration in a horizontal direction caused when the line gang pickup head 110 moves, and acceleration in a vertical direction caused when the mounting heads 112 pick up or mount electronic components.

The mounting condition determining device 300 is realized by executing the mounting condition determining program, and may determine the mounting conditions required for production by the mounter 100 not only prior to the production, but also at real time during the production when mounting electronic components on a board.

The mounting condition determining unit 301 is a processing unit which determines the most suitable mounting conditions, based on data such as mounting acceleration and a mounting order stored in the database unit 307, or the mounting condition determining program stored in the program storage unit 305. The more detail of the mounting condition determining unit 301 is described further below.

The display unit 302 is a cathode ray tube (CRT), a liquid crystal display (LCD), or the like, while the input unit 303 is an input device such as a keyboard, a mouse, a touch panel, or the like. These are used to input data for controlling the mounter 100, such as a goal producing time and the number of circuit boards to be produced within the goal producing time, according to communication between an operator and the mounters 100.

The memory unit 304 is a random access memory (RAM) or the like that provides a work area for the mounting condition determining unit 301.

The program storage unit 305 is a hard disk drive or the like storing a variety of determination programs that realize the functions of the mounting condition determining device 300.

The database unit 307 is a hard disk drive or the like storing predetermined data such as mounting acceleration data and a component library used for the mounting condition determination by the mounting condition determining device 300, a mounting order generated based on the determined mounting conditions condition, and the like.

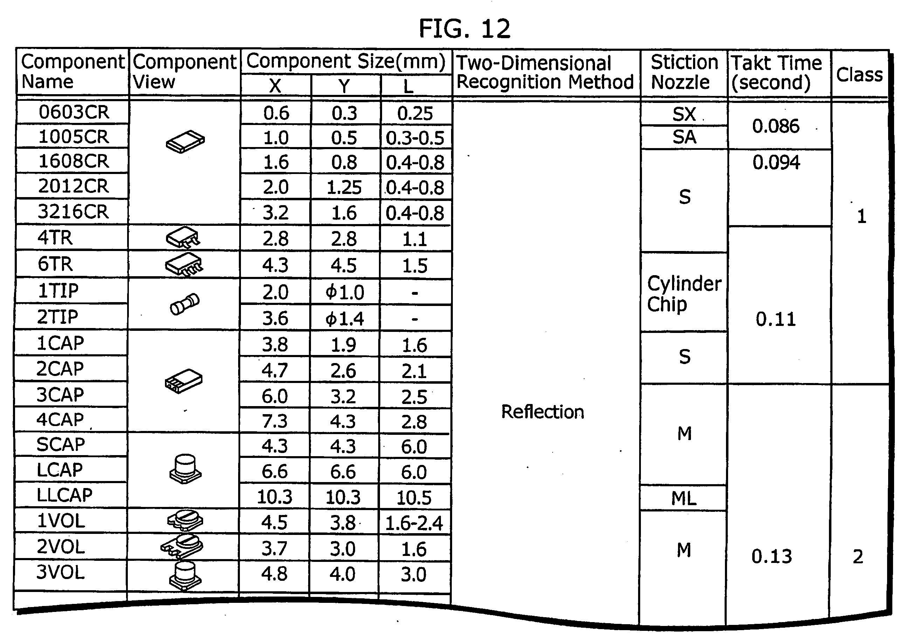

FIG. 12 is a table showing an example of a part of a component library stored in the database unit 307 according to the second embodiment.

The component library shown in FIG. 12 is a library in which specific information for the various component types that can be handled by the mounter 100 is gathered together. Each entry in the component library includes the component size of each component type and other restriction information (such as the type of stiction nozzle that can be used, the recognition method to be used by the component recognizing camera, and the maximum tact time in which the mounting head should move). Note that classes are indicated in rightmost fields of the table shown in FIG. 12. The classes are used to classify the sizes (weights) of all electronic components to be mounted into 16 classes. The table of FIG. 12 also indicates each view of the component types as reference.

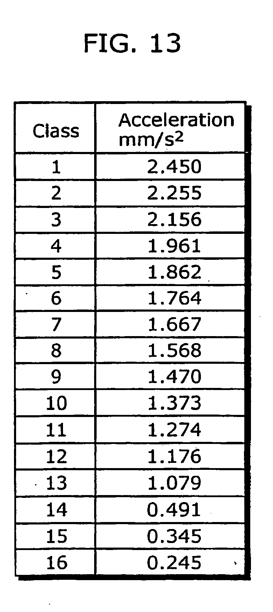

FIG. 13 is a table showing an example of mounting acceleration data stored in the database unit according to the second embodiment.

The mounting acceleration data shown in FIG. 13 is one of gradual acceleration information and indicates a corresponding relationship between the above-described class and a maximum moving acceleration in a horizontal direction at which the line gang pickup head unit 110 holding an electronic component classified in the class to move. When the mounter 100 is operated to obtain maximum throughput, the line gang pickup head unit 110 holding the electronic component classified in the class moves at a maximum moving acceleration corresponding to the class.

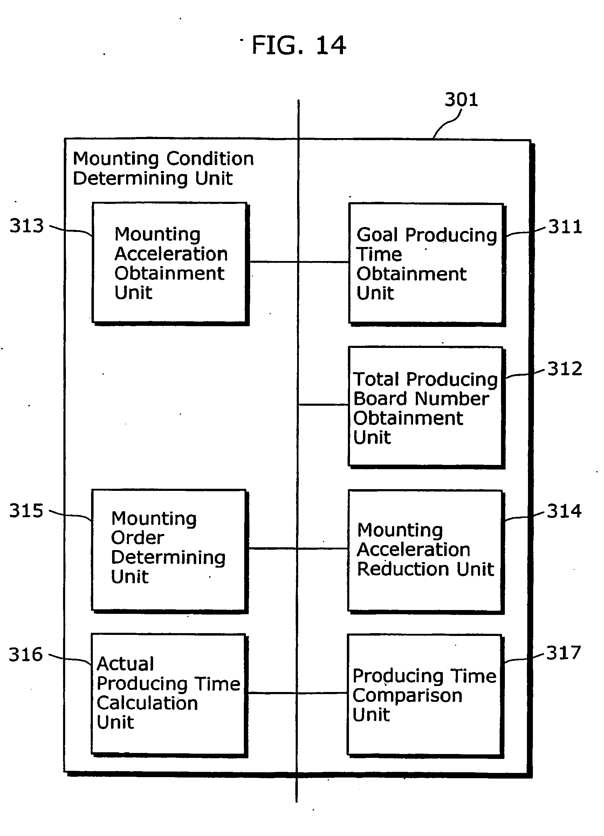

FIG. 14 is a block diagram showing in detail a function of the mounting condition determining unit 301 according to the second embodiment.

The mounting condition determining device 301 shown in FIG. 14 is a processing unit which determines, based on obtained various information, mounting conditions by which an actual producing time is nearly equal to but not longer than a goal producing time. The mounting condition determining device 301 includes a goal producing time obtainment unit 311, a total producing board number obtainment unit 312, a mounting acceleration obtainment unit 313, a mounting acceleration reduction unit 314, a mounting order determining unit 315, an actual producing time calculation unit 316, and a producing time comparison unit 317.

The goal producing time obtainment unit 311 is a processing unit which obtains a goal producing time within which all predetermined number of circuit boards should be produced. Note that the goal producing time is longer than a time required to produce a total number of circuit boards at a maximum capacity of the mounter 100. Note also that the goal producing time is calculated adequately using the number of orders of circuit boards, operation days of a production plant, and the like, and obtained via the input unit 303 and the like.

The total producing board number obtainment unit 312 is a processing unit which obtains a total number of circuit boards to be produced within the goal producing time. Note that the total number is calculated adequately, as described above, using the number of orders, a balance with other production lines, and the like, and obtained via the input unit 303 and the like.

The mounting acceleration obtainment unit 313 is a processing unit which obtains from the database unit 307 a maximum possible mounting acceleration for each component. The mounting acceleration obtainment unit 313 obtains various accelerations in addition to the moving acceleration classified according to the classes of FIG. 13.

The mounting acceleration reduction unit 314 is a processing unit which gradually reduces the obtained maximum mounting acceleration regarding various accelerations. In the second embodiment, the mounting acceleration reduction unit 314 obtains mounting acceleration data and a component library from the database unit 307, and, in a case of mounting an electronic component 0603CR in FIG. 12, determines a mounting acceleration corresponding to Class 2 that is one class lower than Class 1 to which the electronic component 0603CR belongs. Note that, in the second embodiment, a mounting acceleration of electronic components classified in Class 16 is not reduced, since there is no lower class than Class 16.

The mounting order determining unit 315 is a processing unit which determines, for all electronic components to be mounted, which electronic component and in which order the line gang pickup head unit 110 should pick up, how the line gang pickup head unit 110 moves after the picking-up, and in which order the line gang pickup head unit 110 mounts the picked-up and sticked electronic component, for example. For example, when the mounter 100 is operated to obtain a maximum throughput, a mounting order is determined to complete all mounting in the shortest time period. Note that well-known algorithm is used for such determination.

The actual producing time calculation unit 316 is a processing unit which calculates an actual producing time required to produce circuit boards by simulating mounting processes based on the mounting acceleration of each electronic component obtained from the mounting acceleration reduction unit 314 and the mounting order obtained from the mounting order determining unit 315. Note that the actual producing time calculation unit 316 may calculate other data such as an actual producing time measured by actually performed production in the mounter.

The producing time comparison unit 317 is a processing unit which compares the actual producing time obtained from the actual producing time calculation unit 316 to a calculated goal producing time per one circuit board obtained from the goal producing time obtainment unit 311 and the total producing board number obtainment unit 312, and extracts the longest actual producing time that is not longer than the goal producing time per one circuit board.

Next, an operation of the mounting condition determining device 300 having the above structure is described.

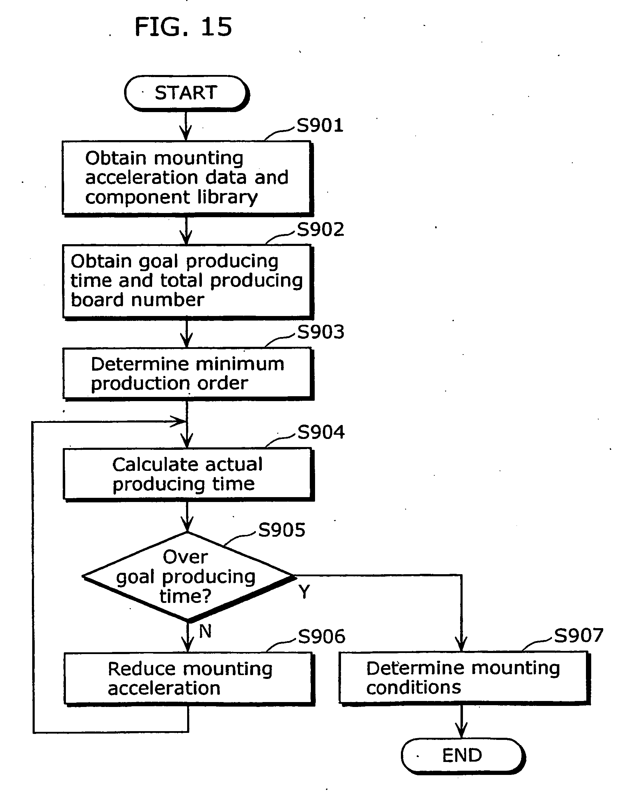

FIG. 15 is a flowchart showing processing performed by the mounting condition determining device 300 according to the second embodiment.

Firstly, the mounting condition determining unit 301 obtains mounting acceleration data and a component library from the database unit 307 (S901). Next, a goal producing time and a total number of boards to be produced are obtained (hereinafter, referring to as total producing board number) (S902). For example, the goal producing time is calculated using a daily operation time of the mounter 100, operation days of a whole plant, an amount of orders, and an estimated amount of orders. Note that the calculated goal producing time may include an additional time period in order to cope with unexpected additional orders. Note also that the goal producing time may be obtained from other order estimation systems.

Next, based on the mounting acceleration data and the maximum mounting acceleration allowed for each electronic component obtained from the component library, the mounting order determining unit 315 determines, using a well-known method, a mounting order in which circuit boards can be produced within the shortest time period (S903).

Next, the actual producing time calculation unit 316 calculates an actual producing time per one circuit board, based on the determined mounting order (S904).

Then, the producing time comparison unit 317 compares the actual producing time per one circuit board to the goal producing time (S905). If the actual producing time does not exceed the goal producing time (N at S905), then the mounting acceleration reduction unit 314 reduces the mounting acceleration of each component by lowering a class of each electronic component by one class (S906). In the second embodiment, among various accelerations, a moving acceleration of the line gang pickup head unit 110 is gradually reduced since the moving acceleration affects reduction of electricity consumption the most.

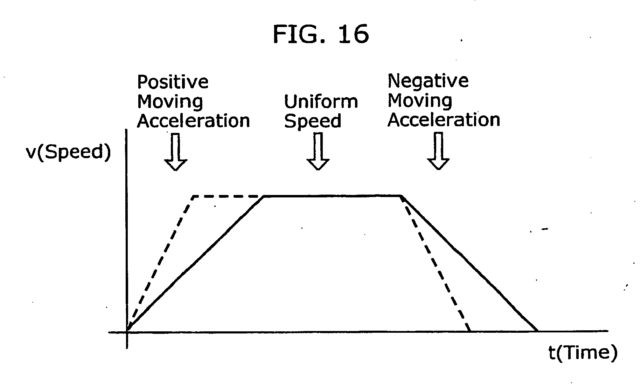

FIG. 16 is a graph showing a pattern relationship between a time and a speed of the line gang pickup head 110 when an electronic component belongs to a predetermined class is transported, according to the second embodiment.

A dashed line in the graph of FIG. 16 indicates when the predetermined electronic component is transported at maximum moving acceleration allowed for the component, while a full line in the graph indicates when the maximum moving acceleration is reduced.

As shown in FIG. 16, in the second embodiment, not only a positive moving acceleration until a predetermined speed, but also a negative moving acceleration until the line gang pickup head 110 stops above a mounting point is reduced. This is because a large amount of electricity is required for the mounter 100 not only to accelerate the moving speed of the line gang pickup head 110 up to a certain speed (positive moving acceleration), but also to slow down the moving speed of the line gang pickup head 110 to be stopped (negative moving acceleration).

Next, based on the reduced mounting acceleration, an actual producing time per one circuit board is calculated again (S904) and the re-calculation is repeated until the actual producing time exceeds the goal producing time.

If the actual producing time exceeds the goal producing time (Y at 5905), then the mounting order obtained at Step S903 and a mounting acceleration determined immediately prior to the exceeding are determined as new mounting conditions (S907).

Note that, in a case where simultaneous lowering of classes of all electronic components results in exceeding the goal producing time, the actual producing time may be calculated by lowering each class of each electronic component to perform Steps S904 to S907. In this case, an order in which the classes of electronic components are lowered may be from the lowest class, in other words, from a component having a greatest mounting acceleration, or from the highest class. Furthermore, the order may be designated arbitrarily.

The second embodiment performs also determination of the mounting order to reduce electricity consumption, as described below.

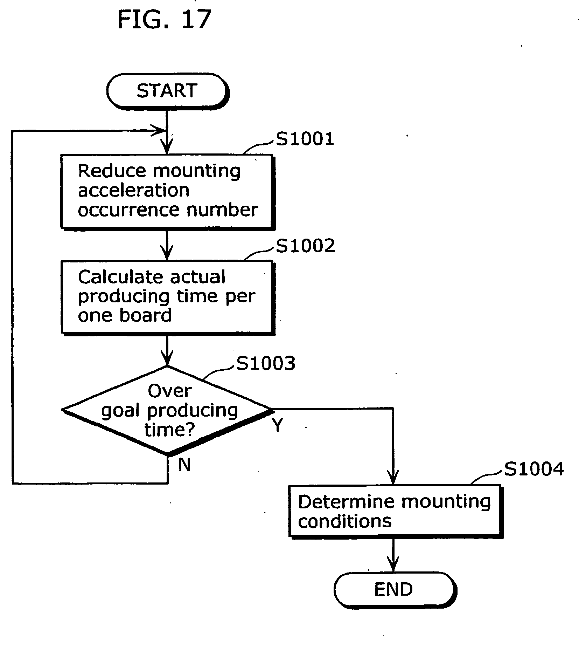

FIG. 17 is a flowchart showing an operation for the mounting order determination according to the second embodiment.

The mounting order determining unit 315 determines a mounting order by which at least one of an, occurrence number of the highest mounting acceleration (or maximum acceleration) is reduced compared to the determined shortest mounting order (S1001). More specifically, for example, in a case where electronic components stored in the lower tray and the upper tray of the tray-type supplying unit 155b as shown in FIG. 10 are to be mounted sequentially, if a circuit board should be produced in the shortest time period, a mounting order is determined in order to use an idle time for other mounting processes. For example, after the line gang pickup head 110 picks up and sticks an electronic component from the lower tray, the line gang pickup head 110 has to wait until the upper tray is protruded from the tray-type supplying unit 155b (idle time occurs), so that the idle time is used for moving the line gang pickup head 110 in order to obtain another electronic component from another position or for mounting the already picked-up and sticked component. On the other hand, at the mounting order determination step S1001, even if it takes a time to change trays from the lower tray to the upper tray to be protruded from the tray-type supplying unit 115b, a mounting order is determined so that the moving line gang pickup head 110 waits without moving to other positions and after picking up the electronic component on the upper tray moves to other positions. Thus, the number of moves of the line gang pickup head 110, namely, the occurrence number of mounting accelerations is reduced.

Next, based on the determined mounting order, the actual producing time calculation unit 316 calculates an actual producing time per one circuit board (S1002), and the producing time comparison unit 317 compares the calculated actual producing time to the goal producing time (S1003). The above calculating and comparing are repeated until the actual producing time exceeds the goal producing time (N at S1003).

Then, if the actual producing time exceeds the goal producing time per one circuit board (Y at S1003), then the mounting order determined at Step S1001 and a mounting acceleration determined immediately prior to the exceeding are determined as new mounting conditions (S1004).

When the mounter 100 actually mounts electronic components onto a board according to the mounting conditions obtained according to the above-described device structure and operations, it is possible to produce all ordered circuit boards at a slow pace within a time period nearly equal to but not longer than the goal producing time, in other words, within a delivery deadline, and at the same time possible to reduce electricity consumption required for production per one circuit board. That is, it is possible to effectively reduce a cost for production of one circuit board.

This is because unnecessary energy loss due to high-speed operation can be controlled. Especially, reduction of a moving acceleration of the heavy line gang pickup head 110 and reduction of the occurrence number of the moving acceleration by determining the mounting order are considered to have great effect of directly reducing electricity consumption.

Furthermore, the reduction of the mounting accelerations including the moving acceleration results in reduction of electricity consumption indirectly. More specifically, the mounter 100 emits a large amount of heat when causing the mounting acceleration. Especially when a negative acceleration occurs, for example when the line gang pickup head 110 is slowed down, kinetic energy of the line gang pickup head 110 is emitted as heat. The mounter 100 should operate a cooling fan (not shown) in order to cool the mounter heated by the emitted heat. Therefore, the reduction of mounting acceleration or the reduction of the occurrence number of the mounting acceleration result in restraint on the heat emission, thereby reducing an operation frequency or a operation rate of the cooling fan, which makes it possible to reduce electricity consumption. Accordingly, the reduction of the mounting acceleration results in the reduction of electricity consumption of the mounter 100 indirectly.

Moreover, the reduction of the mounting acceleration results in an extended lifetime of the mounter 100.

This is because, the reduction of the mounting acceleration results in restraint on loads of movable elements of the mounter 100 due to high-speed operation, thereby reducing interchange frequency of the elements of the mounter 100, which makes it possible to reduce a time and a cost required to interchange the elements. This contributes cost reduction for a whole production plant, eventually resulting in cost reduction for production of one circuit board.

As described above according to the second embodiment of the present invention, it is possible to effectively reduce a cost price of a circuit board eventually, and also to contribute to environmental issues by energy saving.

Furthermore, according to the second embodiment of the present invention, the reduction of the mounting acceleration provides an additional effect of reducing sound caused by operation which occurs by friction between elements of the mounter 100.

Therefore, the determination can contribute to a solution of an environmental problem of noise and provides a further additional effect of reducing mental and physical stresses of workers caused by the noise.

Note that the second embodiment has described the structure in which the mounting condition determining device 300 is embedded in the mounter 100, but the present invention does not limit the structure to the above.

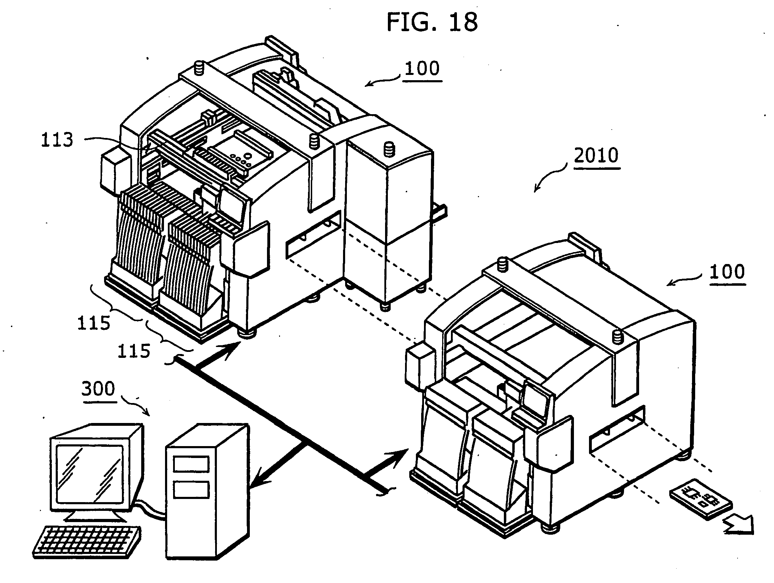

For example, as shown in FIG. 18, the mounting condition determining device 300 may be formed as a separate apparatus and may determine mounting conditions for each mounter 100 embedded in a mounting line 2010 (not shown).

Furthermore, the reduction of the mounting acceleration is not necessarily performed for all electronic components, but may be performed for only component having the greatest mounting acceleration by gradually lowering a class of the component not to exceed the goal producing time.

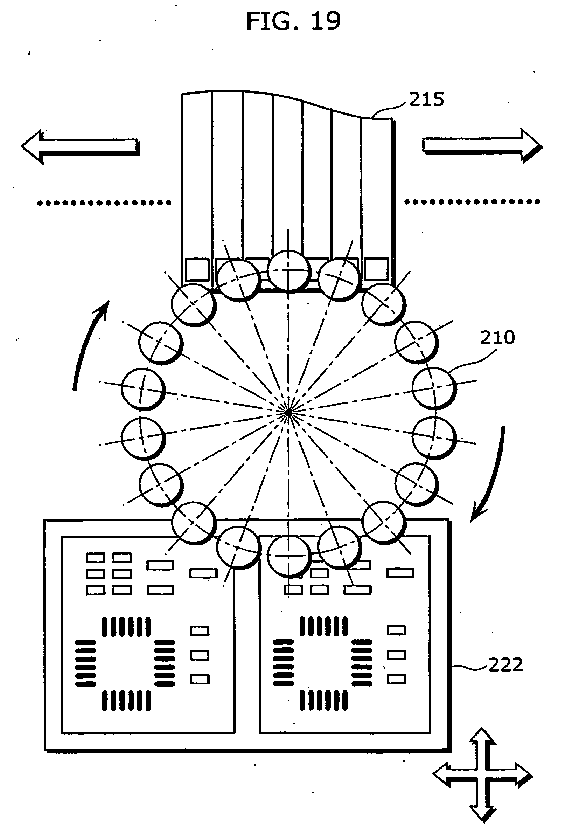

Still further, the acceleration to be reduced may be at least one of accelerations caused during mounting. For example, in the second embodiment, the reduced acceleration is the moving acceleration in a horizontal direction of the line gang pickup head 110 in the mounter that is a so-called modular-type mounter, but the reduced acceleration may be an acceleration caused when an electronic component that is picked up by a mounting head is transported vertically. Still further, as shown in FIG. 19, in a case of using a so-called rotary-type mounter in which a plurality of mounting heads 210 rotates around a fixed shaft to perform picking-up, transportation, and mounting, and a component supplying unit 215 and boards move in a horizontal direction, the reduced acceleration may be a rotation acceleration of the mounting heads 210, a moving acceleration of the supplying unit 215, or a moving acceleration of a table 222 which transports the boards in a X-Y direction.

Still further, an amount of the acceleration reduction is reduced not only gradually based on a predetermined table, but also arbitrarily.

### (Variation)

The following describes a variation of the method of determining mounting condition.

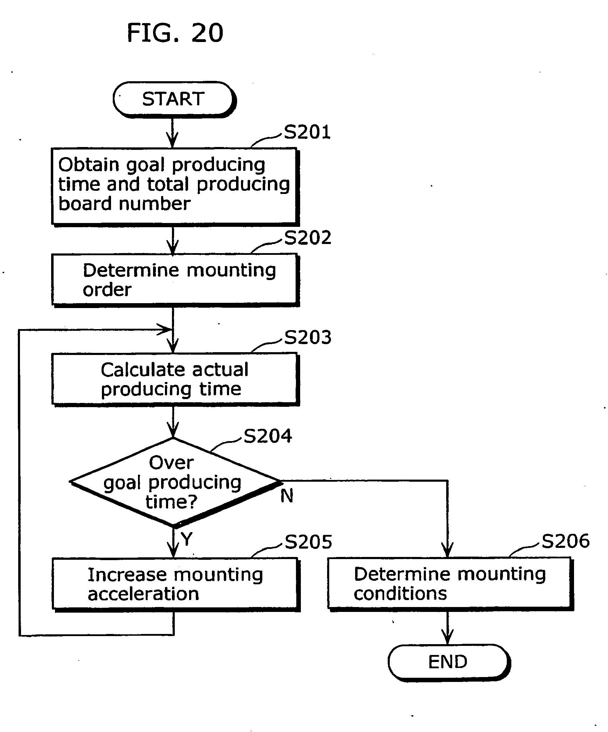

FIG. 20 is a flowchart showing another processing performed by the mounting condition determining device 300.

Firstly, the mounting condition determining unit 301 obtains a goal producing time and a total producing board number (S201). Next, based on mounting acceleration data and a lowest mounting acceleration (minimum acceleration) allowed for each electronic component obtained from the component library, the mounting order determining unit 315 determines a mounting order using a well-known method (S202).

Next, the actual producing time calculation unit 316 calculates an actual producing time per one circuit board, based on the determined mounting order (S203).

Then, the producing time comparison unit 317 compares the actual producing time per one circuit board to the goal producing time. If the actual producing time exceeds the goal producing time (Y at S204), then a mounting acceleration of each component is increased by increasing a class of each component by one class (S205).

Next, based on the increased mounting acceleration, an actual producing time per one circuit board is calculated (S203) and the calculation is repeated until the actual producing time becomes less than the goal producing time.

Then, if the actual producing time becomes less than the goat producing time (N at S204), then the mounting order obtained at Step S202 and a mounting acceleration determined when the actual producing time becomes less than the goal producing time are determined as new mounting conditions (S206).

By the above mounting condition determining method, an original acceleration is set to be a minimum level in consideration of energy saving, then a mounting order is determined based on the minimum acceleration, then a target acceleration is determined using the mounting order, and an actual producing time is estimated based on the target acceleration, so that the most appropriate mounting conditions can be determined.

Note that in the above embodiments the mounting conditions are determined by reducing or increasing accelerations, but the mounting conditions may be determined,by reducing or increasing speeds. Note also that an initial level of the acceleration may be set according to a ratio of a goal producing time to a producing time required to produce circuit boards under the fastest-mounting conditions.

Note also that in the above embodiments the mounting conditions are determined to obtain an actual producing time that is nearly equal to but not longer than the goal producing time. However, the present invention is not limited to the above and the purpose of the mounting conditions may be anything as far as electricity consumption can be reduced under the situation that the actual producing time does not exceed the goal producing time.

Note also that the goal producing time may be a deadline for completing goal production.

### (Third Embodiment)

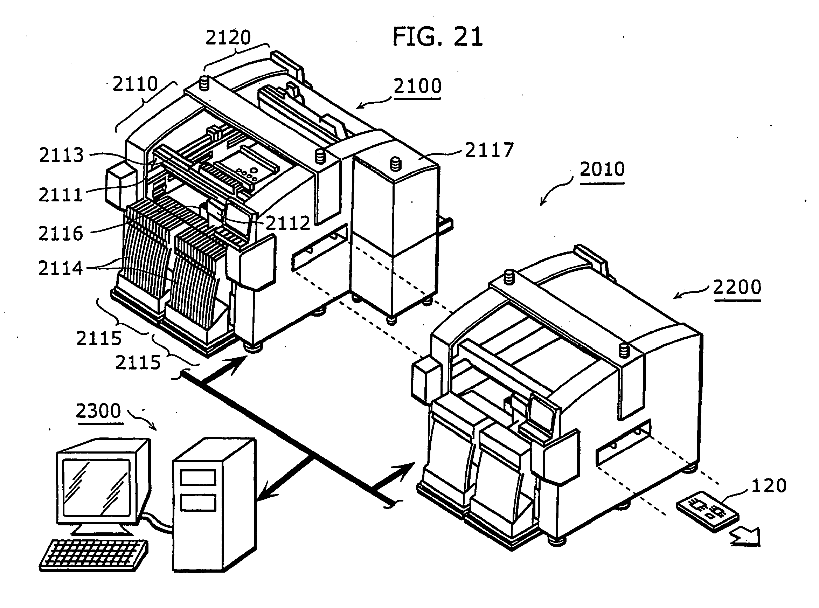

FIG. 21 is an outline perspective view showing a whole structure of a mounting line 2010 according to the third embodiment of the present invention.

The mounting line 2010 is a production line where electronic components are mounted onto a board 120 that is transported from upstream to downstream. The mounting line 2010 includes a plurality of mounters 2100 and 2200, and a mounting condition determining device 2300. The mounters 2100 and 2200 are devices each of which mounts components on a board. The mounting condition determining device 2300 is a device which determines, at a timing of beginning production for example, mounting conditions such as the number of using beams based on various databases, a mounting order of electronic components, and the like, and then downloads the obtained numeric control (NC) data into the mounters 2100 and 2200 in order to control the mounters 2100 and 2200.

The mounter 2100 includes component two supplying units 2115, a line gang pickup head 2112, a beam 2113, a component recognizing camera 2116, a tray supplying unit 2117, and the like. The component supplying units 115 are each made up of an array of component feeders 114 that store component tapes. The line gang pickup head 2112 has a plurality of stiction nozzles (hereafter, referred to also as simply "nozzles") that can pick up and stick components from the component feeder 2114 and mount them onto the board 120. The beam 2113 is equipped with the line gang pickup head 2112. The component recognizing camera 2116 investigates the stiction state of the components that have been sticked by the line gang pickup head 2112 in two or three dimensions. The tray supplying unit 2117 supplies trays. Note that the tray supplying unit 2117 can be arbitrarily equipped in or de-equipped from the mounter 2100.

Here, the "component tape" refers to a tape (a carrier tape) in which a number of the same type of components have been arranged, with such tape being supplied from a reel (a supply reel) or the like around which the tape has been wound. The component tapes are usually used to supply relatively small components called "chip components" to a mounter.

The mounter 2100 is a mounting device that includes the functions of both a mounting device commonly called a high-speed mounter and a mounting device called a multi-function mounter. A high-speed mounter is a device that is capable of mounting electronic components that are 10 mm² or smaller in around 0.1 seconds, while a multi-function mounter is a device that can mount large electronic components that are 10 mm² or larger, irregularly shaped components like switches and connectors, and IC components like quad flat package (QFP) or ball grid array (BGA) components.

In short, the mounter 2100 is designed so as to be able to mount almost all types of electronic components to be mounted from 0.4 mm by 0.2 mm chip resistors to 200 mm connectors, with a production line being formed by arranging the required number of mounters 2100 in a line.

Note that a structure of the mounter 2200 is the same as the structure of the mounter 2100 so that the detail of the structure of the mounter 2200 is the same as described for the mounter 2100.

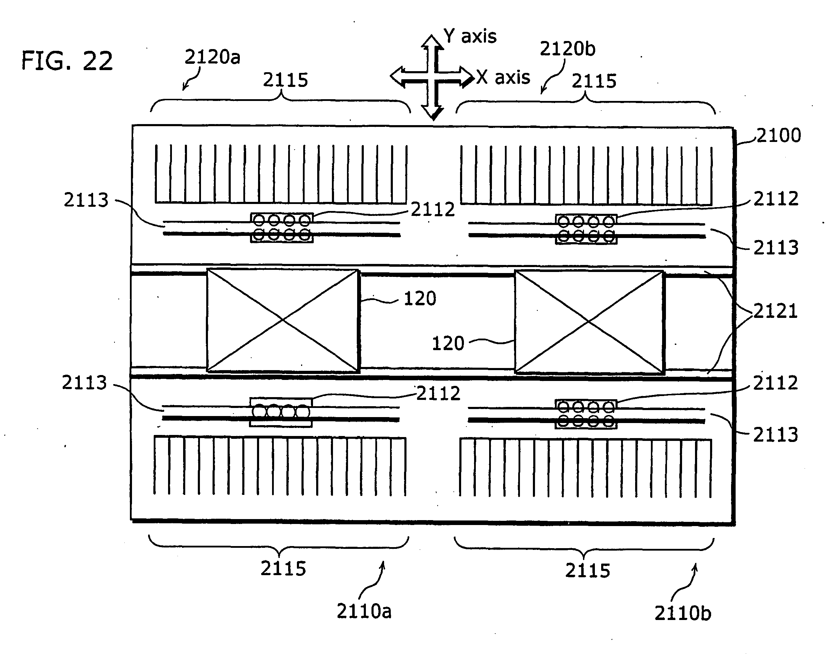

FIG. 22 is a plane view showing a main structure of the mounter 2100.

The mounter 2100 is equipped with four stages 2110a, 2110b, 2120a, and 2120b which are arranged in a direction of board transportation (X axis direction) and also at a front-rear direction of the mounter 2100 (Y axis direction). A pair of stages arranged in the X axis direction (2110a and 2110b, and 2120a and 2120b) operate independently of one another to perform different mounting process at the same time. On the other hand, another pair of stages arranged in the front-rear direction (Y axis direction) (2110a and 2120a, and 2110b and 2120b) operate in concert to perform the same mounting process for one board.

Each stage 2110a, 2110b, 2120a, or 2120b has a beam 2113, a line gang pickup head 2112, a component supplying unit 2115, and a beam motor (not shown) driving the beam. Note that the stage further includes a head motor which drives the line gang pickup head 2110, but the head motor is not shown in FIG. 22. Note also that the stage still further includes other units (not shown) in order to perform a whole mounting process, such as a component recognizing camera 2116 which investigates the stiction state of the components that have been sticked by the line gang pickup head 2112 in two or three dimensions, a nozzle station on which interchangeable nozzles are positioned, and the like. Note also that the mounter 2100 has, between a front stage and a rear stage, a pair of rails 2121 along which the board 120 is transported.

Note that the component recognizing camera 2116 and the tray supplying unit 2117 are not essential to the present invention, so that these units are not shown in FIG. 22.

The beam 2113 is a rigid body extending in the X axis direction which moves in a direction parallel to the X axis direction along a track (not shown) formed in the Y axis direction (a direction perpendicular to the direction of transporting the board 120), and is driven the above-mentioned beam motor. Moreover, the beam 2113 can move the equipped line gang pickup head 2112 alont the beam 2113, namely, in the X axis direction, so that the beam 2113 can move the line gang pickup head 2112 flexibly on a X-Y plane when the beam 2113 moves in the Y axis direction and the line gang pickup head 2112 is moved in the X axis direction. Still further, the beam 2113 includes a plurality of motors (not shown) such as beam motors for driving the line gang pickup head 2112. The beam motors are supplied with electricity via the beam 2113.

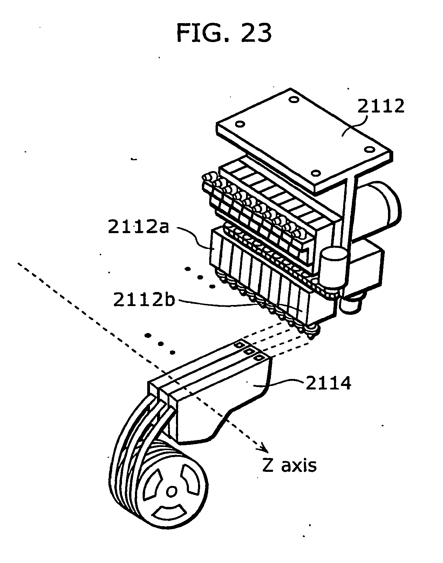

FIG. 23 is a perspective pattern view showing a position relationship between the line gang pickup head 2112 and the component feeder 2114 according to the third embodiment.

The line gang pickup head 2112 can be equipped with a plurality of stiction nozzles 2112a to 2112b by which the line gang pickup head 2112 can pick up from the component feeder 2114 the same number of electronic components as the maximum number of the equipped stiction nozzles 2112a to 2112b, simultaneously in a single nozzle stroke.

The line gang pickup head 2112 can move along the beam 2113, which is driven by the motor (not shown). The motor also drives the line gang pickup head 2112 to stick electronic components and to stroke for mounting the electronic components onto the board 120.

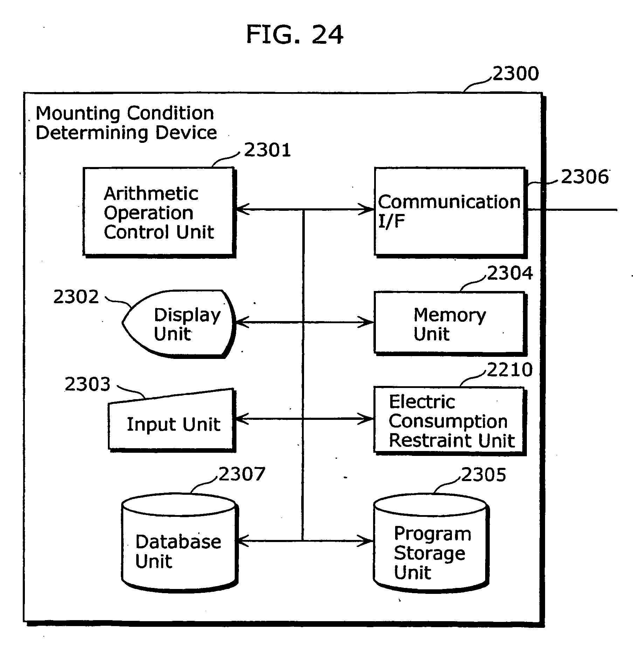

FIG. 24 is a block diagram showing a functional structure of the mounting condition determining device 2300.

The mounting condition determining device 2300 shown in FIG. 24 is a device which determines new mounting conditions based on a result of comparing an actual value to a setting value of a parameter regarding electricity consumption, under various restrictions due to a specification of the mounter 2100. The mounting condition determining device 2300 includes an electricity consumption restraint unit 2210, an arithmetic operation control unit 2301, a display unit 2302, an input unit 2303, a memory unit 2304, a program storage unit 2305 storing electricity consumption restraint programs, a communication I/F 2306, and a database unit 2307.

Here, the "mounting conditions" refer to various conditions regarding mounting of electronic components. Example of the mounting conditions are a mounting order of electronic components, a moving speed (acceleration) of the line gang pickup head 2112 which has sticked electronic components, information whether or not each beam 2113 is to be used, and the like.

The electricity consumption restraint unit 2210 is realized by executing the electricity consumption restraint program according to the third embodiment, serving as a simulator for the mounter 2100. More detail of the electricity consumption restraint unit 2210 is described further below.

The arithmetic operation control unit 2301 is a central processing unit (CPU), a numerical value processor, or the like, for controlling each units of the mounter 2100 according to instructions from a user.

The arithmetic operation control unit 2301 creates a component library and the like and stores them into the database unit 2307.

The display unit 2302 is a cathode ray tube (CRT), a liquid crystal display (LCD), or the like, while the input unit 2303 is an input device such as a keyboard, a mouse, a touch panel, or the like. These are used to input data for controlling the mounter 2100, such as a goal producing time, the number of circuit boards to be produced within the goal producing time, and the number of beams to be used, according to communication between an operator and the mounter 100.

The memory unit 304 is a random access memory (RAM) or the like that provides a work area for the arithmetic operation control unit 2301.

The program storage unit 2305 is a hard disk drive or the like storing a variety of determination programs that realize the functions of the mounting condition determining device 2300.

The communication I/F 2306 is a processing unit which sends the data created by the electricity consumption restraint unit 2210 to the mounter 2100, and receives various data sent from the mounting line 2010.

The database unit 2307 is a hard disk drive or the like storing predetermined data such as the component library used for the determination performed by the mounting condition determining device 2300, a mounting order generated based on the determination, and the like.

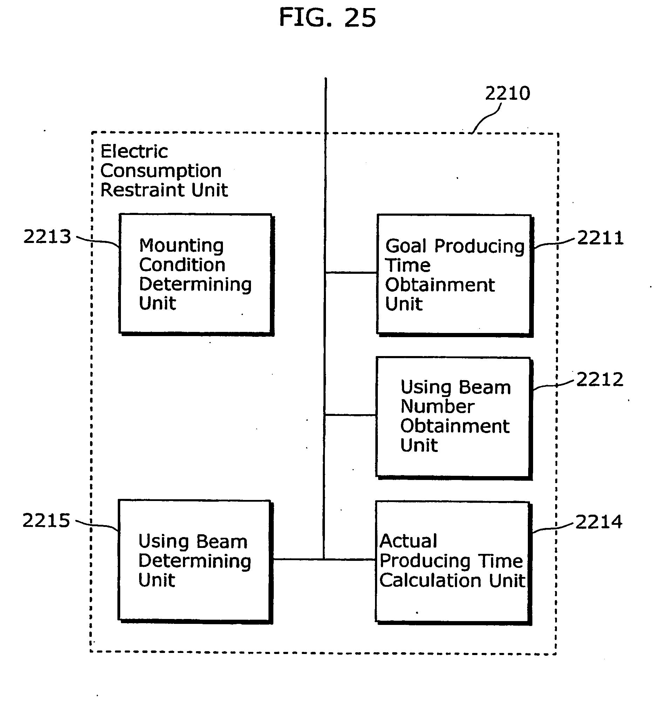

FIG. 25 is a block diagram showing in detail a functional structure of the electricity consumption restraint unit 2210.

The electricity consumption restraint unit 2210 shown in FIG. 25 is a processing unit which determines the most appropriate number of beams to be used, based on the obtained various information. The electricity consumption restraint unit 2210 also determines other mounting conditions using the determined number of using beams as restriction information. The electricity consumption restraint unit 2210 includes a goal producing time obtainment unit 2211, an using-beam number obtainment unit 2212, a mounting condition determining unit 2213, an actual producing time calculation unit 2214, and an using beam determining unit 2215.

The goal producing time obtainment unit 2211 is a processing unit that obtains a goal producing time which is a setting value of a producing time as a parameter regarding electricity consumption and within which all predetermined number of circuit boards should be produced. Note that the goal producing time is longer than a time required to produce a total number of circuit boards at a maximum capacity of the mounter 2100. Note also that the goal producing time is calculated adequately using the number of orders of circuit boards, operation days of a plant, and the like.

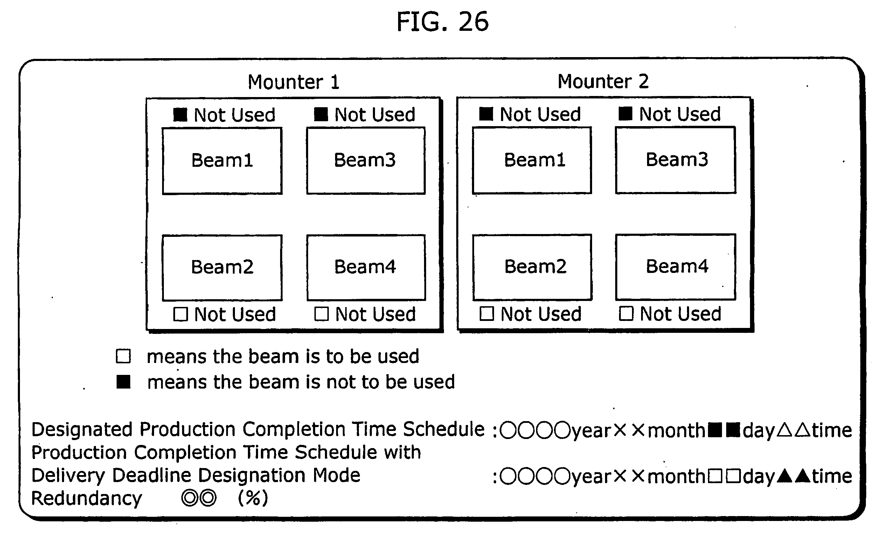

The using beam number obtainment unit 2212 is a processing unit which obtains the number of beams to be used as an initial value for determining mounting conditions. The using beam number obtainment unit 2212 obtains, for example, the number of using beams obtained when an operator arbitrarily selects beams to be used by using a screen as shown in FIG. 26, or the number of beams calculated using a goal producing time and a fastest producing time calculated based on maximum performance of the mounter 2100.

The mounting condition determining unit 2213 is a processing unit which determines, using a well-known method, a mounting order of electronic components or an arrangement order of the component feeders 2114 in a component supplying unit 2115, based on the number of beams obtained by the using beam number obtainment unit 2212 and the like.

The actual producing time calculation unit 2214 is a processing unit which calculates an actual producing time as an actual time required to produce circuit boards, by simulating component mounting processing performed by the mounter 2100, based on mounting conditions determined by the mounting, condition determining unit 2213.

The using beam determining unit 2215 is a processing unit which compares the goal producing number obtained by the goal producing time obtainment unit 2211 to the actual producing time obtained by the actual producing time calculation unit 2214, and then determines a minimum number of using beams by which the actual producing time does not exceed the goal producing time.

Next, an operation of the electricity consumption restraint unit 2210 having the above structure is described.

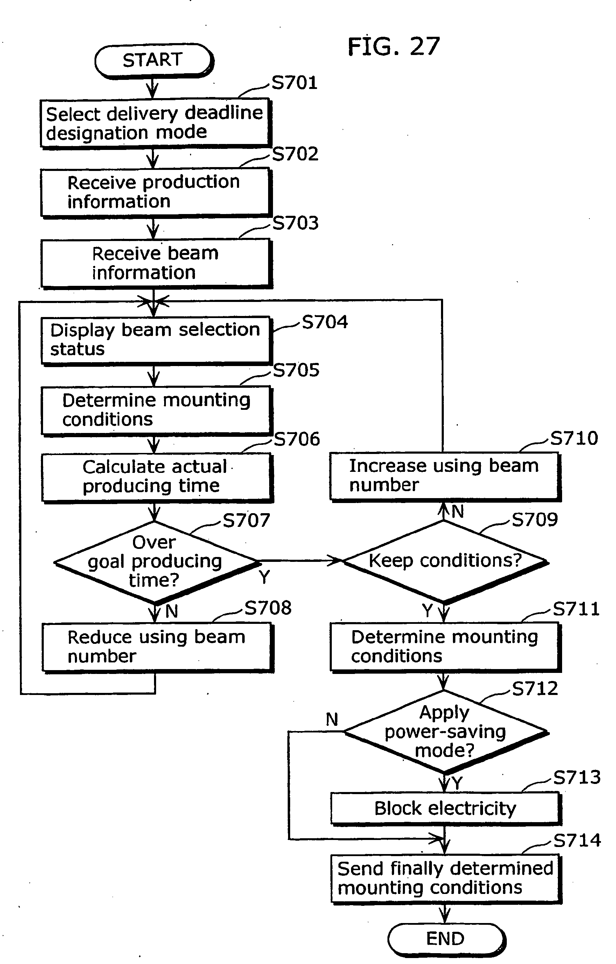

FIG. 27 is a flowchart showing a processing performed especially by the mounting condition determining device 2300 and the electricity consumption restraint unit 2210.

Firstly, using the input unit 2303, the display unit 2302, and the like, an operator selects a delivery deadline designation mode (S701). When the delivery deadline designation mode is selected, a screen as shown in FIG. 26 is displayed on the display unit 2302. Using the screen, the operator inputs a delivery deadline (designated production completion time schedule) and a daily operation time of a mounting line, the number of boards to be produced within the delivery deadline (S702).

Next, the operator inputs beams not to be used on the screen of FIG. 26 (S703).

The display unit 2302 displays the screen of FIG. 26 with the above selection results (S704).

Next, the mounting condition determining unit 2213 determines mounting conditions based on, as restriction information, the number and arrangement of the beams to be used that have been selected on the screen of FIG. 26 (S705).

The actual producing time calculation unit 2214 calculates an actual producing time based on the determined mounting conditions (5706).

The using beam determining unit 2215 examines whether or not the calculated actual producing time exceeds a goal producing time (S707). If the calculated actual producing time does not exceed the goal producing time (N at S707), then the determined mounting conditions including the current number of using beams are kept, and at the same time the current number of using beams is reduced with one beam and the resulting reduced number is sent back to the using beam number obtainment unit 2212 (S708). On the other hand, if the calculated actual producing time exceeds the goal producing time (Y at S707), then an examination is made as to whether or not previously kept mounting conditions including the number of using beams are still kept (S709). If the previously determined conditions are not kept any more (N at S709), the current number of using beams is increased with one beam and the increased number is sent back to the using beam number obtainment unit 2212 (S710).

The above steps from S704 to S710 are repeated until the actual producing time exceeds the goal producing time. When the actual producing time exceeds the goal producing time and the previously determined mounting conditions are still kept (Y at S709), the kept mounting conditions are determined as final mounting conditions (S711).

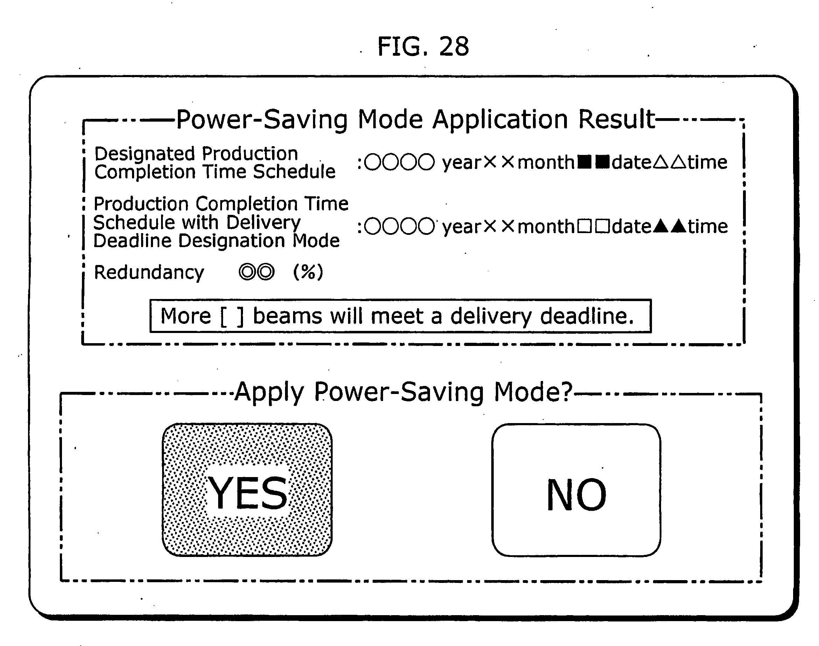

Next, a screen as shown in FIG. 28 is displayed and receives information whether or not production is performed according to a power-saving mode in which mounting conditions are determined by reducing the number of using beams (S712).

If the power-saving mode is applied (Y at S712), electricity supplied to beams not to be used is blocked (S713).

Finally, the kept mounting conditions are sent to the mounter 2100 via the communication I/F 2306, and at the same time a signal is sent to stop supplying electricity to each beam not to be used (S714).

Note that, if the power-saving mode is not applied (N at S712), then mounting conditions are determined assuming that all beams are to be used and the determined mounting conditions are sent to the mounter 2100.

Note that the third embodiment has described that the initial beams are selected arbitrarily, but the initial beams may be set to have a minimum total number, and then the minimum number is increased until the actual producing number becomes less than the goal producing time.

When the mounter 2100 actually mounts electronic components onto a board according to the mounting conditions obtained by the above-described device structure and operations, it is possible to produce all ordered circuit boards using the reduced beams 2113 within a delivery deadline, thereby effectively reducing electricity consumption.

The electricity supplied to the beam 2113 is used not only for the motor driving the beam in the Y axis direction but also for the motor driving the line gang pickup head 2112 moving along the beam 2113, lighting, and the like, so that the blocking of electricity provides a great effect of reducing electricity consumption.

Moreover, electricity consumption is reduced while the amount of produced circuit boards is not changed, so that it is possible to reduce electricity required for production per one circuit board.

Furthermore, it is possible to extend a lifetime of the mounter 2100. This is because, when the production can complete advance of the goal producing time and a redundant time occurs, the redundant time is effectively used. More specifically, in such a case, some beams are stopped not to increase a total operation time of the stopped beams, so that interchange frequency of interchangeable elements in the beams can be reduced. Therefore, whenever such redundant time occurs, beams are selected in turn not to be used, which eventually makes it possible to extend the lifetime of the mounter 2100.

As described above, according to the third embodiment of the present invention, it is possible to restrain electricity consumption, and eventually to effectively reduce a cost price of a circuit board and also to contribute to environmental issues by energy saving.

Note that the third embodiment has described the structure in which the electricity consumption restraint unit 2210 is embedded in the mounting condition determining device 2300 managing the mounting line 2010, but the present invention does not limit the structure to the above. For example, the electricity consumption restraint unit 2210 may be embedded in the mounter 2100.

Note also that the third embodiment has described that electricity supplied to the beams 2113 is blocked, but it is also possible to block electricity supplied to the stages 2110a, 2110b, 2120a, and 2120b having the beams 2113. In such a case, a possibility of electricity consumption reduction is further increased.

Note that the third embodiment has described that the number of using beams is determined to save electricity, but the present invention does not limit to the above. For example, in order to save electricity used for a whole mounting line, the number of mounters in the mounting line may be determined. Note also that the present invention can be realized even if, in the explanation of the third embodiment, the mounter is replaced with the mounting line, and the beam is replaced with the mounter in the mounting line.

### (Fourth Embodiment)

The following describes the fourth embodiment of the present invention. Note that the same elements are designated by the same reference numerals in the third embodiment, so that details of the elements are the same as described above.

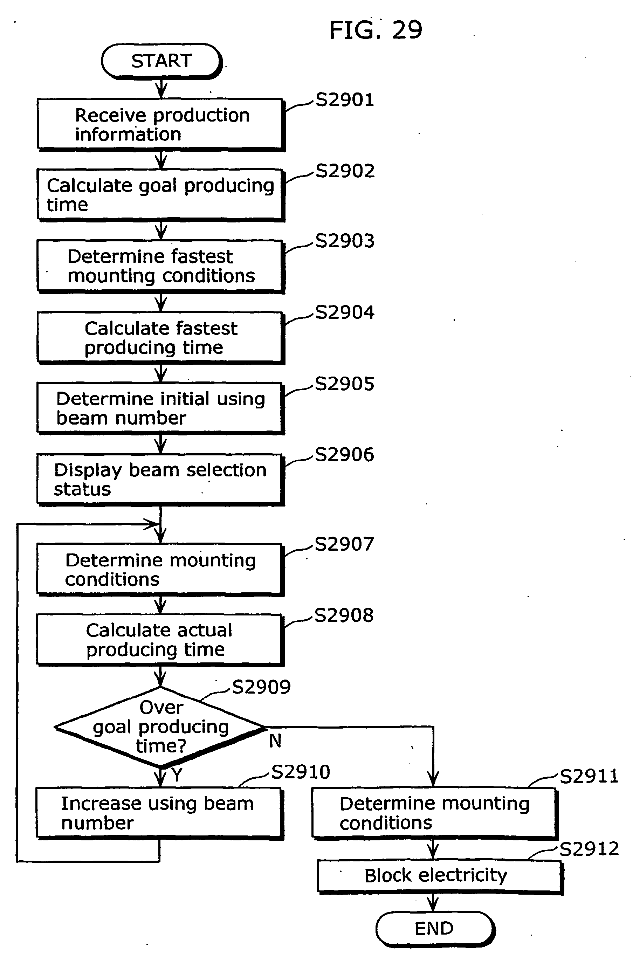

FIG. 29 is a flowchart showing processing performed especially performed by the mounting condition determining device 2300 and the electricity consumption restraint unit 2210 according to the fourth embodiment.

Firstly, using the input unit 2303, the screen of FIG. 26 displayed by the display unit 2302, and the like, an operator inputs a delivery deadline, a daily operation time of a mounting line, the number of boards to be produced within the delivery deadline, and the like (S2901).

The goal producing time obtainment unit 2211 calculates using the above data a goal producing time that is a time require to produce the necessary number of circuit boards (S2902).

Next, the mounting condition determining unit 2213 determines mounting conditions in order to produce the circuit boards at the fastest speed using all beams in the mounter 2100 (S2903).

The actual producing time calculation unit 2214 calculates a fastest actual producing time required to produce the circuit boards, based on the determined mounting conditions (S2904).

The using beam number obtainment unit 2212 determines the number of using beams (all beams in this case) as an initial number, using a ratio of the fastest producing time to a goal producing time (S2905). For example, the fastest producing time is divided by the goal producing time, then the obtained value is multiplied with a value of four that is the total number of using beams, next the obtained value is rounded off to be an integral number, and eventually the obtained number is determined as the initial number of using beams.

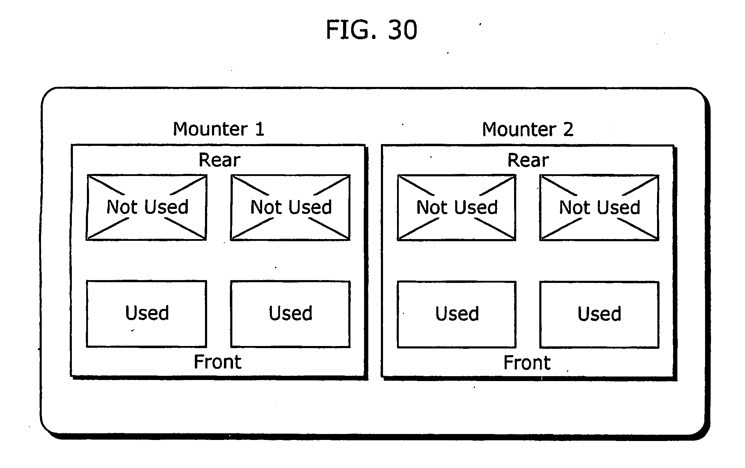

Next, the number of using beams is set by choosing beams sequentially from the front stage 2110 of the mounter 2100, and the set status is displayed on a screen as shown in FIG. 30 (S2906). Thus, by selecting beams firstly from a beam arranged in one of two rows parallel to a direction of transporting the board 120, it is possible to expect improvement of the throughput. This is because beams arranged in the X axis direction (transportation direction) can operate independently of one another to perform each mounting process for each different board 120, so that such beams do not have to stop during process of other beams. On the other hand, beams arranged in the Y axis direction operate in concert to perform the same mounting process, so that such beams sometimes have to wait until another beam completes its tasks.

Next, the operator checks the screen and can change the arrangement (positions) of using beams at this stage, according to a reason that the rear stage 2120 can set the component feeders 2114 easier than the front stage 2110, for example.

If the operator confirms the displayed data, then the mounting condition determining unit 2213 determines mounting conditions based on the reduced number of beam and the arrangement of the beams as restriction information (S2907).

The actual producing time calculation unit 2214 calculates an actual producing time based on the determined mounting conditions (S2908).

The using beam determining unit 2215 examines whether or not the calculated actual producing time exceeds the goal producing time (S2909). If the actual producing time exceeds the goal producing time, then the number of using beams is increased with one beam and the obtained number is sent back to the using beam number obtainment unit 2212 (S2910).

On the other hand, if the actual producing time does not exceed the goal producing time (N at S2909), the mounting conditions including the current number of using beams are determined as final mounting conditions (S2911).

Finally, the determined mounting conditions are sent to the mounter 2100 via the communication I/F 2306, and at the same time a signal is sent to stop supplying electricity to each beam not to be used (S2912).

An effect obtained using the mounting conditions determined by the above operation is the same as the effect of the third embodiment.

Additionally, according to the fourth embodiment, if a minimum number of using beams is previously determined by a separate simple method, the steps in the operation can be reduced and the mounting conditions can be determined more smoothly.

### (Variation)

The following describes a variation of the fourth embodiment. In order to increase the effect of energy saving, it is also possible to modify the determined mounting conditions including the number of using beams.

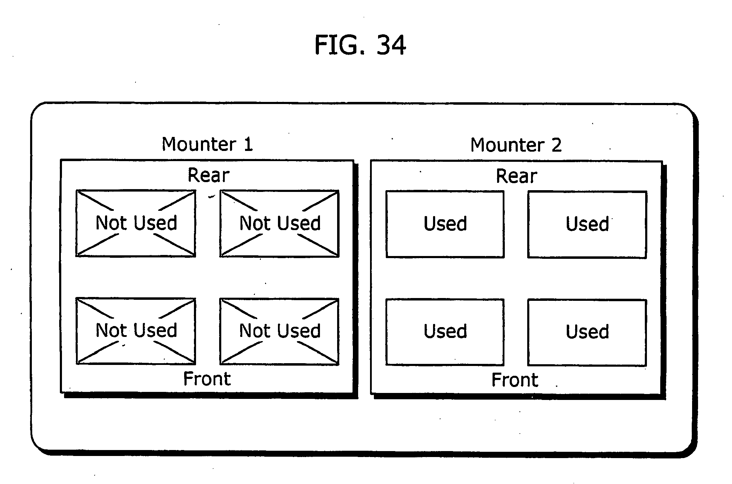

For example, when beams in a plurality of mounters 2100 are selected to be used as shown in FIG. 30, the using beams can be grouped together in the same mounter as shown in FIG. 34 in order to reduce the number of mounters 2100 to be operated.

Beams facing each other have to alternately perform each mounting process for a single board 120, so that an actual producing time is extended. However, as far as the production can complete within a goal producing time even if the actual producing time is extended, it is effective to turn off one mounter 2100 in order to further increase the energy saving effect.

Note that, if the beams to be used are grouped together as described above, it is desirable to keep a balance of the number of tasks among such beams.

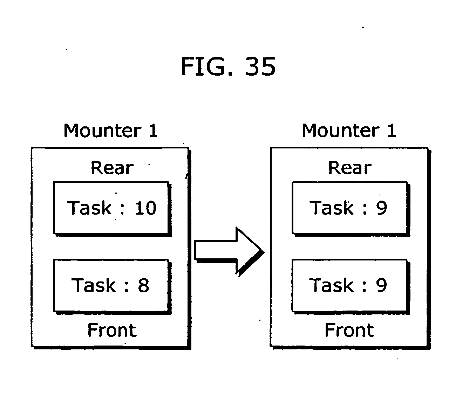

For example, as shown in FIG. 35, by grouping the beams, the number of tasks of a front beam in the facing beams becomes eight and the number of tasks of a rear beam becomes ten, it is desirable to keep the task balance by setting each number of tasks as nine.

Thereby, if the front beam performs eight tasks and the rear beam performs ten tasks, these beams can perform mounting tasks alternately until the eighth time, but from the ninth time the front beam stops (idle time occurs), so that two of mounting tasks which are performed by only the rear beam can be eliminated, which makes it possible to shorten a total mounting time for a whole mounter 2100. Therefore, using the idle time, it is possible to further reduce electricity consumption, for example, to reduce acceleration.

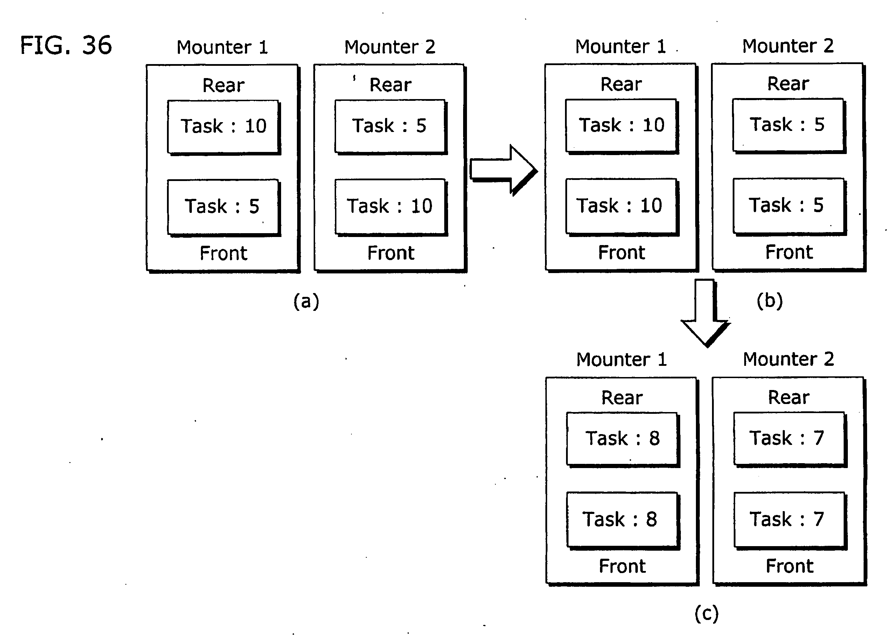

Furthermore, as shown in FIG. 36, it is also possible to keep a balance of the number of tasks among the mounters 2100. More specifically, as shown in FIG. 36 (a), when each beam has different number of tasks, it is possible to exchange the tasks between the mounters 2100 so that facing beams can have the same number of tasks. Still further, it is possible to exchange tasks among all mounters 2100 to keep the task balance, as shown in FIG. 36 (c).

Thereby, it is possible to generate an idle time to used for improving throughput of a whole mounting line. Therefore, using the idle time, it is possible to further reduce electricity consumption.

### (Fifth Embodiment)

The following describes the fifth embodiment according to the present invention. Note that the same elements are designated by the same reference numerals in the third embodiment, so that details of the elements are the same as described above.

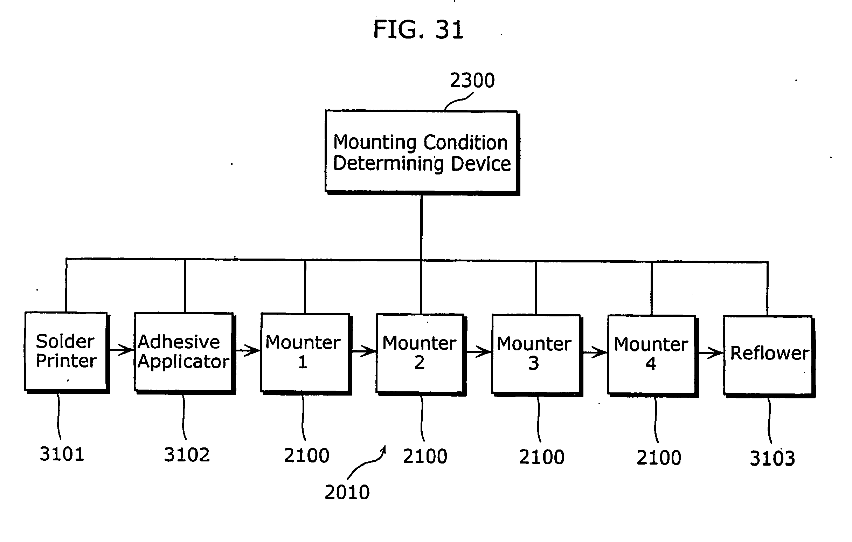

FIG. 31 is a block diagram showing a mounting line according to the third embodiment.

As shown in FIG. 31, the mounting line 2010 has: four mounters 2100; a solder printer 3101 and an adhesive applicator 3102 which are used for processing before processing of the four mounters 2100; and a reflower 3103 which is used for processing after the processing of the four mounter 2100.

The mounting condition determining device 2300 can perform not only determination of mounting conditions for each mounter 2100, but also further determination of the determined mounting conditions by examining respective mounting conditions for the four mounters 2100 together. The mounting condition determining device 2300 further has a mounting line monitor unit 3200 which watches an operations status of each equipment in the mounting line 2010.

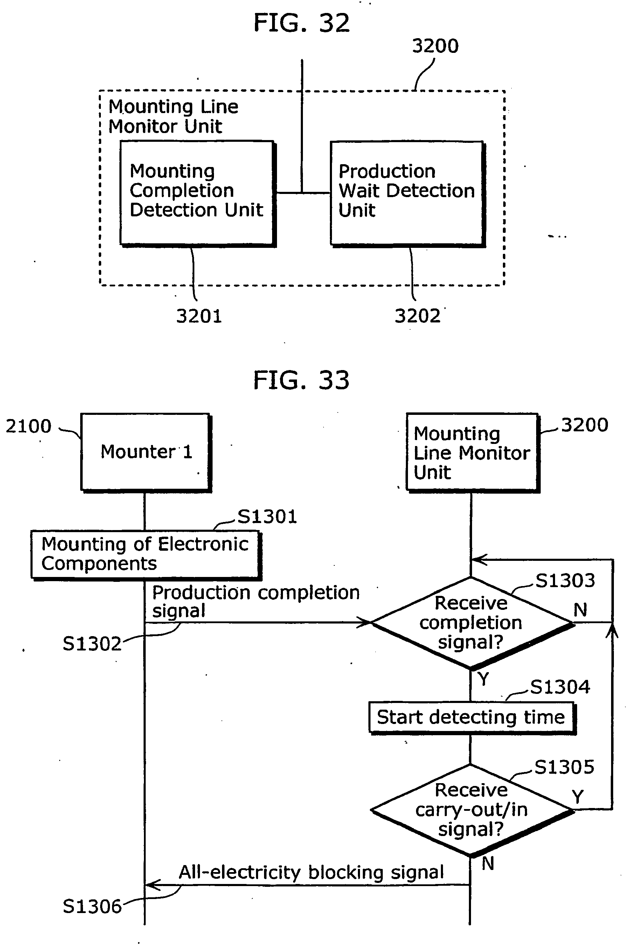

FIG. 32 is a block diagram showing a functional structure of the mounting line monitor unit 3200.

As shown in FIG. 32, the mounting line monitor unit 3200 includes a mounting completion detection unit 3201 and a production wait detection unit 3202.

The mounting completion detection unit 3201 is a processing unit which detects when all components to be mounted are mounted, in other words, when all mounters 2100 complete their mounting processing for respective boards 120.

The production wait detection unit 3202 is a processing unit which detects a production wait status in which any one of mounter 2100 produces nothing within a predetermined time period (for ten seconds, for example). More specifically, the production wait detection unit 3202 detects times when each mounter 2100 carries in and out a board, and then detects the production wait status based on the times.

Next, an electricity consumption restraint operation performed by the mounting line 2010 having the above structure is described.

FIG. 33 is a diagram showing the sequence of processing performed by the mounter 2100 and the mounting line monitor unit 3200 which is included in the mounting condition determining device 2300, when the production wait status occurs in the mounting line 2010.

Firstly, it is assumed that a piece of equipment in the mounting line 2010 (adhesive applicator 3102 for example) has some trouble, while each mounter 2100 still holds a board 120 to be produced and is performing each mounting processing. Therefore, the mounter 2100 which does not have any trouble is now mounting components on the boards 120 carried in without being affected by the above trouble (S1301).

Then, after mounting all of predetermined electronic components onto the carried board 120, the mounter 2100 sends a production completion signal to the mounting condition determining device 2300 (S1302).

The mounting completion detection unit 1201 in the mounting line monitor unit 3200 is waiting for the production completion signal (N at S1303), and if the production completion signal is received (Y at S1303), then the mounting completion detection unit 1201 starts detecting a time period from when the mounter sends the signal (S1304).

If a next signal indicating that a board is carried in or carried out (hereinafter, referred to as a carry-in signal and a carry-out signal) is not received from the mounter 2100 within ten seconds after the start of the time period detecting (N at S1305), the mounting line monitor unit 3200 sends to the mounter 2100 a signal for blocking electricity supplied to all beams in the mounter (all-electricity blocking signal) (S1306). Therefore, the carry-in signal is not received when a mounter in upstream of the mounter has some trouble and waits for starting production, while the carry-out signal is not received when a mounter in downstream of the mounter has some trouble.

In other words, the above mounters 2100 in upstream and down stream are mounters which do not send a carry-in signal nor a carry-out signal within a predetermined time period.

Accordingly, the production wait status of the mounting line 2010 is monitored, and when the production wait occurs, electricity supplied to the beams is blocked, so that it is possible to restrain electricity consumption, even if a sudden trouble or accident happens.

Note that the fifth embodiment has described that the mounting line monitor unit 3200 is equipped in the mounting condition determining device 2300, but the present invention is not limited to the above and the mounting line monitor unit 3200 may be equipped in each mounter 2100 in order to detect a production wait from a trouble occurred in uptream or downstream and to block electricity supplied to beams of the mounter.

### (Sixth Embodiment)

The following describes a mounting system according to the sixth embodiment of the present invention with reference to the drawings.

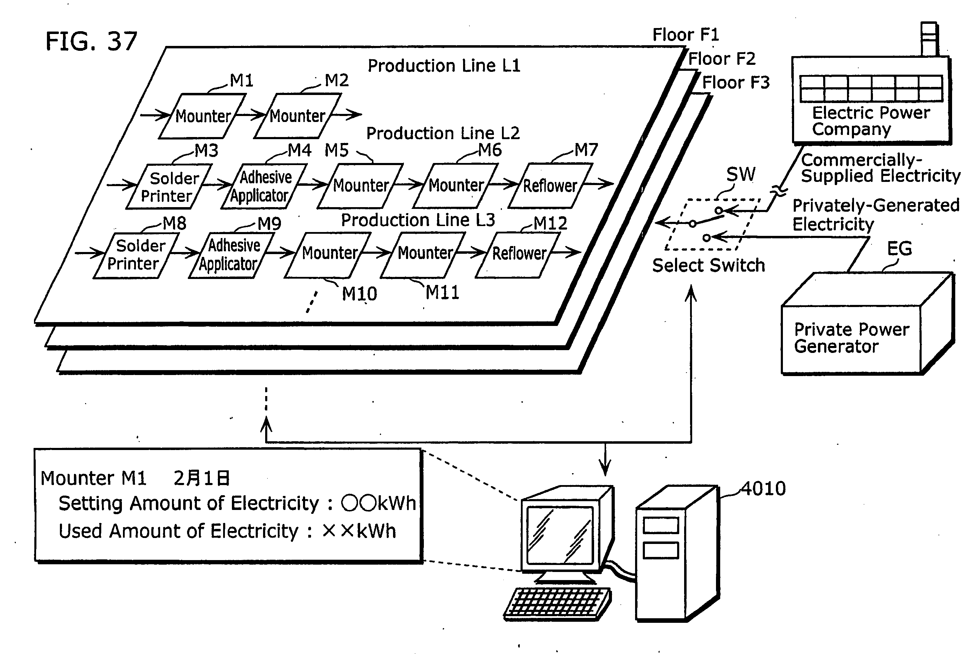

FIG. 37 is a diagram showing a whole structure of the component mounting system according to the present invention.

This component mounting system includes a plurality of production lines L1, L2, ..., an electricity monitoring apparatus 4010, a private power generator EG, and a select switch SW. Each of the production lines L1, L2, ... is arranged on each floor F1, F2, .... The electricity monitoring apparatus 4010 monitors electricity used in the production lines. The private power generator EG independently generates electricity by diesel power generation for example, and supplies the electricity to the production lines. The select switch SW switches using electricity between commercially-supplied electricity and the privately-generated electricity.

Each of the production line L1, L2, ..., has a plurality of machines each of which performs each part of processing for mounting electronic components (components) onto a circuit board (board) which is transported from upstream to downstream.

For example, the production line L1 includes two machines, mounters M1 and M2, each of which mounts various components onto a board. The production line L2 includes a solder printer M3, an adhesive applicator M4, mounters M5 and M6, and a reflower M7. Here, the solder printer M3 is a machine which prints cream solder on a board by screen printing. The adhesive applicator M4 is a machine which previously applies adhesive to the board so that the a large component or the like is mounted at a right position in a subsequent process. The mounters M5 and M6 have the same structure of the above described mounters M1 and M2. The reflower M7 is a machine which solders the components mounted on the board.

Note that, hereinafter, the "floor" refers to a group of mounting lines or machines which are arranged on the floor. Note also that the machines (including mounters), the production lines, and the floors are also referred as equipments for mounting components onto a board.

The select switch SW switches electricity to be used between commercially-supplied electricity and privately-generated electricity, for each machine, each mounting line, or each floor, under control of the electricity monitoring apparatus 4010.

The electricity monitoring apparatus 4010 obtains, from each machine, data regarding a used amount of electricity, and displays the used amount of electricity and a setting amount of electricity that is set for each machine, each mounting line, or each floor. Then, when the amount of electricity used in a machine becomes closer to the setting amount of electricity, for example, the electricity monitoring apparatus 4010 controls the select switch SW to change electricity to be supplied to the machine from the commercially-supplied electricity to the privately-generated electricity.

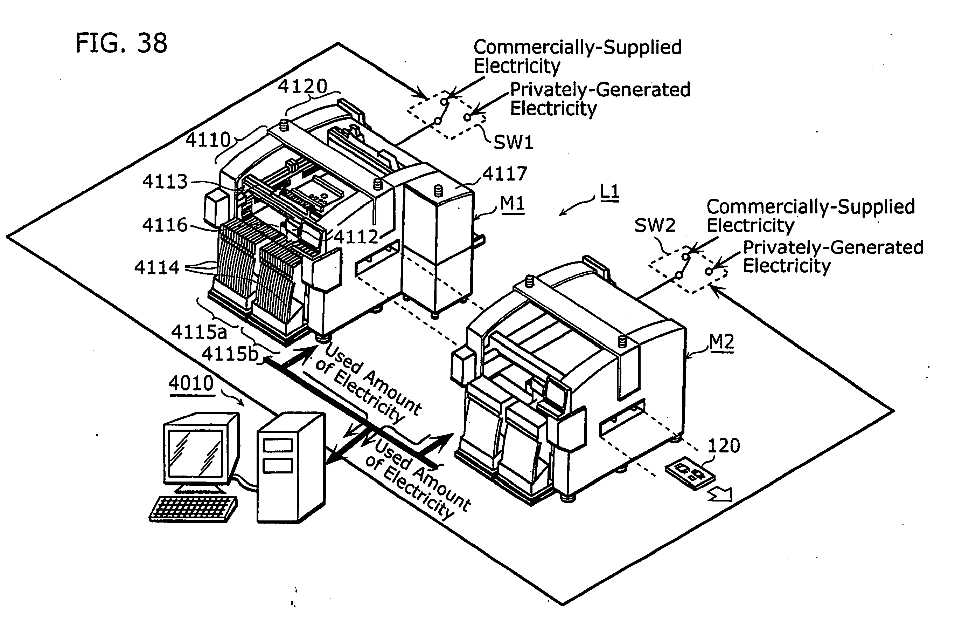

FIG. 38 is an outline perspective view showing the production line L1 and the power monitoring apparatus 4010.

The production line L1 includes the mounter M1 and M2 as described above. Note that the mounters M1 and M2 (and mounters M5 and M6) have the same structure, so that a structure of the mounter M1 is described in detail below.

The mounter M1 is equipped with two stages (a front stage 4110 and a rear stage 4120) that operate simultaneously and independently of one another. Each of these stages 4110 and 4120 is a perpendicular robotic mounting stage and includes two component supplying units 4115a and 4115b, a line gang pickup head 4112, an XY robot 4113, a component recognizing camera 4116, a tray supplying unit 4117, and the like. The component supplying units 4115a and 4115b are each made up of an array of up to 48 component feeders 4114 that store component tapes. The line gang pickup head 4112 has 10 stiction nozzles (hereafter simply "nozzles") that can pick up and stick a maximum of 10 components from the component feeders 4114 and mount them onto a board 120. The XY robot 4113 moves the line gang pickup head 4112. The component recognizing camera 4116 investigates the stiction state of the components that have been sticked by the line gang pickup head 4112 in two or three dimensions. The tray supplying unit 117 supplies trays. Each of these stages mount components on each board simultaneously and independently of one another.

Here, the "component tape" refers to a tape (a carrier tape) in which a number of the same type of components have been arranged, with such tape being supplied from a reel (a supply reel) or the like around which the tape has been wound. The component tapes are usually used to supply relatively small components called "chip components" to a mounter.

The mounter M1 is a device in mounting equipment and includes the functions of both a mounting device commonly called a high-speed mounter and a mounting device called a multi-function mounter. A high-speed mounter is a device that is capable of mounting electronic components that are 10 mm² or smaller in around 0.1 seconds, while a multi-function mounter is a device that can mount large electronic components that are 10 mm² or larger, irregularly shaped components like switches and connectors, and IC components like quad flat package (QFP) or ball grid array (BGA) components.

In short, the mounter M1 having various types of interchangeable nozzles is designed so, as to be able to mount almost all types of electronic components to be mounted from 0.4 mm by 0.2 mm chip resistors to 200 mm connectors, with a production line being formed by arranging the required number of such mounters M1 in a line.

The mounters M1 and M2 are connected to small select switches SW1 and SW2 respectively. The small select switches SW1 and SW2 are included in the above described select switches SW, and switch electricity supplied to the mounter M1 and M2 respectively between commercially-supplied electricity and privately-generated electricity. In other words, the select switch SW includes a group of the small select switches SW1, SW2, ... each or which is connected to each mounter, so that it is possible to change the type of electricity supplied to each mounter.

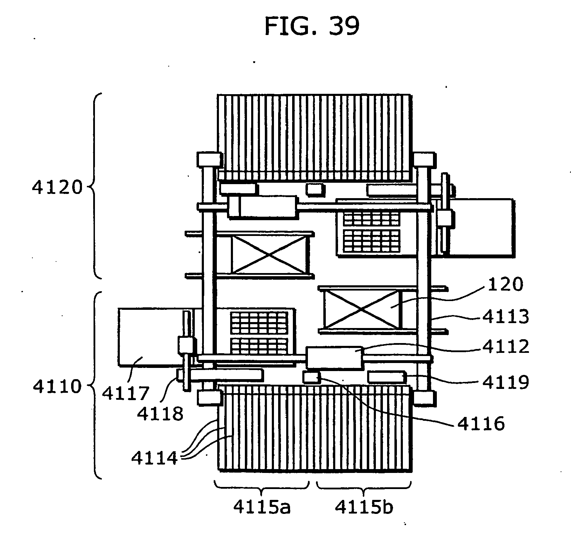

FIG. 39 is a plane view showing a main structure of the mounter M1.

A shuttle conveyor 4118 is a moving table (a component transportation conveyor) on which a component taken from the tray supplying unit 4117 is placed and moved to a predetermined position where the line gang pickup head 4112 can pick up the component from the shuttle conveyor 4118. The nozzle station 4119 is a table on which interchangeable nozzles corresponding to various sizes of components are positioned.

The component supplying units 4115a and 4115b included in each stage 4110 or 4120 are provided on the left and right sides of the component recognizing camera 4116. Therefore, the line gang pickup head 4112 picks up components from the component supplying unit 4115a or 4115b, passes by the component recognizing camera 4116 repeating an operation whereby the line gang pickup head 4112 moves to a mounting point on the board 120 and mounts one of the picked-up and sticked components. The "mounting point" refers to a coordinate point where a component is to be mounted. The component recognizing camera 4116 recognizes a component that has been picked up to the line gang pickup head 4112 when the line gang pickup head 4112 is passing by the component recognizing camera 4116.

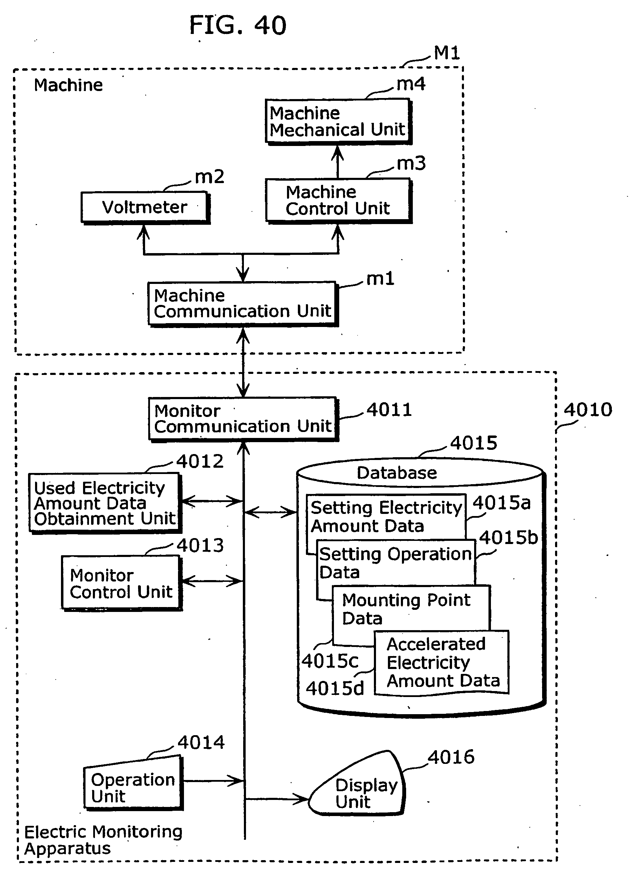

FIG. 40 is a block diagram showing a functional structure of inside of a machine and the power monitoring apparatus 4010.

FIG. 40 shows a functional structure of inside of the mounter M1 as an example of the machines that have the same structure. Hereinafter, the mounter M1 is referred to as a machine M1, and other solder printer M3 and the like are referred to as a machine M3 and the like.

The machine M1 includes a machine communication unit m1, a machine mechanical unit m4, a machine control unit m3, and a voltmeter m2. The machine communication unit m1 communicates with the electricity monitoring apparatus 4010, achieving interface. The machine mechanical unit m4 is an operation means to mechanically operate the XY robot 4113, the line gang pickup head 4112, and the like. Note that if the machine performs solder printing or the like except mounting, the machine mechanical unit m4 has mechanical features corresponding to the processing. The machine control unit m3 controls the machine mechanical unit m4 according to the communication results with the electricity monitoring apparatus 4010. The voltmeter m2 measures an amount of electricity used in the machine (used amount of electricity) according to the instructions from the electricity monitoring apparatus 4010, and then notifies the measured results to the electricity monitoring apparatus 4010 via the machine communication unit m1.

The electricity monitoring apparatus 4010 includes a monitor communication unit 4011, a used electricity amount data obtainment unit 4012, a monitor control unit 4013, a database 4015, a display unit 4016, and an operation unit 4014.

The monitor communication unit 4011 communicates with each machine, achieving interface.

The used electricity amount data obtainment unit 4012 obtains data of used amount of electricity that is measured by the voltmeter m2 of each machine, and accumulates the obtained data. Moreover, the used electricity amount data obtainment unit 4012 serves as a measuring means in conjunction with the voltmeter m2 of each machine.

The database 4015 stores setting electricity amount data 4015a, setting operation data 4015b, mounting point data 4015c, and accelerated electricity amount data 4015d. The setting electricity amount data 4015a indicates a setting amount of electricity which is set for each equipment. The setting operation data 4015b indicates how the monitor control unit 4013 controls a used amount of electricity when the used amount of electricity becomes closer to the setting amount of electricity. The mounting point data 4015c indicates a mounting point. The accelerated electricity amount data 4015d indicates amounts of electricity corresponding to acceleration patterns when the line gang pickup head 4112 moves.

The display unit 4016 is a liquid crystal display panel or the like, and displays a screen according to types of the controls of the monitor control unit 4013.

The operation unit 4014 is a setting electricity amount data obtainment means such as a keyboard, a mouse, or the like, and outputs a signal depending on the inputting of an operator, to the monitor control unit 4013.

The monitor control unit 4013 controls the display unit 4016, the database 4015, and the used electricity amount data obtainment unit 4012, based on the output signal from the operation unit 4014, and also controls the machine and the select switch SW.

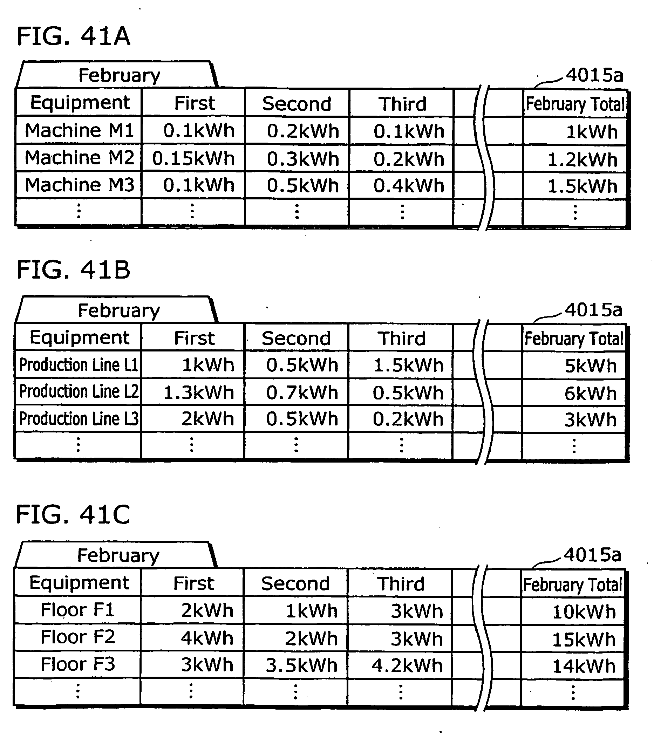

FIG. 41 is tables showing detail of the setting electricity data.

The setting electricity amount data 4015a indicates setting amounts of electricity for respective machines, respective production lines, or the like, as shown in (a) to (c) of FIG. 41. The setting amounts of electricity are assumed to be set daily or monthly, for example.

More specifically, as shown in (a) of FIG. 41, the setting electricity amount data 4015a indicates a setting amount of electricity on the first of February, a setting amount of electricity on the second of February, a setting amount of electricity in February, and the like, for each machine M1, M2, ...., for example. Further, as shown in (b) of FIG. 41, the setting electricity amount data 4015a indicates a setting amount of electricity on the first of February, a setting amount of electricity on the second of February, a setting amount of electricity in February, and the like, for each production line L1, L2, ...., for example. Still further, as shown in (c) of FIG. 41, the setting electricity amount data 4015a indicates a setting amount of electricity on the first of February, a setting amount of electricity on the second of February, a setting amount of electricity in February, and the like, for each floor F1, F2, ...., for example.

Such setting electricity amount data 4015a is generated by the monitor control unit 4013 based on the inputting by the operation unit 4014, and stored (registered) into the database 4015.

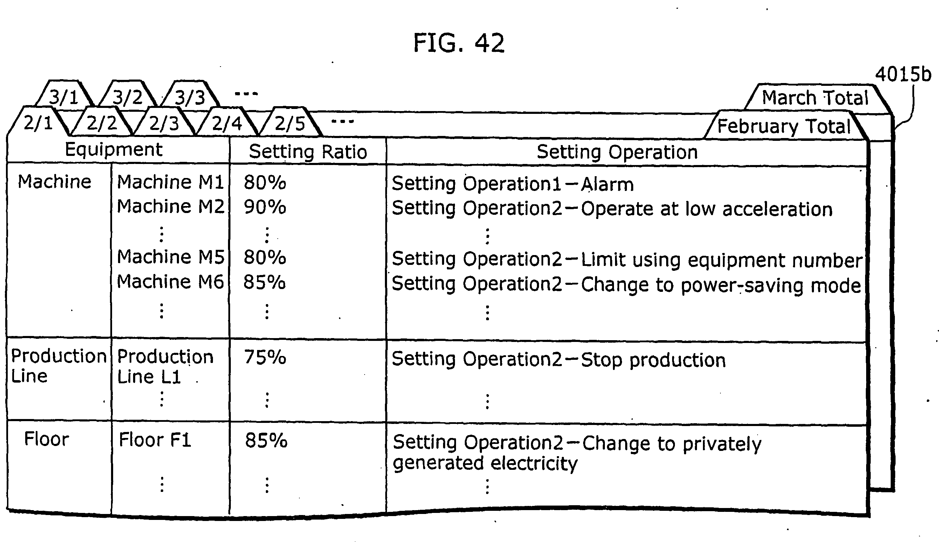

FIG. 42 is tables showing detail of the setting operation data 4015b.

The setting operation data 4015b indicates, daily and monthly, a ratio (reference ratio) of a used amount of electricity to the a setting amount of electricity regarding each equipment, and an operation (setting operation) to be performed by the equipment when an amount of electricity used in the equipment reaches the reference ratio.

For example, the setting operation data 4015b indicates that an alarm should be displayed when an amount of electricity used in the machine 1 reaches 80% of the setting amount of electricity on the first of February. The setting operation data 4015b further indicates that the production should be stopped when an amount of electricity used in the production line L1 reaches a reference ratio 75% of the used amount to the setting amount of electricity, and still further indicates that electricity to be used should be changed to privately-generated electricity when an amount of electricity used in the floor F1 reaches a reference ratio 85% of the used amount to the setting amount of electricity.

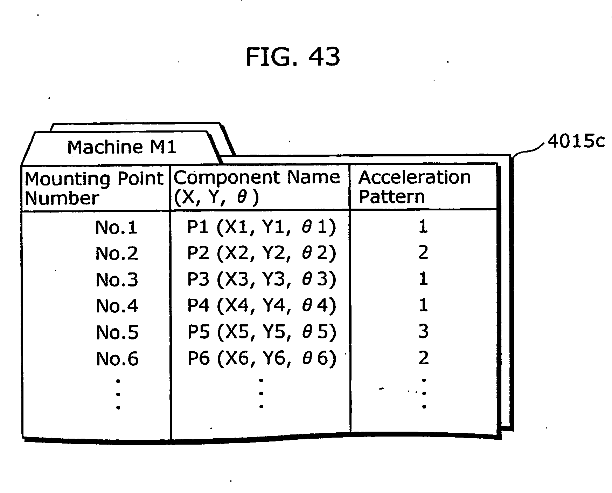

FIG. 43 is a table showing detail of the mounting point data 4015c.

For each mounter, the mounting point data 4015c indicates: a mounting point number assigned to each mounting point; a component name of a component to be mounted on a mounting point corresponding to the mounting point number; mounting coordinates (X coordinates and Y coordinates) and a mounting angle (θ) of the mounting point where the component is to be mounted; and an acceleration pattern of the line gang pickup head 4112 mounting a component on the mounting point.

For example, the mounting point data 4015c indicates that on a mounting point "No. 1" with mounting coordinates (X, Y) and a mounting angle (θ1), a component "P1" should be mounted at an "acceleration pattern 1".

The above mounting point data 4015c is sent to the machine as a mounter by the monitor control unit 4013, and then the mounter moves the line gang pickup head 4112 according to the mounting point data 4015c in order to mount a component on each mounting point.

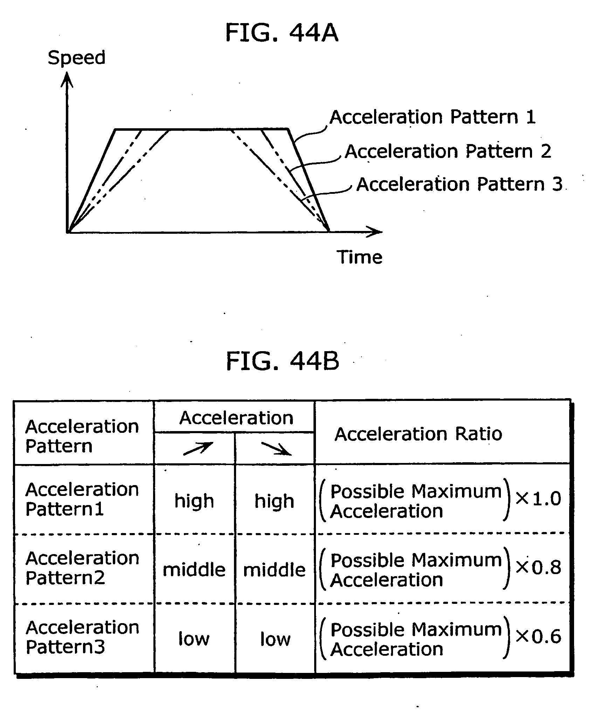

FIG. 44A and 44B are a graph and a table, respectively, explaining the acceleration patterns.

The acceleration pattern shows changes of an acceleration from when the line gang pickup head 4112 starts moving until when the line gang pickup head 4112 stops. The acceleration patterns are an acceleration pattern 1, an acceleration pattern 2, and an acceleration pattern 3.

In the acceleration pattern 1, an acceleration when the line gang pickup head 4112 starts and stops is equal to a possible maximum acceleration. In the acceleration pattern 2, an acceleration when the line gang pickup head 4112 starts and stops is 0.8 times as much as the possible maximum acceleration. In the acceleration pattern 3, an acceleration when the line gang pickup head 4112 starts and stops is 0.6 times as much as the possible maximum acceleration. This means that the acceleration is getting lower firstly from the acceleration pattern 1, the acceleration pattern 2, the acceleration pattern 3, sequentially.

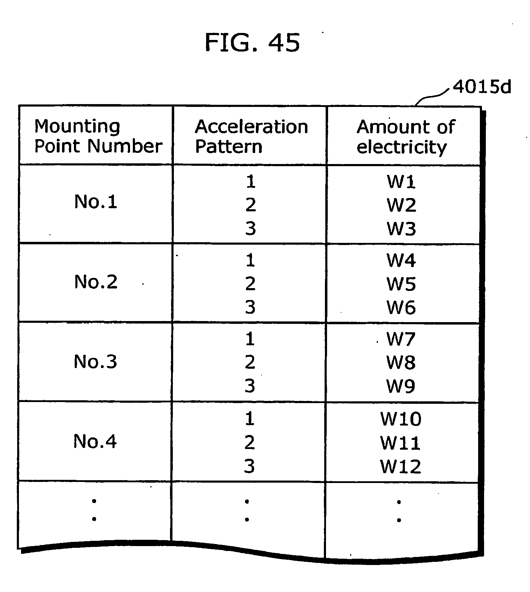

FIG. 45 is a table showing detail of the accelerated electricity amount data 4015d.

The accelerated electricity amount data 4015d indicates: the mounting point number assigned to each mounting point; a acceleration pattern necessary to move the line gang pickup head 4112 to a mounting point of the mounting point number; and an amount of electricity required to move the line gang pickup head 4112 at the acceleration pattern.

For example, the accelerated electricity amount data 4015d indicates that the line gang pickup head 4112 can move to the mounting point "No. 1" at any of acceleration patterns "1" to "3", and further indicates that the "acceleration pattern 1" requires an amount of electricity "W1", the "acceleration pattern 2" requires an amount of electricity "W2", and the "acceleration pattern 3" requires an amount of electricity "W3".

Here, an operation performed by the monitor control unit 4013 is described in detail.

The monitor control unit 4013 makes the display unit 16 display a setting operation screen on which the setting operation data 4015b is edited, according to instructions from the operation unit 4014.

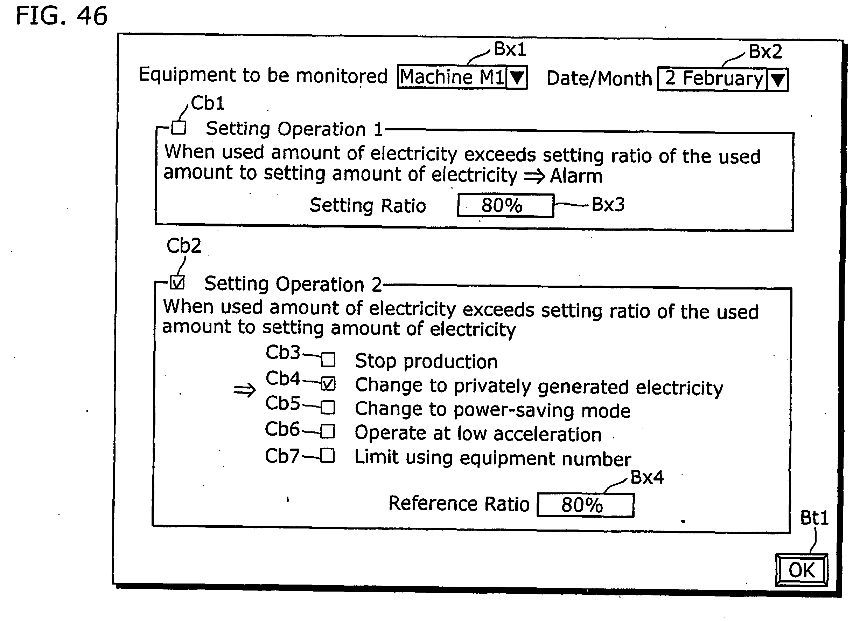

FIG. 46 is a diagram showing an example of the setting operation screen.

The setting operation screen displays: a box Bx1 for inputting a name of an equipment; a box Bx2 for inputting date and month or only a month; a setting operation 1 field; a setting operation 2 field; and a button Bt1.

The setting operation 1 field displays: a check box Cb1 for selecting a setting operation 1; and a box Bx3 where a reference ratio (percentage) of the used amount to the setting amount of electricity is inputted.

Here, the setting operation 1 is an operation for making the display unit 16 display an alarm to notify a fact that a used amount of electricity becomes closer to the setting amount of electricity, when the used amount reaches the reference ratio in the box Bx3.

The setting operation 2 field displays: a check box Cb2 for selecting a setting operation 2; a box Bx4 where a reference ratio (percentage) of the used amount to the setting amount of electricity is inputted; a check box Cb3 for selecting an operation "Stop Production"; a check box Cb4 for selecting an operation "Change to privately-generated electricity"; a check box Cb5 for selecting an operation "Change to power-saving mode"; a check box Cb6 for selecting an operation "Low acceleration operation"; and a check box Cb7 for selecting an operation "Limit using equipment number".

Here, the setting operation 2 is operations displayed next to the check boxes Cb3 to Cb7, such as the operation "Change to privately-generated electricity", each of which is performed when a used amount of electricity reaches the reference ratio in the box Bx4.

For example, by the instructions from the operator using the operation unit 4014, "Machine M1" is inputted into the box Bx1 and "2 February" is inputted into the box Bx2. Then, the check boxs Cb2 and Cb4 are selected and a reference ratio "80%" is inputted into the box Bx4. When the button Bt1 is pressed under the above status, the monitor control unit 4013 registers, to the setting operation data 4015b in the database 4015, data indicating that electricity supplied to the machine M1 on the second of February is changed to privately-generated electricity if a used amount of electricity reaches 80% of the setting amount of electricity.

Thus, the monitor control unit 4013 registers the setting operation and the reference ratio of each equipment according to the instructions from the operation unit 4014, so that the setting operation data 4015b can be edited.

Furthermore, when a machine starts operations using electricity, the monitor control unit 4013 makes, via the monitor communication unit 4011, the voltmeter m2 of the machine measure a used amount of electricity. Then, the monitor control unit 4013 makes the voltmeter m2 notify the electricity monitoring apparatus 4010 of the measured amount of used electricity. The used electricity amount data obtainment unit 4012 obtains the data of used amount of electricity notified from the voltmeter m2, and accumulates such data.

Next, the monitor control unit 4013 makes the display unit 16 display an electricity amount display screen on which the setting amount of electricity and the used amount of electricity are shown, by referring to the used amounts of electricity accumulated in the used electricity amount data obtainment unit 4012 and the setting electricity amount data 4015a stored in the database 4015.

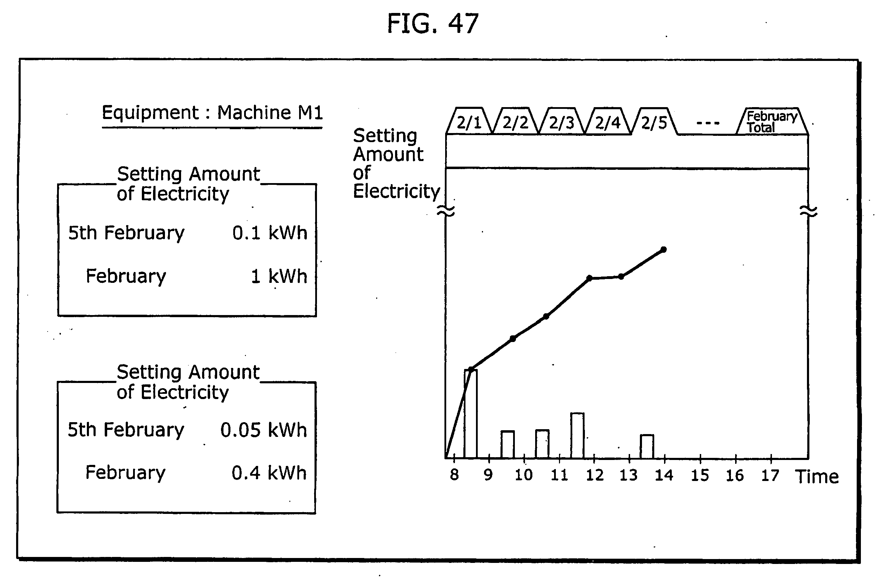

FIG. 47 is a diagram showing an example of the electricity amount display screen.

The electricity amount display screen displays an equipment which is monitored, a setting amount of electricity, a used amount of electricity, and a graph showing changes of the used amount. Here, the setting amount of electricity is displayed as a setting amount of electricity of a present date and a setting amount of electricity of a present month. In the same manner, the used amount is displayed as an amount of electricity used on the present date and an amount of electricity used in the present month.

For example, a setting amount of electricity on the fifth of February "0.1 kWh" and a setting amount of electricity in February "1 kWh" regarding an equipment "machine M1", and an amount of electricity used on the fifth of February "0.05 kWh" and an amount of electricity used in February "0.4 kWh" regarding the equipment "machine M1" are displayed. Furthermore, amounts of electricity used at respective times on the fifth of February regarding the equipment "machine M1" are indicated using a bar graph, and changes of the accumulated amounts of electricity used until the present time are indicated using a line graph. Note that the monitor control unit 4013 can display as a graph the changes of the amounts of electricity used not only on the present date as shown in FIG. 47, but also in the present month.

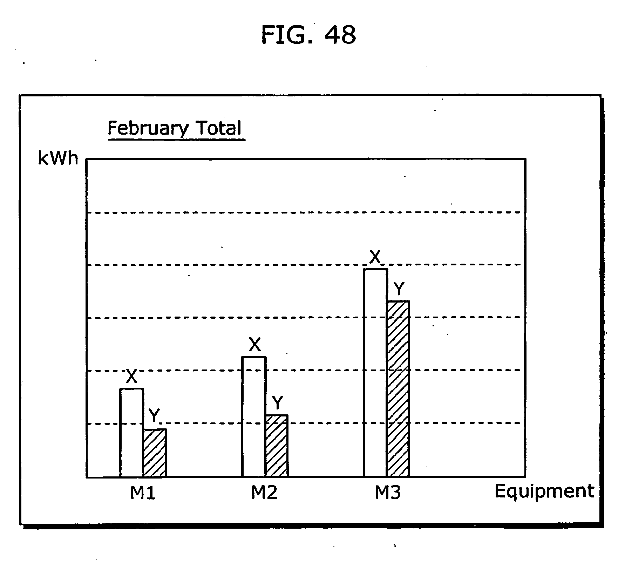

FIG. 48 shows another example of the electricity amount display screen.

The electricity amount display screen displays setting amounts of electricity (X) and used amounts of electricity (Y) in the present month, using a bar graph. It is possible to switch the screen to be displayed between the electricity amount display screens shown in FIGS. 47 and 48, according to instructions from the operation unit 4014. Moreover, the monitor control unit 4013 can makes the display unit 4016 display, as a graph, the used amounts of electricity in each equipment used not only in the present month as shown in FIG. 48, but also in the present date and the like, according to instructions from the operation unit 4014.

Here, if each amount of electricity used in each equipment is changing, the monitor control unit 4013 examines whether or not the amount reaches a reference ratio stored in the setting operation data 4015b. If the used amount of electricity reaches the reference ratio, the monitor control unit 4013 makes the equipment execute a setting operation indicated in the setting operation data 4015b.

For example, the monitor control unit 4013 provides an alarm as the setting operation. That is, the setting operation data 4015b indicates that a setting operation "Setting operation 1 - Alarm" should be performed when an amount of electricity used in the equipment "machine M1" reaches a reference ratio "80%". In this case, when the used amount reaches 70% of the setting amount of electricity, the monitor control unit 4013 makes the display unit 4016 display a preliminary alarm, and when the used amount reaches a reference ratio (80% of the setting amount of electricity), the monitor control unit 4013 makes the display unit 4016 display an alarm to notify that the used amount becomes closer to the setting amount of electricity.

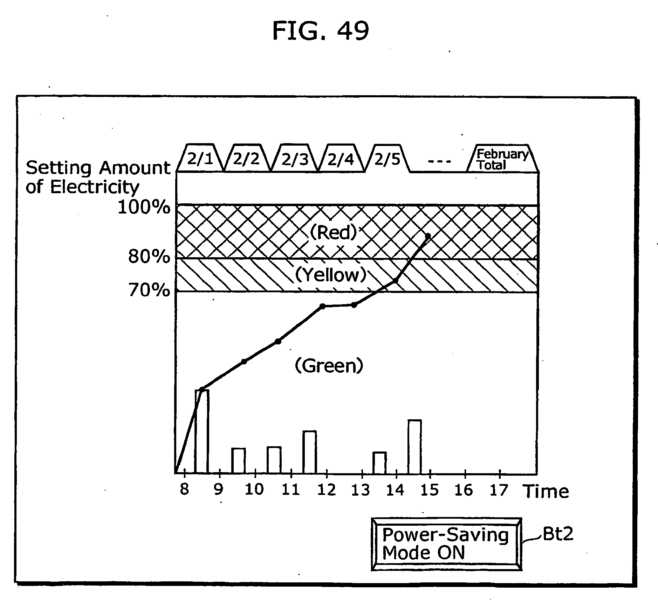

FIG. 49 is a diagram showing an example of a screen displaying the preliminary alarm and the alarm.

As shown in FIG. 49, the monitor control unit 4013 shows a range from 70% to 80% in a graph as an yellow area when a used amount of electricity reaches 70% of a setting amount of electricity, thereby displaying the preliminary alarm. Furthermore, the monitor control unit 4013 shows a range from 80% to 100% in the graph as a red area when the used amount reaches 80% of the setting amount of electricity, thereby displaying the alarm. Note that a range from 0% to 70% in the graph is shown as a green area.

When the preliminary alarm or the alarm is displayed by the display unit 4016, the monitor control unit 4013 makes the display unit 4016 display a mode selection switch Bt2 which is used to change processing performed by the equipment to processing with a power-saving mode.

When the mode select switch Bt2 is pressed according to instructions from the operator using the operation unit 4014, the monitor control unit 4013 makes the equipment performs processing with the power-saving mode.

When the equipment for which the power-saving mode is selected is the machine M1 as a mounter, the machine M1 moves the line gang pickup head 4112 so that an acceleration pattern for each mounting point indicated in the mounting point data 4015c is uniformly lowered by one level. Thereby an amount of electricity used in the machine M1 can be restrained.

Moreover, the monitor control unit 4013 makes the equipment operate at a low acceleration as the setting operation. This means that the setting operation data 4015b indicates that, when an amount of electricity used in the equipment "machine M2" reaches a reference ratio "90%", a setting operation "Setting operation 2 - Operate at low acceleration" should be executed. In this case, from when the used amount reaches a reference ratio (90% of the setting amount of electricity), the monitor control unit 4013 makes the equipment operate at a low acceleration.

When the equipment operating at a low acceleration is the machine M1 as a mounter, the monitor control unit 4013 changes an acceleration pattern in the mounting point data 4015c regarding the machine M1, by referring to the accelerated electricity amount data 4015d.

More specifically, the monitor control unit 4013 selects from the acceleration patterns for every mounting points indicated in the mounting point data 4015c for an acceleration pattern by which a power saving effect would be increased more than a predetermined value, and then changes only the selected acceleration pattern. In other words, the monitor control unit 4013 changes only an acceleration pattern by which an amount of electricity can be reduced more than the predetermined amount by lowering a level of the acceleration pattern. ,

For example, according to consideration of the monitor control unit 4013 based on the accelerated electricity amount data 4015d in FIG. 45, when the mounting point data 4015c indicates that an acceleration pattern of a mounting point "No. 1" is the "acceleration pattern 1", amounts of electricity "W1 to W2" can be reduced by lowering the "acceleration pattern 1" to the "acceleration pattern 2", and amounts of electricity. "W1 to W3" can be reduced by lowering the "acceleration pattern 1" to the "acceleration pattern 3". Then, the monitor control unit 4013 considers that, when one of the amounts of electricity "W1 to W2" and "W1 to W3" is greater than a predetermined value, the "acceleration pattern 1" of the mounting point "No. 1" is the acceleration pattern to be changed. Furthermore, the monitor control unit 4013 considers that, when the amount of electricity "W1 to W2" is greater than the predetermined value, the "acceleration pattern 1" should be lowered to the "acceleration pattern 2", and that, when the amount of electricity "W1 to W3" is greater than the predetermined value, the "acceleration pattern 1" should be lowered to the "acceleration pattern 3".

The monitor control unit 4013 performs the above consideration for acceleration patterns for each mounting point indicated in the mounting point data 4015c, and changes the acceleration data in the mounting point data 4015c.

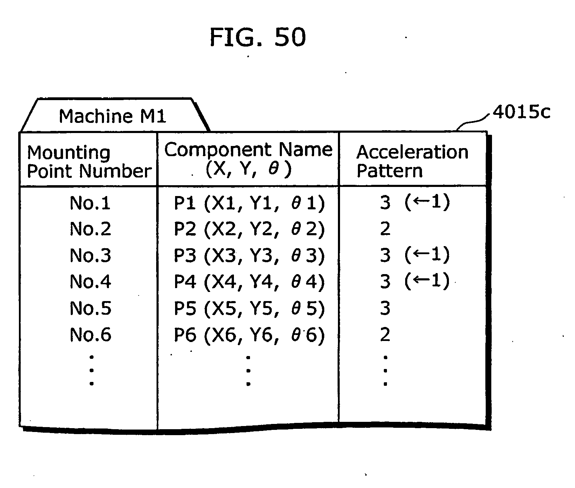

FIG. 50 is a table showing the mounting point data that is changed by the monitor control unit 4013.

As shown in FIG. 50, in the mounting point data 4015c, acceleration patterns corresponding to mounting points "No. 1", "No. 3", and "No. 4" are changed from the "acceleration pattern 1" to "acceleration pattern 3", for example.

The monitor control unit 4013 sends the changed mounting point data 4015c to the machine M1 via the monitor communication unit 4011, and makes the machine M1 perform mounting processing based on the changed mounting point data 4015c. Thereby the machine M1 moves a line gang pickup head at an acceleration lower than the usual acceleration in order to mount components on some mounting points. Thus it is possible to restrain an amount of electricity used in the machine M1.

Furthermore, the monitor control unit 4013 makes the equipment limit the number of equipments used in the equipment, according to a setting operation. More specifically, for example, the setting operation data 4015b indicates that the setting operation "Setting operation 2 - Limit using equipment number" should be executed, when an amount of electricity used in the equipment "machine M5" reaches a reference ratio "80%". In this case, the monitor control unit 4013 makes the machine M5 limit the number of devices used in the machine M5 from when the used amount of electricity reaches the reference ratio (80% of setting amount of electricity)

In the above case, the monitor control unit 4013 stops an operation of a rear stage 4120 in the machine M5, for example.

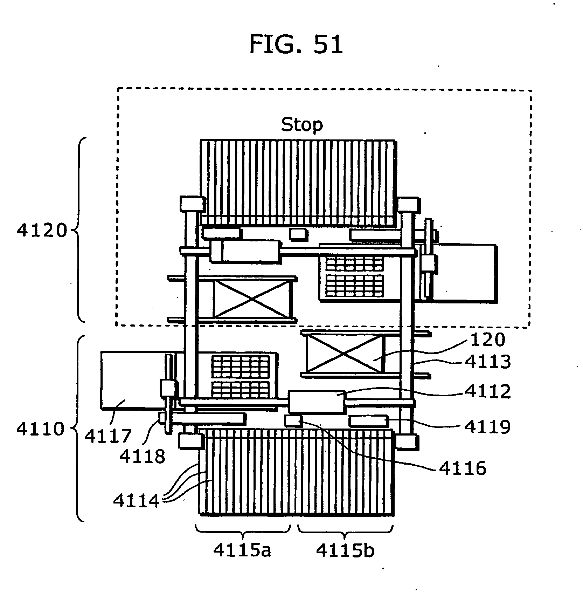

FIG. 51 is a diagram showing the stopped rear stage 4120.

As shown in FIG. 51, in the machine M5, the rear stage 4120 is stopped and only the front stage 4110 continues mounting processing. Moreover, in a case where the monitored equipment is a production line, the monitor control unit 4013 stops some machine, while when the monitored equipment is a floor, the monitor control unit 4013 stops some production line or machine. Thereby it is possible to restrain an amount of electricity used in an equipment that is monitored.

Furthermore, the monitor control unit 4013 executes a change of supplied electricity to privately-generated electricity as a setting operation. More specifically, for example, the setting operation data 4015b indicates that a setting operation "Setting operation 2 - Change to privately-generated electricity" is executed, when an amount of electricity used in an equipment "floor F1" reaches a reference ratio "85%". In this case, from when the used amount reaches the reference ratio (85% of setting amount of electricity), the monitor control unit 4013 controls small select switches connected to all machines in each production line on the floor F1 in order to change electricity supplied to all machines on the floor F1 from commercially-supplied electricity to privately-generated electricity. Thereby it is possible to restrain the amount of commercially-supplied electricity used in the floor F1.

Still further, the monitor control unit 4013 makes an equipment stop production processing, according to a setting operation. More specifically, for example, the setting operation data 4015b indicates that a setting operation "Setting operation 2 - Stop operation" is executed, when an amount of electricity used in an equipment "production line L1" reaches a reference ratio "75%". In this case, from when the used amount reaches the reference ratio (75% of setting amount of electricity), the monitor control unit 4013 stops production processing performed by all machines in the production line L1. Thereby it is possible to restrain an amount of electricity used in the production line L1.

Still further, the monitor control unit 4013 makes an equipment perform production processing with an energy saving mode, according to a setting operation. More specifically, for example, the setting operation data 4015b indicates that a setting operation "Setting operation 2 - Change to energy saving mode" is executed, when an amount of electricity used in an equipment "machine M6" reaches a reference ratio "85%". In this case, from when the used amount reaches the reference ratio (85% of setting amount of electricity), the monitor control unit 4013 makes the equipment perform production processing with the energy saving mode. Thereby it is possible to restrain the amount of electricity used in the machine M6.

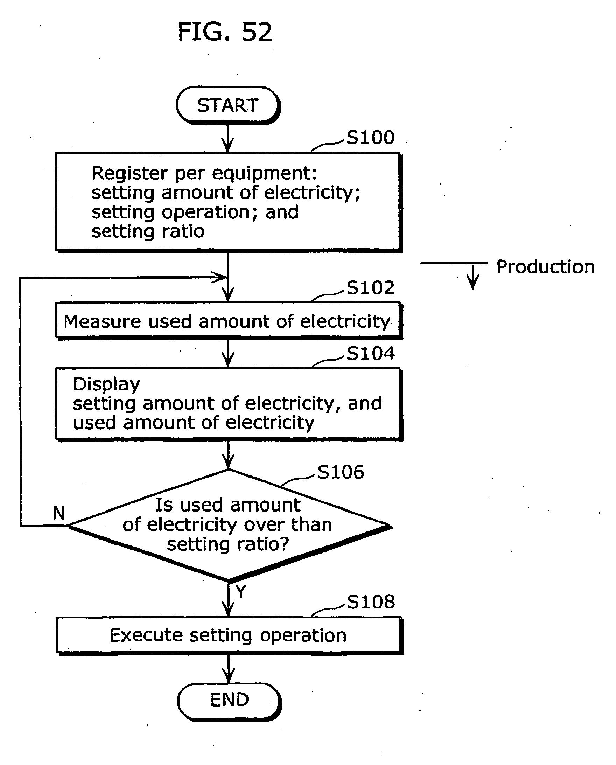

FIG. 52 is a flowchart showing an operation performed by the power monitoring apparatus 4010.

Firstly, the electricity monitoring apparatus 4010 resistors a setting amount of electricity, a setting operation, and a reference ratio, regarding each equipment, according to inputting of an operator using the operation unit 4014 (Step S100). Next, when each equipment start production processing, the electricity monitoring apparatus 4010 makes each equipment measure an amount of electricity used in the equipment and also notify the electricity monitoring apparatus 4010 of the measured result (Step S102). Thus, the electricity monitoring apparatus 4010 obtains, from the equipment, data of the amount electricity used in the equipment. Then, the electricity monitoring apparatus 4010 displays the obtained data of setting amount of electricity and used amount of electricity, as numerical values, a chart, a graph, and the like (Step S104).

Here, the electricity monitoring apparatus 4010 determines whether or not the amount of electricity used in each equipment exceeds a reference ratio of the used amount to the setting amount of electricity (Step S106). If the determination is made that the used amount does not exceed the reference ratio (N at Step S106), then the electricity monitoring apparatus 4010 repeats the operation from Step S102 to S106. On the other hand, if the determination is made that the used amount exceeds the reference ratio (Y at Step S106), then the electricity monitoring apparatus 4010 executes the setting operation registered at step S100 (for example, "Change to privately-generated electricity" or the like) (Step S108).

Thus, in the sixth embodiment, both of the setting amount of electricity and the used amount of electricity are displayed, so that the operator can easily learn from the display a ratio of the used amount to the setting amount of electricity. As a result, if the used amount becomes closer to the setting amount, the operator stops production processing performed by the equipment, thereby preventing the used amount from exceeding the setting amount, which makes it possible to restrain the amount of electricity used in the equipment. For example, even if a heavy penalty is imposed for electricity use more than an available amount that is defined for each plant from a political viewpoint, the registration of the available amount as the setting amount results in easy prevention of the penalty.

Furthermore, in a case where the reference ratio is set to 80% and an alarm is provided when the used amount of electricity reaches 80% of the setting amount of electricity, so that the operator of the equipment can easily learn that the used amount becomes closer to the setting amount.

Still further, if the setting operation "Stop production" is registered, when the used amount of electricity reaches a reference ratio, production processing is stopped, so that it is possible to prevent the used amount from exceeding the setting amount of electricity. Therefore, it is possible to stop equipments having a low energy saving effect and to keep operating only equipments having a high energy saving effect.

### (First Variation)

The following describes the first variation of the sixth embodiment in which the method of displaying a used amount of electricity is changed.

In the sixth embodiment, the used amount of electricity is displayed using a unit of "kWh". In the first variation of the sixth embodiment, however, the used amount of electricity is converted to an electricity fee per one produced board to be displayed. For example, when the electricity rate is set simply in proportion to a used amount of electricity, the display conversion from the used electricity amount to the electricity fee is not useful nor effective, but when the electricity rate is not set in proportion to the used amount, such display conversion is quite useful and effective.

In general, electricity rates are sometimes not set in proportion to the used amount of electricity, but set to be increased gradually per unit amount of electricity depending on a used amount of electricity.

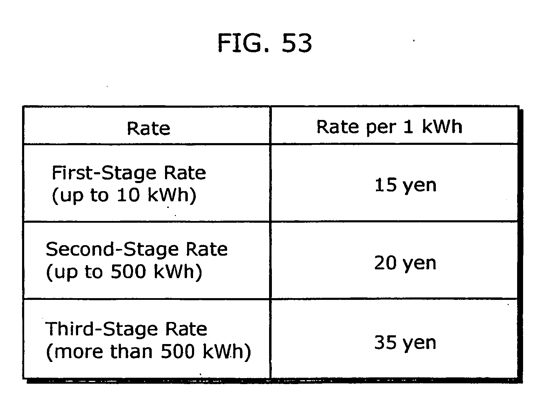

FIG. 53 is a diagram explaining an example of the electricity rates that are set to be increased gradually.

For example, as shown in FIG. 53, an electricity rate per unit used electricity amount 1 kWh is set to: 15 yen when a used amount of electricity ranges from 0 kWh to 10 kWh; 20 yen when a used amount of electricity ranges from 10 kWh to 500 kWh; and 35 yen when a used amount of electricity is more than 500 kWh. Therefore, the monitor control unit 4013 in the electricity monitoring apparatus 4010 according to the first variation of the sixth embodiment obtains the electricity rate table as shown in FIG. 53, and makes the display unit 4016 display an electricity fee per one produced board.

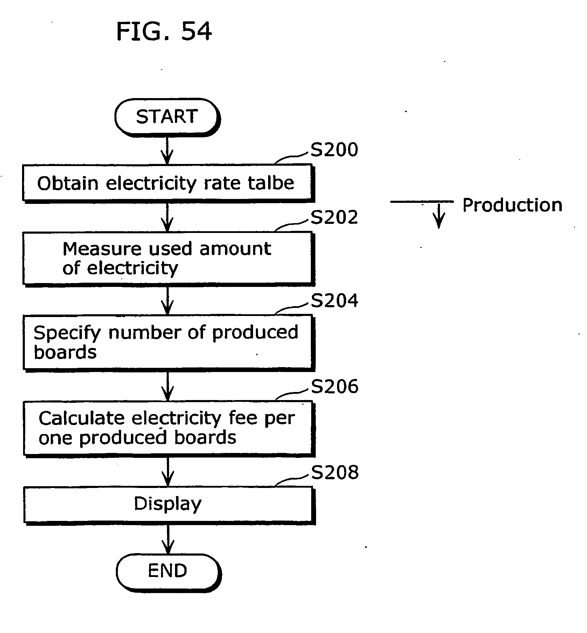

FIG. 54 is a flowchart showing an operation performed by the monitor control unit 4013 according to the first variation of the sixth embodiment.

Firstly, the monitor control unit 4013 obtains an electricity rate table as shown in FIG. 53 according to inputting of an operator using the operation unit 4014 (Step S200). Next, when each equipment starts production processing, the monitor control unit 4013 makes each equipment measure each amount of electricity used in the equipment and notify the monitor control unit 4013 of the measured result (Step S202). The monitor control unit 4013 makes the equipment further notify the monitor control unit 4013 of the number of boards produced by the equipment, and then specifies the data of the number (Step S204).

By referring to the electricity rate table obtained at step S200, the monitor control unit 4013 specifies which stage electricity rate, namely the first stage rate, the second stage rate, or the third stage rate, is to be applied to the currently used amount of electricity. Then, the monitor control unit 4013 estimates, from results of steps S202 and s204, a used amount of electricity and the number of produced boards which occur after the above specified stage rate is applied. For example, if the currently applied electricity rate is the second stage rate, the monitor control unit 4013 estimates a used amount of electricity and the number of produced boards which occur after an used amount of electricity becomes more than 10 kWh. Then, the monitor control unit 4013 uses an equation that is (current electricity rate per unit electricity amount) x (used amount electricity) / (number of produced boards) in order to calculate the current electricity fee per one produced board (Step S206). Then, the monitor control unit 4013 makes the display unit 4016 display the calculated electricity fee (Step S208).

Thus, in the first variation of the sixth embodiment, the electricity fee per one produced boards is displayed, so that an operator of the equipment can easily learn from the display whether or not continuing of the producing results in gain of a profit, even if electricity rates per unit electricity amount are set to be increased gradually depending on a used amount of electricity.

### (Second Variation)

The following describes the second variation of the sixth embodiment in which the timing of executing the setting operation "Change to privately-generated electricity" is changed.

In the sixth embodiment, the setting operation "Change to privately-generated electricity" is executed when a used amount of electricity reaches a reference ratio of the used amount to a setting amount of electricity. In the second variation of the sixth embodiment, the "Change to privately-generated electricity" is executed when an electricity rate per unit amount of commercially-supplied electricity becomes expensive more than an electricity cost per unit amount of privately-generated electricity. Therefore, the second variation of the sixth embodiment is also useful and effective when electricity rates per unit amount of commercially-supplied electricity are set to be increased gradually depending on a used amount of the electricity, as shown in FIG. 53.

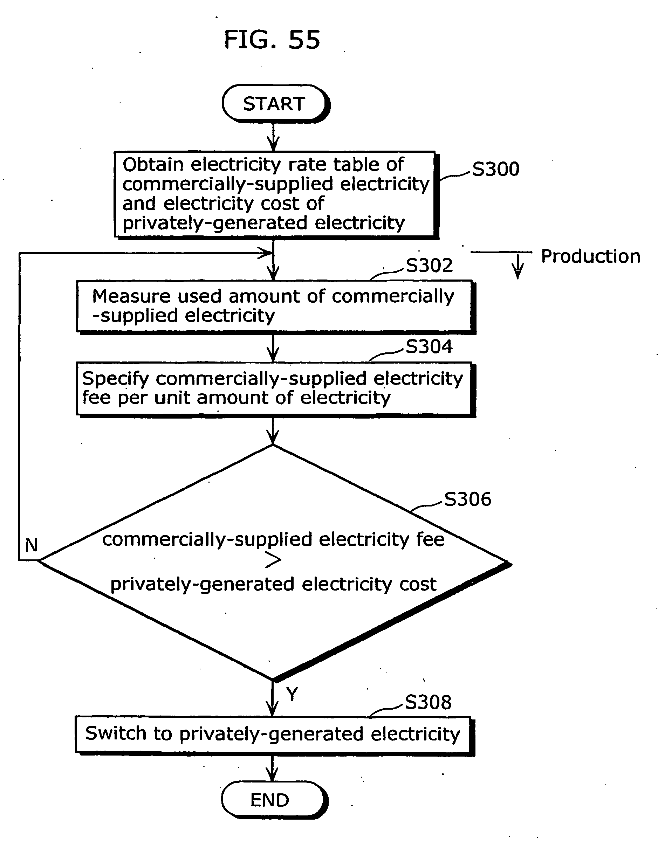

FIG. 55 is a flowchart showing an operation performed by the monitor control unit 4013 according to the second variation of the sixth embodiment.

Firstly, the monitor control unit 4013 obtains an commercially-supplied electricity rate table as shown in FIG. 53 and an electricity cost per unit amount of privately-generated electricity (privately-generated electricity cost), according to inputting of an operator using the operation unit 4014 (Step S300). Next, when each equipment starts production processing, the monitor control unit 4013 makes the equipment measure an amount of commercially-supplied electricity used in the equipment and notify the monitor control unit 4013 of the measured result (Step S302). The monitor control unit 4013 specifies an electricity rate per unit amount of currently used commercially-supplied electricity (commercially-supplied electricity rate), from a used amount of commercially-supplied electricity, by referring to the electricity rate table obtained at step S300 (Step S304).

The monitor control unit 4013 compares the commercially-supplied electricity rate with the privately-generated electricity cost, and examines whether or not the commercially-supplied electricity rate is expensive more than the privately-generated electricity cost (Step S306). Here, if the commercially-supplied electricity rate is expensive more than the privately-generated electricity cost (Y at Step S306), then the monitor control unit 4013 controls the select switch SW to change electricity supplied to the equipment from the commercially-supplied electricity to the privately-generated electricity (Step S308). On the other hand, if the commercially-supplied electricity rate is not more expensive than the privately-generated electricity cost (N at Step S306), then the monitor control unit 4013 repeats the operation from step S302 to step S306.

Thus, in the second variation of the sixth embodiment, even if an electricity rate per unit amount of commercially-supplied electricity is set to be increased gradually depending on a used amount of electricity, the setting operation "Change to privately-generated electricity" is executed when the electricity rate per unit amount of commercially-supplied electricity becomes expensive more than an electricity cost per unit amount of privately-generated electricity, which enables the equipment to continue production processing using inexpensive electricity.

### (Third Variation)

The following describes the third variation of the sixth embodiment in which the timing of executing the setting operation "Stop production" is changed.

In the sixth embodiment, the setting operation "Stop production" is executed when a used amount of electricity reaches a reference ratio of the used amount to a setting amount of electricity. In the third variation of the sixth embodiment, the setting operation "Stop production" is executed when an increased money amount of the electricity fee per one produced board reaches a predetermined money amount of a profit (expected profit). Therefore, in a case where electricity rates per unit electricity amount are set to be increased gradually depending on a used amount of the electricity as shown in FIG. 17, the increased cost due to the electricity rate increase sometimes results in no profit, though the profit has previously been expected to be gained in a case of the first stage rate. In such a case, the third variation of the sixth embodiment is useful and effective.

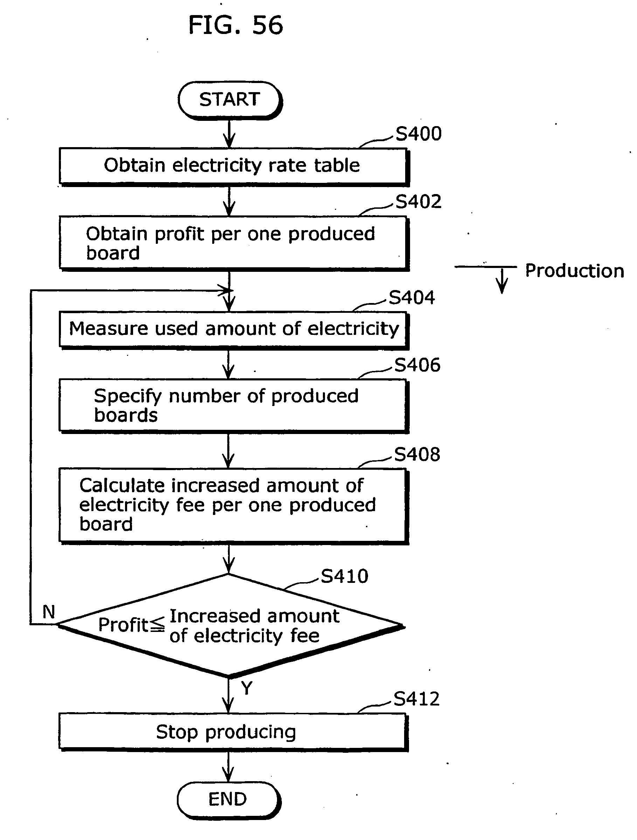

FIG. 56 is a flowchart showing an operation performed by the monitor control unit 4013 according to the third variation of the sixth embodiment.

Firstly, the monitor control unit 4013 obtains an electricity rate table as shown in FIG. 53 and also data of a profit per one produced board, according to inputting of an operator using the operation unit 4014 (Step S400). Here, the profit refers to the expected profit that has been predetermined. One example of such expected profit is a value calculated by subtracting a sale price with a material cost and a used electricity fee applied with the first stage electricity rate.

Next, when each equipment starts production processing, the monitor control unit 4013 makes the equipment measure an amount of electricity used in the equipment and notify the monitor control unit 4013 of the measured result (Step S404). The monitor control unit 4013 makes the equipment further notify the monitor control unit 4013 of the number of boards produced by the equipment, and specifies the number (Step S406).

By referring to the electricity rate table obtained at step S400, the monitor control unit 4013 specifies which stage electricity rate, namely the first stage rate, the second stage rate, or the third stage rate, is to be applied to the currently used amount of electricity. Then, the monitor control unit 4013 estimates, from the results of steps S404 and S406, a used amount of electricity and the number of produced boards which occur after the above specified stage rate is applied. For example, if the currently applied electricity rate is the second stage rate, the monitor control unit 4013 estimates a used amount of electricity and the number of produced boards which occur after an used amount of electricity becomes more than 10 kWh. Then, the monitor control unit 4013 uses an equation that is (current electricity rate per unit electricity amount) × (used amount electricity) / (number of produced boards) in order to calculate the current electricity fee per one produced board. Then, the monitor control unit 4013 calculates an increased amount of the electricity fee per one produced board by subtracting the above calculated electricity cost with the electricity fee per one produced board (Step S408).

The monitor control unit 4013 determines whether or not the increased amount of the electricity fee calculated at step S408 results in gain of a profit (Step S410).

Here, if the increased amount results in gain of a profit (Y at Step S410), then the monitor control unit 4013 stops production processing performed by the equipment (Step S412). On the other hand, if the increased amount results in no profit (N at Step S410), the monitor control unit 4013 repeats the operation from step S404 to step S410.

Thus, in the third variation of the sixth embodiment, even if electricity rates per unit electricity amount are set to be increased gradually depending on a used amount of electricity, the setting operation "Stop production" is executed when the increased amount of the electricity fee per one produced board results in gain of a profit per one produced board, so that it is possible to surely prevent a profit loss.

### (Fourth Variation)

The following describes the fourth variation of the sixth embodiment in which the timing of executing the setting operation "Stop production" is further changed.

In the sixth embodiment, the setting operation "Stop production" is executed when a used amount of electricity reaches a reference ratio of the used amount to a setting amount of electricity. In the fourth variation of the sixth embodiment, however, the setting operation "Stop production" is executed when an accumulated cost for producing boards (production cost) including an electricity fee reaches sales cost. For example, in a case where electricity rates per unit electricity amount are set to be increased gradually depending on a used amount of electricity as shown in FIG. 53, the more the boards are produced and sold, the more the production cost sometime becomes closer to the sales cost. In such a case, the fourth variation of the sixth embodiment is useful and effective.

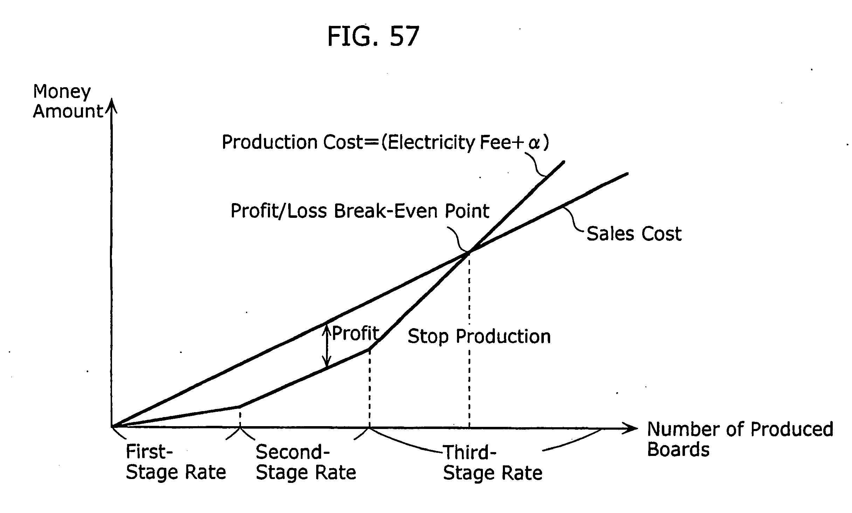

FIG. 57 is a graph showing a relationship between the production cost and the sales cost corresponding to number of produced boards.

The sales cost is increased in proportion to increase of number of produced boards, if a selling price per one board is fixed.

The production cost is also increased in proportion to the increase of number of produced boards. However, pace of the increase is gradually stage by stage, if electricity rates are set to be increased gradually, as shown in FIG. 57.

Therefore, sometimes the production cost reaches the sales cost due to increase of the number of produced boards. In such situation, further production does not provide gain of a profit.

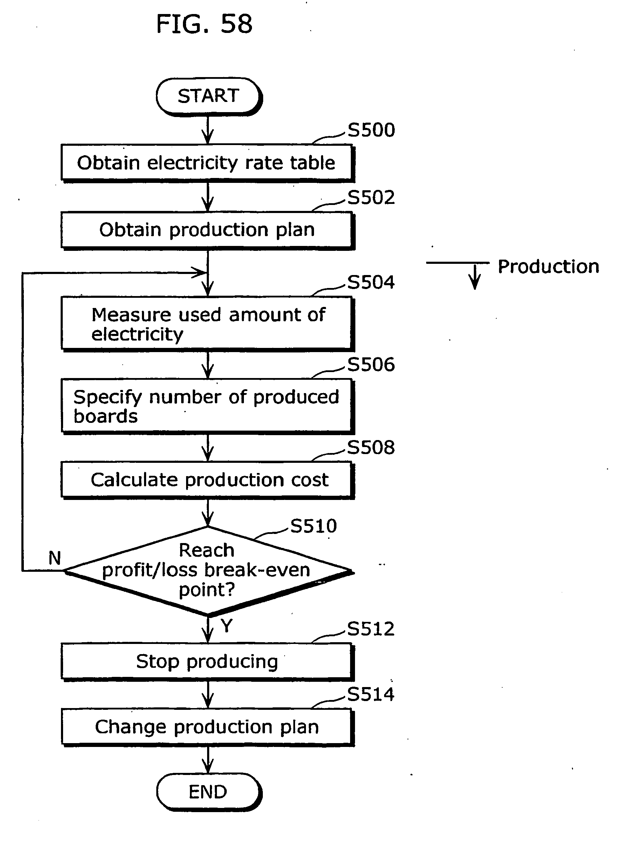

FIG. 58 is a flowchart showing an operation performed by the monitor control unit 4013 according to the fourth variation of the sixth embodiment.

Firstly, the monitor control unit 4013 obtains an electricity rate table as shown in FIG. 53 (Step S500) and also a production plan indicating the number of boards to be produced daily or monthly or the like, according to inputting of an operator using the operation unit 4014 (Step S502).

Next, when each equipment starts production processing, the monitor control unit 4013 makes the equipment measure an amount of electricity used in the equipment and notify the monitor control unit 4013 of the measured result (Step S504). The monitor control unit 4013 makes the equipment further notify the monitor control unit 4013 of the number of boards produced by the equipment and specifies the number (Step S506).

By referring to the electricity rate table obtained at step S500, the monitor control unit 4013 calculates a production cost by converting an amount of electricity used until the presence into an electricity fee and then adding the converted electricity fee with a material cost and the like (Step S508). Here, the material cost and the like correspond to the number of produced boards specified at step S506.

The monitor control unit 4013 estimates sales cost using the number of produced boards specified at Step S504, and examines whether or not the production cost reaches the sales cost, in other words, whether or not the production cost reaches a profit/loss break-even point (Step S510).

If the production cost reaches the profit/loss break-even point (Y at Step S510), then the monitor control unit 4013 stops production processing performed by the equipment (Step S512) and changes the production plan obtained at step S502 so that boards not yet produced due to the production stop are to be produced next day or next month (Step S514). On the other hand, if the production cost does not reach the profit/loss break-even point (N at Step S510), then the monitor control unit 4013 repeats the operation from step S504 to step S510.

Accordingly, in the fourth variation of the sixth embodiment, even if the electricity rates per unit electricity amount are set to be increased gradually according to an amount of used electricity, the setting operation "Stop production" is executed when the production cost reaches the sales cost, so that it is possible to surely prevent a profit loss.

Thus, the method of monitoring electricity according to the present invention has been described in the sixth embodiment and variations thereof, but the method is not limited to the above.

For example, in the sixth embodiment and variations thereof, the used amount of electricity and the setting amount of electricity are displayed, but it is also possible to display an amount of discharged carbon dioxide and a setting amount of carbon dioxide. The amount of discharged carbon dioxide refers to an amount of carbon dioxide discharged from an equipment or plant. The setting amount of carbon dioxide refers a predetermined amount of carbon dioxide permitted to be discharged from the equipment or plant. For example, the equipment or plant is permitted to discharge carbon dioxide up to the setting amount of carbon dioxide, but the equipment or plant needs a right, namely an ecology right, to discharge carbon dioxide more than the setting amount. For instance, an ecology right for discharge of carbon dioxide 1 kg costs four dollars. Therefore, an amount of carbon dioxide discharged from the equipment is measured and also a setting amount of carbon dioxide is obtained thereby displaying both of the amount of discharged carbon dioxide and the setting amount of carbon dioxide, which enables an operator to restrain an amount of carbon dioxide discharged from the equipment in order to prevent the purchase of such expensive ecology right.

Note that the amount of discharged carbon dioxide may include not only an amount of carbon dioxide discharged directly from the equipment or plant, but also an amount of carbon dioxide discharged from a power plant which generates electricity used in the equipment or plant. This is because when the power plant or the like of an electric power company generates electricity, the power plant or the like also discharges carbon dioxide. Therefore, if the equipment or plant uses the electricity supplied from the power plant, a part of amount in the amount of carbon dioxide discharged from the power plant that corresponds to an amount of the electricity used in the equipment or plant is considered as an amount of carbon dioxide discharged for the equipment or plant. Thereby the operator can surely restrain not only the amount of carbon dioxide discharged directly from the equipment or plant, but also the amount of carbon dioxide indirectly discharged for the board production in the equipment or plant.

Moreover, the sixth embodiment has described that an equipment executes the setting operation "Stop production" when the amount of used electricity reaches a reference ratio of the used amount of the setting amount of electricity, but such setting operation can be executed also when the amount of discharged carbon dioxide reaches a reference ratio of the discharged amount of the setting amount of carbon dioxide. Thereby it is possible to surely restrain the discharged amount of carbon dioxide.

Further, at step S206 of FIG. 54 in the first variation of the sixth embodiment, if the ecology right needs to be purchased, the electricity fee per one produced board may include the purchase cost of the ecology right. Still further, also at step S306 of FIG. 55 in the second variation of the sixth embodiment, if the ecology right needs to be purchased, it is possible to compare the privately-generated electricity cost to the commercially-supplied electricity fee, each of which includes the purchase cost of the ecology right. Note that, in general, generation of the commercially-supplied electricity discharges less carbon dioxide compared to generation of the privately-generated electricity, so that a purchase cost of the ecology right per unit amount of commercially-supplied electricity is cheaper than a purchase cost of the ecology right per unit amount of privately-generated electricity. Still further, also at step S408 of FIG. 56 in the third variation and at step S508 of FIG. 58 in the fourth variation of the sixth embodiment, if the ecology right needs to be purchased, it is possible to calculate the increased amount of the electricity fee per one produced board and the production cost, each of which includes the purchase cost of the ecology right.

Moreover, if the amount of discharged carbon dioxide is less than the setting amount of carbon dioxide, it is also possible to sell an ecology right corresponding to the difference. Therefore, if the ecology right is permitted to be sold, a sale cost can be subtracted during the above-described calculation of the cost per one produced board.

Note also that, the sixth embodiment has described that the number of stages is limited when the machine M1 executes the setting operation "Limit using equipment number", but it is also possible to limit the number of beams in the machine M1 instead if the machine M1 uses a plurality of beams. Each of the beams has the line gang pickup heads 4112 and moves the line gang pickup heads 4112. By limiting the number of the beams, a used amount of electricity can be restrained. Further, when the number of used equipments is limited, it is also possible to stop firstly an equipment that consumes a large amount of electricity and is not quite important for a production plan.

Note also that the sixth embodiment has described that the electricity monitoring apparatus is independent from the equipments, but the electricity monitoring apparatus may be equipped in each equipment. In this case, a production apparatus as the equipment performs additional operations such as displaying of an amount of electricity used in the equipment and a setting amount of electricity regarding the equipment.

Note also that the third variation of the sixth embodiment has described that when the increased amount of the electricity fee per one board results in a gain of the expected profit, the setting operation "Stop production" is executed. After such operation, it is also possible to change a previously obtained production plan in the same manner as described in the fourth variation of the sixth embodiment.

Although only some exemplary embodiments of the present invention have been described in detail above, those skilled in the art will readily appreciate that many modifications are possible in the exemplary embodiments without materially departing from the novel teachings and advantages of the present invention.

### Industrial Applicability

The present invention can be applied to a mounter which mounts components onto a board, and especially to a mounter or the like which mounts electronic components onto a printed circuit board or the like to produce a mounted board.

Furthermore, the present invention can be applied to a mounter which mounts components onto a board, and especially to a mounter or the like which is equipped with a plurality of beams.

Moreover, the present invention has an effect of restraining an amount of electricity used in equipments, and is useful, for example, to monitor an amount of electricity used in a mounter mounting electronic components onto a printed circuit board or an amount of electricity used in a production line having a plurality of such mounters.

## Claims

1. A mounting condition determining method of determining mounting conditions under which a piece of equipment mounts a component onto a substrate, said method comprising:
obtaining a goal producing time (311) allowed to produce the mounted substrates;
obtaining an actual producing time (316) required to produce the mounted substrates under current mounting conditions; and
determining new mounting conditions (315) so that the obtained actual producing time does not exceed the goal producing time.

2. The mounting condition determining method according to Claim 1, further comprising :
obtaining information of a mounting acceleration corresponding to the component to be mounted; and
lowering the mounting acceleration by a predetermined degree,
wherein in said obtaining of the actual producing time, the actual producing time is calculated based on the lowered mounting acceleration as the current mounting conditions, and
in said determining, the lowered mounting acceleration is determined so that the actual producing time does not exceed the goal producing time.

3. The mounting condition determining method according to Claim 2, further comprising
obtaining gradual mounting acceleration information which gradually sets the mounting accelerations,
wherein in said lowering, the mounting acceleration is gradually lowered based on the gradual mounting acceleration information.

4. The mounting condition determining method according to Claim 1, further comprising:
obtaining information of a mounting acceleration corresponding to the component to be mounted; and
lowering the mounting acceleration by a predetermined degree,
wherein in said obtaining of the actual producing time, the actual producing time is calculated based on the lowered mounting acceleration and a mounting order that are the current mounting conditions, and
in said determining, the mounting order is determined so that the actual producing time does not exceed the goal producing time, after the lowered mounting acceleration is determined so that the actual producing time does not exceed the goal producing time.

5. A mounting condition determining device for carrying out the method of claim 1, said device comprising:
a setting value obtainment unit (311) operable to obtain a goal producing time allowed to produce the mounted substrate,
an actual value obtainment unit (316) operable to obtain an actual producing time required to produce the mounted substrate under current mounting conditions, and
a mounting condition determining unit (301) operable to determine new mounting conditions so that the obtained actual producing time does not exceed the goal producing time.

6. A mounter, comprising a mounting condition determining device according to claim 5, which mounts a component onto a substrate, said mounter comprising:
a setting value obtainment unit operable to obtain a goal producing time allowed to produce the mounted substrate;
an actual value obtainment unit operable to obtain an actual producing time required to produce the mounted substrate under current mounting conditions;
a mounting condition determining unit operable to determine new mounting conditions so that the obtained actual producing time does not exceed the goal producing time; and
a mounting control unit operable to mount the component onto the substrate under the new mounting conditions.

7. A mounting condition determining method according to claim 1, wherein the current mounting conditions are the number of beams to be used.

8. The mounting condition determining method according to Claim 7, further comprising:
determining mounting conditions assuming that all beams are to be used; and
calculating a fastest producing time under the fastest-mounting conditions,
wherein in said obtaining of the number of beams to be used, the number of beams to be used is obtained based on the goal producing time and the fastest producing time.

9. The mounting condition determining method according to claim 7, further comprising:
receiving information of a selected number of beams to be used; and
obtaining the number of beams to be used from the received information of the selected number of beams.

10. The mounting condition determining method according to Claim 7,
wherein in said determining, the new mounting conditions are determined to be added with further conditions under which beams arranged in a row parallel to a direction of transporting the substrate are used prior to beams arranged in another row parallel to the direction.

11. The mounting condition determining method according to Claim 7, further comprising
blocking electricity supplied to beams not to be used.

12. The mounting condition determining method according to Claim 7, further comprising
blocking electricity supplied to a stage in the equipment, the stage having beams not to be used.

13. A mounting condition determining method according to claim 1, wherein the mounted substrate is produced by a mounting line and wherein the mounting conditions are the number of the equipments to be used in the mounting line,

14. A mounting condition determining method according to Claim 1, said method further comprising:
obtaining a setting value of a parameter regarding electricity consumption required to mount the component;
obtaining an actual value of the parameter based on current mounting conditions,
determining new mounting conditions based on a result of comparing the setting value with the actual value,
detecting that the mounting is complete when all of components to be mounted are mounted; and
blocking electricity supplied to beams when a production waiting time required to wait for next mounting after the detected mounting completion exceeds the setting value.

15. A mounting condition determining device according to claim 5,
wherein the current mounting conditions are the number of beams to be used.

16. A mounter according to claim 6, wherein the current mounting conditions are the number of beams to be used.

17. A mounting condition determining method according to Claim 1, said method further comprising:
obtaining a setting amount of electricity allowed to be used by the equipment in a predetermined time period,
obtaining a used amount of electricity by measuring an amount of electricity used by the equipment from a beginning of the predetermined time period to a present time;
displaying the obtained setting amount of electricity and the measured used amount of electricity; and
determining new mounting conditions based on a result of comparing the setting amount of electricity with the used amount of electricity.

18. The mounting condition determining method according to Claim 17, further comprising:
examining whether or not a ratio of the used amount of electricity to the setting amount of electricity exceeds the setting amount of electricity; and
alarming to notify that the used amount of electricity becomes closer to the setting amount of electricity, when said examination is made that the ratio exceeds the setting amount of electricity.

19. The mounting condition determining method according to Claim 17, further comprising:
examining whether or not a ratio of the used amount of electricity to the setting amount of electricity exceeds the setting amount of electricity; and
reducing an amount of commercially-supplied electricity per unit time which is supplied to the equipment, after said examination is made that the ratio exceeds the setting amount of electricity.

20. The mounting condition determining method according to Claim 19,
wherein in said reducing, an operation performed by the equipment to mount the component onto the substrate is stopped.

21. The mounting condition determining method according to Claim 19,
wherein in said reducing, the commercially-supplied electricity is stopped not to be supplied to the equipment and privately-generated electricity is supplied to the equipment instead.

22. The mounting condition determining method according to Claim 19,
wherein in said reducing, the equipment has elements moved by electricity, and accelerations during moving of the elements are lowered by a same degree.

23. The mounting condition determining method according to Claim 19, further comprising
selecting moving from respective moving of elements that are included in the equipment and moved by electricity, the selected moving using an amount of electricity that can be reduced if an acceleration during the moving is lowered, and the reduced amount of electricity being greater than a predetermined value,
wherein in said reducing, an acceleration during the selected moving is lowered.

24. The mounting condition determining method according to Claim 19,
wherein in said reducing, one of elements that are included in the equipment and moved by electricity is stopped.

25. The mounting condition determining method according to Claim 17, further comprising:
obtaining an electricity rate per unit amount of used electricity; and
calculating an electricity fee for the used amount of electricity measured in said obtaining of the used amount of electricity, based on the used amount of electricity and the obtained electricity rate,
wherein in said displaying, the calculated electricity fee is displayed instead of the used amount of electricity.

26. The mounting condition determining method according to Claim 17, further comprising:
measuring an amount of carbon dioxide discharged from the equipment; and
displaying the measured amount of carbon dioxide.

27. The mounting condition determining method according to Claim 26, further comprising:
obtaining a setting amount of carbon dioxide allowed to be discharged from the equipment; and
stopping an operation performed by the equipment to mount the component onto the substrate, when a ratio of the amount of carbon dioxide discharged from the equipment to the setting amount of carbon dioxide exceeds the setting amount of carbon dioxide.

28. A mounting condition determining device for carrying out the method of claim 17, said device comprising:
a setting value obtainment unit operable to obtain a setting amount of electricity allowed to be used by the equipment in a predetermined time period,
an actual value obtainment unit operable to obtain the used amount of electricity by measuring an amount of electricity used by the equipment from a beginning of the predetermined time period to a present time,
a display unit operable to display the obtained setting amount of electricity and the measured used amount of electricity, and
a mounting condition determining unit operable to determine new mounting conditions based on a result of comparing the setting amount of electricity with the used amount of electricity.

29. A mounter, comprising a mounting condition determining device according to claim 28, which mounts a component onto a substrate, said mounter comprising:
a setting value obtainment unit operable to obtain a setting amount of electricity allowed to be used by the equipment in a predetermined time period,
an actual value obtainment unit operable to obtain the used amount of electricity by measuring an amount of electricity used in the equipment from a beginning of the predetermined time period to a present time,
a display unit operable to display the obtained setting amount of electricity and the measured used amount of electricity,
a mounting condition determining unit operable to determine new mounting conditions based on a result of comparing the setting amount of electricity with the used amount of electricity, and
a mounting control unit operable to mount the component onto the substrate under the new mounting conditions.

## Patentansprüche

1. Montagebedingungen-Festlegungsverfahren zum Festlegen von Montagebedingungen, unter denen eine Einrichtung eine Komponente auf ein Substrat montiert, mit den folgenden Schritten:
Ermitteln einer Soll-Herstellungszeit (311), in der die bestückten Substrate hergestellt werden können;
Ermitteln einer Ist-Herstellungszeit (316), die zur Herstellung der bestückten Substrate unter aktuellen Montagebedingungen benötigt wird; und
Festlegen von neuen Montagebedingungen (315) so, dass die ermittelte Ist-Herstellungszeit nicht länger als die Soll-Herstellungszeit ist.

2. Montagebedingungen-Festlegungsverfahren nach Anspruch 1, das weiterhin die folgenden Schritte aufweist:
Erhalten von Informationen zu einer Montagebeschleunigung die den zu montierenden Komponenten entspricht; und
Verringern der Montagebeschleunigung um ein vorgegebenes Maß,
wobei
bei dem Ermitteln der Ist-Herstellungszeit die Ist-Herstellungszeit aufgrund der verringerten Montagebeschleunigung als den aktuellen Montagebedingungen berechnet wird und
bei dem Festlegen die verringerte Montagebeschleunigung so festgelegt wird, dass die Ist-Herstellungszeit nicht länger als die Soll-Herstellungszeit ist.

3. Montagebedingungen-Festlegungsverfahren nach Anspruch 2, das weiterhin das Erhalten von Stufenweise-Montagebeschleunigungs-Informationen aufweist, die die Montagebeschleunigung stufenweise festlegen, wobei bei dem Verringern die Montagebeschleunigung aufgrund der Stufenweise-Montagebeschleunigungs-Informationen stufenweise verringert wird.

4. Montagebedingungen-Festlegungsverfahren nach Anspruch 1, das weiterhin die folgenden Schritte aufweist:
Erhalten von Informationen zu einer Montagebeschleunigung, die der zu montierenden Komponente entspricht; und
Verringern der Montagebeschleunigung um ein vorgegebenes Maß,
wobei
bei dem Ermitteln der Ist-Herstellungszeit die Ist-Herstellungszeit aufgrund der verringerten Montagebeschleunigung und einer Montagereihenfolge berechnet wird, die die aktuellen Montagebedingungen sind, und
bei dem Festlegen die Montagereihenfolge so festgelegt wird, dass die Ist-Herstellungszeit nicht länger als die Soll-Herstellungszeit ist, nachdem die verringerte Montagebeschleunigung so festgelegt worden ist, dass die Ist-Herstellungszeit nicht länger als die Soll-Herstellungszeit ist.

5. Montagebedingungen-Festlegungsvorrichtung zum Durchführen des Verfahrens nach Anspruch 1, mit:
einer Sollwert-Ermittlungseinheit (311), die so betreibbar ist, dass sie eine Soll-Herstellungszeit ermittelt, in der das bestückte Substrat hergestellt werden kann;
einer Istwert-Ermittlungseinheit (316), die so betreibbar ist, dass sie eine Ist-Herstellungszeit ermittelt, die zur Herstellung des bestückten Substrats unter aktuellen Montagebedingungen benötigt wird; und
einer Montagebedingungen-Festlegungseinheit (301), die so betreibbar ist, dass sie neue Montagebedingungen so festlegt, dass die ermittelte Ist-Herstellungszeit nicht länger als die Soll-Herstellungszeit ist.

6. Montagegerät mit einer Montagebedingungen-Festlegungsvorrichtung nach Anspruch 5, das eine Komponente auf ein Substrat montiert, wobei das Montagegerät Folgendes aufweist:
eine Sollwert-Ermittlungseinheit, die so betreibbar ist, dass sie eine Soll-Herstellungszeit ermittelt, in der das bestückte Substrat hergestellt werden kann;
eine Istwert-Ermittlungseinheit, die so betreibbar ist, dass sie eine Ist-Herstellungszeit ermittelt, die zur Herstellung des bestückten Substrats unter aktuellen Montagebedingungen benötigt wird;
eine Montagebedingungen-Festlegungseinheit, die so betreibbar ist, dass sie neue Montagebedingungen so festlegt, dass die ermittelte Ist-Herstellungszeit nicht länger als die Soll-Herstellungszeit ist; und
eine Montagesteuereinheit, die so betreibbar ist, dass sie die Komponente unter den neuen Montagebedingungen auf das Substrat montiert.

7. Montagebedingungen-Festlegungsverfahren nach Anspruch 1, **dadurch gekennzeichnet, dass** die aktuellen Montagebedingungen die Anzahl von zu verwendenden Zwischenträgern sind.

8. Montagebedingungen-Festlegungsverfahren nach Anspruch 7, das weiterhin die folgenden Schritte aufweist:
Festlegen von Montagebedingungen unter der Voraussetzung, dass alle Zwischenträger verwendet werden sollen; und
Berechnen einer kürzesten Herstellungszeit unter den Bedingungen der schnellsten Montage,
wobei bei dem Ermitteln der Anzahl von zu verwendenden Zwischenträgern die Anzahl von zu verwendenden Zwischenträgern aufgrund der Soll-Herstellungszeit und der kürzesten Herstellungszeit ermittelt wird.

9. Montagebedingungen-Festlegungsverfahren nach Anspruch 7, das weiterhin die folgenden Schritte aufweist:
Erhalten von Informationen zu einer gewählten Anzahl von zu verwendenden Zwischenträgern und
Ermitteln der Anzahl von zu verwendenden Zwischenträgern aus den erhaltenen Informationen zu der gewählten Anzahl von Zwischenträgern.

10. Montagebedingungen-Festlegungsverfahren nach Anspruch 7, **dadurch gekennzeichnet, dass** bei dem Festlegen die neuen Montagebedingungen unter Hinzufügung weiterer Bedingungen festgelegt werden, unter denen Zwischenträger, die in einer Reihe angeordnet sind, die zu einer Substrat-Transportrichtung parallel ist, vor Zwischenträgern verwendet werden, die in einer anderen Reihe angeordnet sind, die zu der Richtung parallel ist.

11. Montagebedingungen-Festlegungsverfahren nach Anspruch 7, das weiterhin das Sperren von Strom aufweist, der Zwischenträgern zugeführt wird, die nicht verwendet werden sollen.

12. Montagebedingungen-Festlegungsverfahren nach Anspruch 7, das weiterhin das Sperren von Strom aufweist, der einer Stufe in der Einrichtung zugeführt wird, die Zwischenträger hat, die nicht verwendet werden sollen.

13. Montagebedingungen-Festlegungsverfahren nach Anspruch 1, **dadurch gekennzeichnet, dass**
das bestückte Substrat mit einer Montagelinie hergestellt wird und
die Montagebedingungen die Anzahl der in der Montagelinie zu verwendenden Einrichtungen sind.

14. Montagebedingungen-Festlegungsverfahren nach Anspruch 1, das weiterhin die folgenden Schritte aufweist:
Ermitteln eines Sollwerts eines Parameters für den Stromverbrauch, der zum Montieren der Komponente benötigt wird;
Ermitteln eines Istwerts des Parameters aufgrund von aktuellen Montagebedingungen;
Festlegen von neuen Montagebedingungen aufgrund eines Ergebnisses des Vergleichens des Sollwerts mit dem Istwert;
Erkennen, dass die Montage beendet ist, wenn alle zu montierenden Komponenten montiert sind; und
Sperren von Strom, der Zwischenträgern zugeführt wird, wenn eine Herstellungswartezeit, die für das Warten auf die nächste Montage nach dem erkannten Montage-Ende erforderlich ist, größer als der Istwert ist.

15. Montagebedingungen-Festlegungsvorrichtung nach Anspruch 5, **gekennzeichnet, dass** die aktuellen Montagebedingungen die Anzahl von zu verwendenden Zwischenträgern sind.

16. Montagegerät nach Anspruch 6, **dadurch gekennzeichnet, dass** die aktuellen Montagebedingungen die Anzahl von zu verwendenden Zwischenträgern sind.

17. Montagebedingungen-Festlegungsverfahren nach Anspruch 1, das weiterhin die folgenden Schritte aufweist:
Ermitteln einer Sollstrommenge, der von der Einrichtung in einem vorgegebenen Zeitraum verwendet werden darf;
Ermitteln einer verbrauchten Strommenge durch Messen einer Strommenge, die von der Einrichtung von einem Beginn des vorgegebenen Zeitraums bis zu einem aktuellen Zeitpunkt verbraucht wird;
Anzeigen der ermittelten Sollstrommenge und der gemessenen verbrauchten Strommenge und
Festlegen von neuen Montagebedingungen aufgrund eines Ergebnisses des Vergleichens der Sollstrommenge mit der verbrauchten Strommenge.

18. Montagebedingungen-Festlegungsverfahren nach Anspruch 17, das weiterhin die folgenden Schritte aufweist:
Prüfen, ob ein Verhältnis der verbrauchten Strommenge zu der Sollstrommenge größer als die Sollstrommenge ist oder nicht; und
Warnen, dass die verbrauchte Strommenge der Sollstrommenge näher kommt, wenn festgestellt wird, dass das Verhältnis größer als die Sollstrommenge ist.

19. Montagebedingungen-Festlegungsverfahren nach Anspruch 17, das weiterhin die folgenden Schritte aufweist:
Prüfen, ob ein Verhältnis der verbrauchten Strommenge zu der Sollstrommenge größer als die Sollstrommenge ist oder nicht; und
Verringern der der Einrichtung zugeführten, kommerziell gelieferten Strommenge je Zeiteinheit, wenn festgestellt wird, dass das Verhältnis größer als die Sollstrommenge ist.

20. Montagebedingungen-Festlegungsverfahren nach Anspruch 19, **dadurch gekennzeichnet, dass** bei dem Verringern eine Operation unterbrochen wird, die von der Einrichtung zum Montieren der Komponente auf das Substrat ausgeführt wird.

21. Montagebedingungen-Festlegungsverfahren nach Anspruch 19, **dadurch gekennzeichnet, dass** bei dem Verringern der kommerziell gelieferte Strom abgeschaltet wird, sodass er nicht der Einrichtung zugeführt wird, und der Einrichtung stattdessen privat erzeugter Strom zugeführt wird.

22. Montagebedingungen-Festlegungsverfahren nach Anspruch 19, **dadurch gekennzeichnet, dass** bei dem Verringern die Einrichtung Elemente hat, die mit Strom bewegt werden, und Beschleunigungen während des Bewegens der Elemente um das gleiche Maß verringert werden.

23. Montagebedingungen-Festlegungsverfahren nach Anspruch 19, das weiterhin das Wählen einer Bewegung aus einzelnen Bewegungen von Elementen aufweist, die Bestandteil der Einrichtung sind und mit Strom bewegt werden, wobei die gewählte Bewegung eine Strommenge verbraucht, die verringert werden kann, wenn eine Beschleunigung während der Bewegung verringert wird, und die verringerte Strommenge größer als ein vorgegebener Wert ist,
wobei bei dem Verringern eine Beschleunigung während der gewählten Bewegung verringert wird.

24. Montagebedingungen-Festlegungsverfahren nach Anspruch 19, **dadurch gekennzeichnet, dass** bei dem Verringern eines der Elemente angehalten wird, die Bestandteil der Einrichtung sind und mit Strom bewegt werden.

25. Montagebedingungen-Festlegungsverfahren nach Anspruch 17, das weiterhin die folgenden Schritte aufweist:
Ermitteln eines Stromtarifs je Mengeneinheit verbrauchter Strom und
Berechnen eines Strompreises für die verbrauchte Strommenge, die bei dem Ermitteln der verbrauchten Strommenge gemessen wird, aufgrund der verbrauchten Strommenge und des ermittelten Stromtarifs,
wobei bei dem Anzeigen der berechnete Strompreis anstelle der verbrauchten Strommenge angezeigt wird.

26. Montagebedingungen-Festlegungsverfahren nach Anspruch 17, das weiterhin die folgenden Schritte aufweist:
Messen einer Kohlendioxidmenge, die von der Einrichtung ausgestoßen wird; und
Anzeigen der gemessenen Kohlendioxidmenge.

27. Montagebedingungen-Festlegungsverfahren nach Anspruch 26, das weiterhin die folgenden Schritte aufweist:
Ermitteln einer Kohlendioxid-Sollmenge, die von der Einrichtung ausgestoßen werden darf; und
Unterbrechen einer Operation, die von der Einrichtung zum Montieren der Komponente auf das Substrat ausgeführt wird, wenn ein Verhältnis der von der Einrichtung ausgestoßenen Kohlendioxidmenge zu der Kohlendioxid-Sollmenge größer als die Kohlendioxid-Sollmenge ist.

28. Montagebedingungen-Festlegungsvorrichtung zum Durchführen des Verfahrens nach Anspruch 17, mit:
einer Sollwert-Ermittlungseinheit, die so betreibbar ist, dass sie eine Sollstrommenge ermittelt, die von der Einrichtung in einem vorgegebenen Zeitraum verbraucht werden darf;
einer Istwert-Ermittlungseinheit, die so betreibbar ist, dass sie die verbrauchte Strommenge durch Messen einer Strommenge ermittelt, die von der Einrichtung von einem Beginn des vorgegebenen Zeitraums bis zu einem aktuellen Zeitpunkt verbraucht wird;
einer Anzeige-Einheit, die so betreibbar ist, dass sie die ermittelte Sollstrommenge und die gemessene verbrauchte Strommenge anzeigt; und
einer Montagebedingungen-Festlegungseinheit, die so betreibbar ist, dass sie neue Montagebedingungen aufgrund eines Ergebnisses des Vergleichens der Sollstrommenge mit der verbrauchten Strommenge festlegt.

29. Montagegerät mit einer Montagebedingungen-Festlegungsvorrichtung nach Anspruch 28, das eine Komponente auf ein Substrat montiert, wobei das Montagegerät Folgendes aufweist:
eine Sollwert-Ermittlungseinheit, die so betreibbar ist, dass sie eine Sollstrommenge ermittelt, die von der Einrichtung in einem vorgegebenen Zeitraum verbraucht werden darf;
eine Istwert-Ermittlungseinheit, die so betreibbar ist, dass sie die verbrauchte Strommenge durch Messen einer Strommenge ermittelt, die von der Einrichtung von einem Beginn des vorgegebenen Zeitraums bis zu einem aktuellen Zeitpunkt verbraucht wird;
eine Anzeige-Einheit, die so betreibbar ist, dass sie die ermittelte Sollstrommenge und die gemessene verbrauchte Strommenge anzeigt;
eine Montagebedingungen-Festlegungseinheit, die so betreibbar ist, dass sie neue Montagebedingungen aufgrund eines Ergebnisses des Vergleichens der Sollstrommenge mit der verbrauchten Strommenge festlegt; und
eine Montagesteuereinheit, die so betreibbar ist, dass sie die Komponente unter den neuen Montagebedingungen auf das Substrat montiert.

## Revendications

1. Procédé de détermination de conditions de montage pour déterminer des conditions de montage sous lesquelles une unité d'équipement monte un composant sur un substrat, ledit procédé comprenant :
l'obtention d'un temps de production cible (311) autorisé pour produire les substrats montés ;
l'obtention d'un temps de production réel (316) requis pour produire les substrats montés sous des conditions de montage actuelles ; et
la détermination de nouvelles conditions de montage (315) de façon à ce que le temps de production réel obtenu n'excède pas le temps de production cible.

2. Procédé de détermination de conditions de montage selon la revendication 1, comprenant en outre :
l'obtention d'informations d'une accélération de montage correspondant au composant devant être monté ; et
la diminution de l'accélération de montage d'un degré prédéterminé,
dans lequel dans ladite obtention du temps de production réel, le temps de production réel est calculé sur la base de l'accélération de montage diminuée comme les conditions de montage actuelles, et
dans ladite détermination, l'accélération de montage diminuée est déterminée de façon à ce que le temps de production réel n'excède pas le temps de production cible.

3. Procédé de détermination de conditions de montage selon la revendication 2, comprenant en outre :
l'obtention d'informations d'accélération de montage graduelle qui définit graduellement les accélérations de montage,
dans lequel dans ladite diminution, l'accélération de montage est graduellement diminuée sur la base des informations d'accélération de montage graduelle.

4. Procédé de détermination de conditions de montage selon la revendication 1, comprenant en outre :
l'obtention d'informations d'une accélération de montage correspondant au composant devant être monté ; et
la diminution de l'accélération de montage d'un degré prédéterminé,
dans lequel dans ladite obtention du temps de production réel, le temps de production réel est calculé sur la base de l'accélération de montage diminuée et d'un ordre de montage qui constituent les conditions de montage actuelles, et
dans ladite détermination, l'ordre de montage est déterminé de façon à ce que le temps de production réel n'excède pas le temps de production cible, après que l'accélération de montage diminuée a été déterminée de façon à ce que le temps de production réel n'excède pas le temps de production cible.

5. Dispositif de détermination de conditions de montage pour mettre en oeuvre le procédé selon la revendication 1, ledit dispositif comprenant :
une unité d'obtention de valeur nominale (311) utilisable pour obtenir un temps de production cible autorisé pour produire le substrat monté,
une unité d'obtention de valeur réelle (316) utilisable pour obtenir un temps de production réel requis pour produire le substrat monté sous des conditions de montage actuelles, et
une unité de détermination de conditions de montage (301) utilisable pour déterminer des nouvelles conditions de montage de façon à ce que le temps de production réel obtenu n'excède pas le temps de production cible.

6. Monteur, comprenant un dispositif de détermination de conditions de montage selon la revendication 5, qui monte un composant sur un substrat, ledit monteur comprenant :
une unité d'obtention de valeur nominale utilisable pour obtenir un temps de production cible autorisé pour produire le substrat monté ;
une unité d'obtention de valeur réelle utilisable pour obtenir un temps de production réel requis pour produire le substrat monté sous des conditions de montage actuelles ;
une unité de détermination de conditions de montage utilisable pour déterminer des nouvelles conditions de montage de façon à ce que le temps de production réel obtenu n'excède pas le temps de production cible ; et
une unité de commande de montage utilisable pour monter le composant sur le substrat sous les nouvelles conditions de montage.

7. Procédé de détermination de conditions de montage selon la revendication 1, dans lequel les conditions de montage actuelles sont le nombre de faisceaux devant être utilisés.

8. Procédé de détermination de conditions de montage selon la revendication 7, comprenant en outre :
la détermination des conditions de montage en supposant que tous les faisceaux doivent être utilisés ; et
le calcul d'un temps de production le plus rapide sous les conditions de montage les plus rapides,
dans lequel dans ladite obtention du nombre de faisceaux devant être utilisés, le nombre de faisceaux devant être utilisés est obtenu sur la base du temps de production cible et du temps de production le plus rapide.

9. procédé de détermination de conditions de montage selon la revendication 7, comprenant en outre :
la réception d'informations d'un nombre sélectionné de faisceaux devant être utilisés ; et
l'obtention du nombre de faisceaux devant être utilisés à partir des informations reçues du nombre sélectionné de faisceaux.

10. Procédé de détermination de conditions de montage selon la revendication 7,
dans lequel dans ladite détermination, les nouvelles conditions de montage sont déterminées pour être ajoutées avec d'autres conditions sous lesquelles des faisceaux agencés selon une rangée parallèle à une direction de transport du substrat sont utilisés avant des faisceaux agencés selon une autre rangée parallèle à la direction.

11. Procédé de détermination de conditions de montage selon la revendication 7, comprenant en outre
le blocage de l'électricité délivrée aux faisceaux ne devant pas être utilisés.

12. Procédé de détermination de conditions de montage selon la revendication 7, comprenant en outre
le blocage de l'électricité délivrée à un étage de l'équipement, l'étage ayant des faisceaux ne devant pas être utilisés.

13. Procédé de détermination de conditions de montage selon la revendication 1, dans lequel le substrat monté est produit par une ligne de montage et dans lequel les conditions de montage sont le nombre des équipements devant être utilisés dans la ligne de montage.

14. Procédé de détermination de conditions de montage selon la revendication 1, ledit procédé comprenant en outre :
l'obtention d'une valeur nominale d'un paramètre se rapportant à la consommation d'électricité requise pour monter le composant ;
l'obtention d'une valeur réelle du paramètre sur la base de conditions de montage actuelles,
la détermination de nouvelles conditions de montage sur la base d'un résultat de la comparaison de la valeur nominale avec la valeur actuelle,
la détection que le montage est terminé lorsque tous les composants devant être montés sont montés ; et
le blocage de l'électricité délivrée aux faisceaux lorsqu'un temps d'attente de production requis pour attendre le montage suivant après la fin détectée du montage excède la valeur nominale.

15. Dispositif de détermination de conditions de montage selon la revendication 5, dans lequel les conditions de montage actuelles sont le nombre de faisceaux devant être utilisés.

16. Monteur selon la revendication 6, dans lequel les conditions de montage actuelles sont le nombre de faisceaux devant être utilisés.

17. Procédé de détermination de conditions de montage selon la revendication 1, ledit procédé comprenant en outre :
l'obtention d'une quantité nominale d'électricité autorisée à être utilisée par l'équipement sur une période de temps prédéterminée,
l'obtention d'une quantité utilisée d'électricité en mesurant une quantité utilisée d'électricité par l'équipement d'un début de la période de temps prédéterminée jusqu'à un instant présent ;
l'affichage de la quantité nominale d'électricité obtenue et de la quantité utilisée d'électricité mesurée ; et
la détermination de nouvelles conditions de montage sur la base d'un résultat de la comparaison de la quantité nominale d'électricité avec la quantité utilisée d'électricité.

18. Procédé de détermination de conditions de montage selon la revendication 17, comprenant en outre :
l'examen pour savoir si un rapport de la quantité utilisée d'électricité sur la quantité nominale d'électricité excède ou non la quantité nominale d'électricité ; et
une alarme pour notifier que la quantité utilisée d'électricité se rapproche de la quantité nominale d'électricité, lorsque ledit examen indique que le rapport excède la quantité nominale d'électricité.

19. Procédé de détermination de conditions de montage selon la revendication 17, comprenant en outre :
l'examen pour savoir si un rapport de la quantité utilisée d'électricité sur la quantité nominale d'électricité excède ou non la quantité nominale d'électricité ; et
la réduction d'une quantité d'électricité commercialement délivrée par unité de temps qui est délivrée à l'équipement, après que ledit examen a indiqué que le rapport excède la quantité nominale d'électricité.

20. Procédé de détermination de conditions de montage selon la revendication 19,
dans lequel dans ladite réduction, une opération effectuée par l'équipement pour monter le composant sur le substrat est stoppée.

21. Procédé de détermination de conditions de montage selon la revendication 19,
dans lequel dans ladite réduction, l'électricité commercialement délivrée est stoppée pour ne pas être délivrée à l'équipement, et de l'électricité générée de façon privée est délivrée à l'équipement à la place.

22. Procédé de détermination de conditions de montage selon la revendication 19,
dans lequel dans ladite réduction, l'équipement a des éléments déplacés par l'électricité, et des accélérations pendant le déplacement des éléments sont diminuées d'un même degré.

23. Procédé de détermination de conditions de montage selon la revendication 19, comprenant en outre
la sélection d'un déplacement parmi des déplacements respectifs d'éléments qui sont inclus dans l'équipement et déplacés par l'électricité, le déplacement sélectionné utilisant une quantité d'électricité qui peut être réduite si une accélération pendant le déplacement est diminuée, et la quantité d'électricité réduite étant plus grande qu'une valeur prédéterminée,
dans lequel dans ladite réduction, une accélération pendant le déplacement sélectionné est diminuée.

24. Procédé de détermination de conditions de montage selon la revendication 19,
dans lequel dans ladite réduction, l'un des éléments qui sont inclus dans l'équipement et déplacés par l'électricité est stoppé.

25. Procédé de détermination de conditions de montage selon la revendication 17, comprenant en outre :
l'obtention d'un prix de l'électricité par quantité unitaire d'électricité utilisée ; et
le calcul d'un coût de l'électricité pour la quantité utilisée d'électricité mesurée dans ladite obtention de la quantité utilisée d'électricité, sur la base de la quantité utilisée d'électricité et du prix de l'électricité obtenu,
dans lequel dans ledit affichage, le coût de l'électricité calculé est affiché au lieu de la quantité utilisée d'électricité.

26. Procédé de détermination de conditions de montage selon la revendication 17, comprenant en outre :
la mesure d'une quantité de dioxyde de carbone déchargée de l'équipement ; et
l'affichage de la quantité mesurée de dioxyde de carbone.

27. Procédé de détermination de conditions de montage selon la revendication 26, comprenant en outre :
l'obtention d'une quantité nominale de dioxyde de carbone autorisée à être déchargée de l'équipement ; et
l'arrêt d'une opération effectuée par l'équipement pour monter le composant sur le substrat, lorsqu'un rapport de la quantité de dioxyde de carbone déchargée de l'équipement sur la quantité nominale de dioxyde de carbone excède la quantité nominale de dioxyde de carbone.

28. Dispositif de détermination de conditions de montage pour mettre en oeuvre le procédé selon la revendication 17, ledit dispositif comprenant :
une unité d'obtention de valeur nominale utilisable pour obtenir une quantité nominale d'électricité autorisée à être utilisée par l'équipement sur une période de temps prédéterminée,
une unité d'obtention de valeur réelle utilisable pour obtenir la quantité utilisée d'électricité en mesurant une quantité utilisée d'électricité par l'équipement d'un début de la période de temps prédéterminée jusqu'à un instant présent,
une unité d'affichage utilisable pour afficher la quantité nominale d'électricité obtenue et la quantité utilisée d'électricité mesurée, et
une unité de détermination de conditions de montage utilisable pour déterminer des nouvelles conditions de montage sur la base d'un résultat de la comparaison de la quantité nominale d'électricité avec la quantité utilisée d'électricité.

29. Monteur, comprenant un dispositif de détermination de conditions de montage selon la revendication 28, qui monte un composant sur un substrat, ledit monteur comprenant :
une unité d'obtention de valeur nominale utilisable pour obtenir une quantité nominale d'électricité autorisée à être utilisée par l'équipement sur une période de temps prédéterminée,
une unité d'obtention de valeur réelle utilisable pour obtenir la quantité utilisée d'électricité en mesurant une quantité utilisée d'électricité par l'équipement d'un début de la période de temps prédéterminée jusqu'à un instant présent,
une unité d'affichage utilisable pour afficher la quantité nominale d'électricité obtenue et la quantité utilisée d'électricité mesurée,
une unité de détermination de conditions de montage utilisable pour déterminer des nouvelles conditions de montage sur la base d'un résultat de la comparaison de la quantité nominale d'électricité avec la quantité utilisée d'électricité, et
une unité de commande de montage utilisable pour monter le composant sur le substrat sous les nouvelles conditions de montage.
